(19) Europäisches Patentamt
European Patent Office
Office européen des brevets

(11) EP 2 833 472 A1

(12) **EUROPEAN PATENT APPLICATION**
published in accordance with Art. 153(4) EPC

(43) Date of publication:
**04.02.2015 Bulletin 2015/06**

(21) Application number: **13769442.8**

(22) Date of filing: **29.03.2013**

(51) Int Cl.:
***H01M 14/00*** *(2006.01)* ***C09B 23/00*** *(2006.01)*
***H01L 31/04*** *(2014.01)*

(86) International application number:
**PCT/JP2013/059501**

(87) International publication number:
**WO 2013/147145 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.03.2012 JP 2012079355**

(71) Applicant: **Nippon Kayaku Kabushiki Kaisha**
**Tokyo 100-0005 (JP)**

(72) Inventors:
- **KANEKO Masayoshi**
  **Tokyo 115-8588 (JP)**
- **SHIGAKI Koichiro**
  **Tokyo 115-8588 (JP)**
- **INOUE Teruhisa**
  **Tokyo 115-8588 (JP)**

(74) Representative: **Gille Hrabal**
**Brucknerstrasse 20**
**40593 Düsseldorf (DE)**

# (54) DYE-SENSITIZED PHOTOELECTRIC CONVERSION ELEMENT

(57) A. photoelectric conversion element which is obtained by having a thin film of fine oxide semiconductor particles support a methine-based dye that is represented by formula (1), said thin film being provided on a substrate.

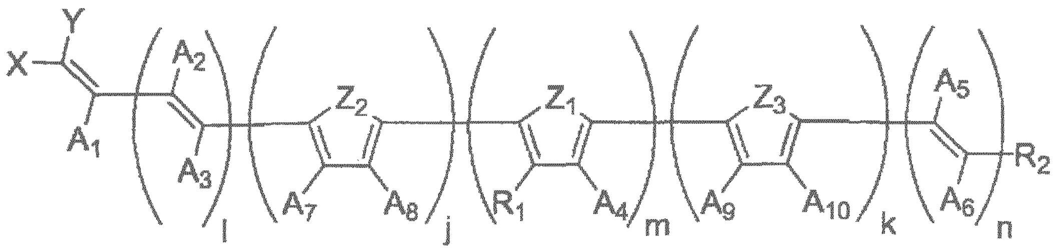

(1)

(In formula (1), m represents an integer of 1-5; each of 1 and n represents an integer of 0-6; each of j and k represents an integer of 0-3; each of X and Y represents a hydrogen atom, an aromatic residue, an aliphatic hydrocarbon residue or the like; each of $Z_1$, $Z_2$ and $Z_3$ represents an oxygen atom, a sulfur atom or the like; each of $A_1$, $A_2$, $A_3$, $A_5$ and $A_6$ represents a hydrogen atom, an aromatic residue, an aliphatic hydrocarbon residue or the like; $A_4$ represents a hydrogen atom, an aliphatic hydrocarbon residue or the like; each of $A_7$, $A_8$, $A_9$ and $A_{10}$ represents a hydrogen atom, an aliphatic hydrocarbon residue or the like; $R_1$ represents a group having a specific structure, an organic metal complex residue or the like; and $R_2$ represents a hydrogen atom, an aliphatic hydrocarbon residue, an organic metal complex residue or the like.)

EP 2 833 472 A1

## Description

Technical Field

The present invention relates to a photoelectric conversion device having a thin film of a semiconductor fine particle sensitized by an organic dye, and a solar battery using the same. More specifically, it relates to a photoelectric conversion device comprising a methine compound (dye) having a particular structure supported on a thin film of an oxide semiconductor fine particle, and a solar battery utilizing the same.

Background Art

A solar battery utilizing sunlight attracts attention as an energy resource that would substitute for fossil fuel such as petroleum or coal. Currently, a silicon solar battery using crystalline or amorphous silicon, and a compound semiconductor solar battery using gallium, arsenic, and the like have actively been developed and studied. Such a solar battery, however, is high in energy and cost required for production thereof, and thus has the problem of being difficult for general use. In addition, a photoelectric conversion device using a semiconductor fine particle sensitized by a dye, and a solar battery using the same are also known, and a material and a production technique for preparing the same are disclosed (see Patent Literature 1, Non-Patent Literature 1 and Non-Patent Literature 2). This photoelectric conversion device attracts attention, because it is produced with a relatively inexpensive oxide semiconductor such as titanium oxide, so that it would be possible to manufacture the device at a lower cost than the conventional solar battery using silicon or the like, and the produced solar battery is more colorful than the conventional one. A ruthenium complex used as a sensitizing dye for providing a device high in conversion efficiency, however, is expensive by itself, and is still problematic also in terms of stable supply thereof. On the other hand, an attempt has already been made to use an organic dye as a sensitizing dye, but a photoelectric conversion device using the dye has not been practically used, because such problems as low conversion efficiency, stability and durability thereof have not been sufficiently solved, and a further enhancement in conversion efficiency has been desired (see Patent Literature 2).

Citation List

Patent Literature

Patent Literature 1: JP 2664194 B
Patent Literature 2: WO 2002/011213

Non-Patent Literature

Non-Patent Literature 1.: B. O'Regan and M. Graetzel Nature, Vol. 353, p. 737 (1991)
Non-Patent Literature 2: M. K. Nazeeruddin, A. Kay, I. Rodicio, R. Humphry-Baker, E. Muller, P. Liska, N. Vlachopoulos, M. Graetzel, J.Am.Chem.Soc., Vol. 115, p. 6382 (1993)

Summary of Invention

Technical Problem

It has been demanded to develop a photoelectric conversion device using an oxide semiconductor fine particle sensitized by an organic dye, the photoelectric conversion device using an inexpensive organic dye, and being stable, high in conversion efficiency and high in practicality.

Solution to Problem

The present inventors have made intensive studies in order to solve the above problems, and as a result, have found that when a photoelectric conversion device is produced by using a methine dye having a particular structure to sensitize a thin film of a semiconductor fine particle, a photoelectric conversion device that is stable and high in conversion efficiency is obtained, thereby leading to the completion of the present invention.

That is, the present invention relates to:

(1) a photoelectric conversion device comprising a methine dye represented by the following formula (1) supported on a thin film of an oxide semiconductor fine particle provided on a substrate:

[Formula 1]

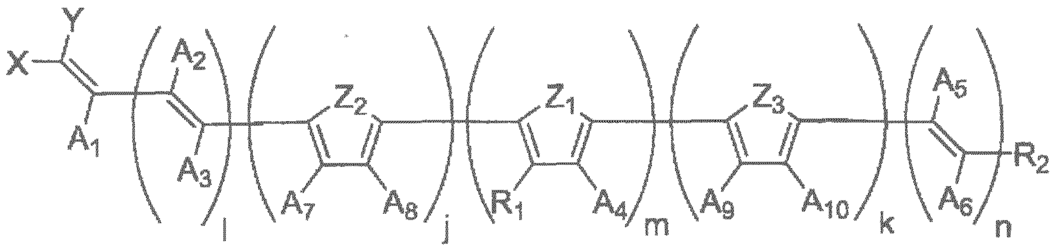

(1)

wherein m represents an integer of 1 to 5, 1 and n each represent an integer of 0 to 6, and j and k each represent an integer of 0 to 3; X and Y each independently represent a hydrogen atom, an aromatic residue, an aliphatic hydrocarbon residue, a carboxyl group, a phosphoric group, a sulfonic group, a cyano group, an acyl group, an amide group, an alkoxycarbonyl group or a sulfonylbenzene group, and X and Y may be bound to form a ring; $Z_1$, $Z_2$ and $Z_3$ each independently represent an oxygen atom, a sulfur atom, a selenium atom or $NR_{11}$; $R_{11}$ represents a hydrogen atom, an aromatic residue or an aliphatic hydrocarbon residue; when at least one of m, j and k denotes 2 or more and a quantity of any of $Z_1$, $Z_2$ and $Z_3$ present is more than one, each of the more than one $Z_1$, $Z_2$ and $Z_3$ may be the same or different from each other, $A_1$, $A_2$, $A_3$, $A_5$ and $A_6$ each independently represent a hydrogen atom, an aromatic residue, an aliphatic hydrocarbon residue, a cyano group, a halogen atom, a carbonamide group, an amide group, an alkoxyl group, an aryloxy group, an alkoxycarbonyl group, an arylcarbonyl group or an acyl group; when at least one of 1 and n denote 2 or more and a quantity of any of $A_2$, $A_3$, $A_5$ and $A_6$ present is more than one, each of the more than one $A_2$, $A_3$, $A_5$ and $A_6$ may be the same or different from each other; when 1 does not denote 0, at least two of $A_1$, $A_2$ and $A_3$ may be bound to form a ring; $A_4$ represents a hydrogen atom, an aliphatic hydrocarbon residue, a cyano group, a halogen atom, a carbonamide group, an alkoxyl group, an amide group, an alkoxycarbonyl group or an acyl group; when m denotes 2 or more and a quantity of $A_4$ present is more than one, each of the more than one $A_4$ may be the same or different from each other; $A_7$, $A_8$, $A_9$ and $A_{10}$ each independently represent a hydrogen atom, an aliphatic hydrocarbon residue, a cyano group, a halogen atom, a carbonamide group, an alkoxyl group, an alkoxycarbonyl group or an acyl group; when at least any one of j or k denotes 2 or more and a quantity of any of $A_7$, $A_8$, $A_9$ and $A_{10}$ present is more than one, each of the more than one $A_7$, $A_8$, $A_9$ and $A_{10}$ may be the same or different from each other; $R_1$ represents an organometallic complex residue or a group represented by the following formula (3001) or (3003):

[Formula 2]

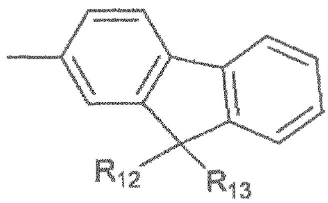

(3001)

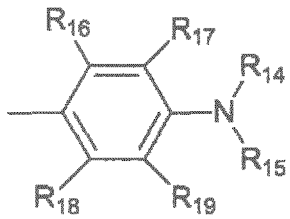

(3003)

wherein $R_{12}$, $R_{13}$, $R_{14}$ and $R_{15}$ each independently represent a hydrogen atom, an aromatic residue or an aliphatic hydrocarbon residue; $R_{16}$, $R_{17}$, $R_{18}$ and $R_{19}$ each independently represent a hydrogen atom, an aromatic residue, an aliphatic hydrocarbon residue, a cyano group, an acyl group, an amide group, an alkoxyl group, an alkoxycarbonyl group or a sulfonylbenzene group; $R_2$ represents a group represented by formula (3001) or (3003), a hydrogen atom, an aliphatic hydrocarbon residue or an organometallic complex residue; when m denotes 2 or more and a quantity of $R_1$ present is more than one, each of the more than one $R_1$ may be the same or different from each

other; and when n does not denote 0, at least two of $A_5$, $A_6$ and $R_2$ may be bound to form a ring.
(2) the photoelectric conversion device according to (1), wherein m in formula (1) denotes 1 to 3;
(3) the photoelectric conversion device according to (2), wherein m in formula (1) denotes 1;
(4) the photoelectric conversion device according to (1), wherein $Z_1$ to $Z_3$ in formula (1) represent a sulfur atom;
(5) the photoelectric conversion device according to (1), wherein 1 and n in formula (1) denote 0;
(6) the photoelectric conversion device according to (5), wherein k in formula (1) denotes 0;
(7) the photoelectric conversion device according to (1), wherein one of X and Y in formula (1) represents a carboxyl group and the other thereof represents a carboxyl group, a cyano group or an acyl group;
(8) the photoelectric conversion device according to (7), wherein one of X and Y in formula (1) represents a carboxyl group and the other thereof represents a cyano group;
(9) the photoelectric conversion device according to (1), wherein X and Y in formula (1) are bound to form a ring structure;
(10) the photoelectric conversion device according to (9), wherein a ring structure formed by binding of X and Y in formula (1) is represented by any of the following formulae (2001) to (2044):

[Formula 3]

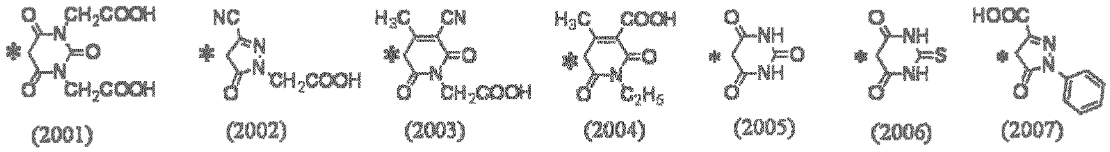

(2001) (2002) (2003) (2004) (2005) (2006) (2007)

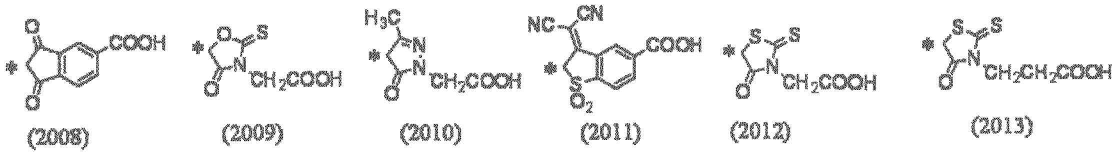

(2008) (2009) (2010) (2011) (2012) (2013)

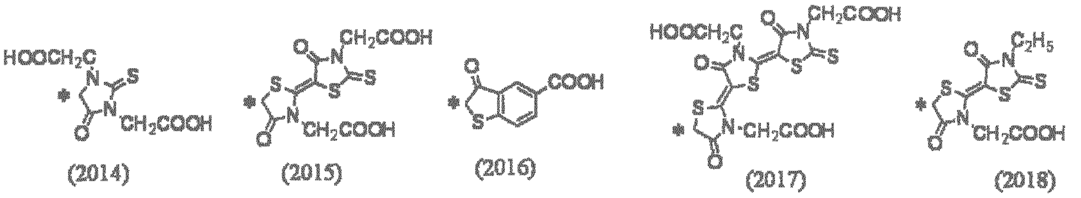

(2014) (2015) (2016) (2017) (2018)

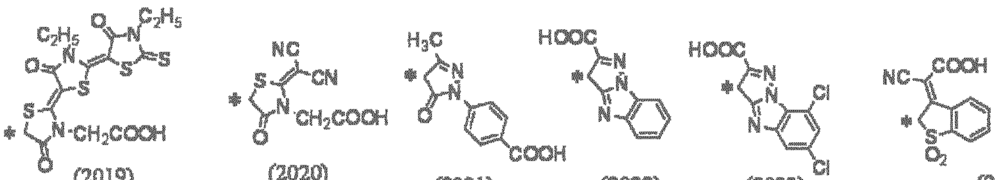

(2019) (2020) (2021) (2022) (2023) (2024)

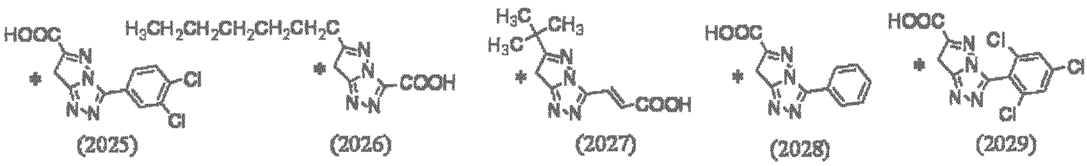

(2025) (2026) (2027) (2028) (2029)

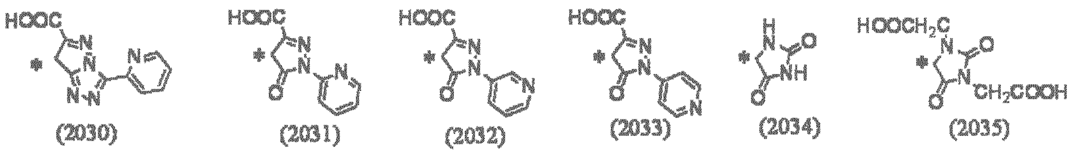

(2030) (2031) (2032) (2033) (2034) (2035)

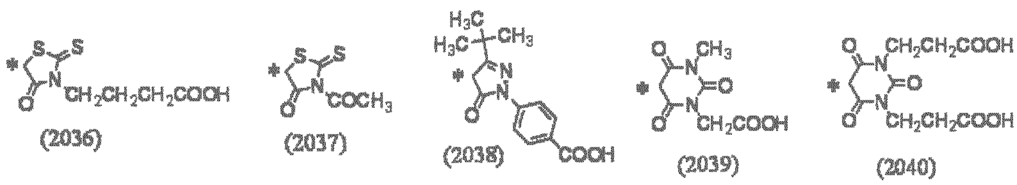

(2036) (2037) (2038) (2039) (2040)

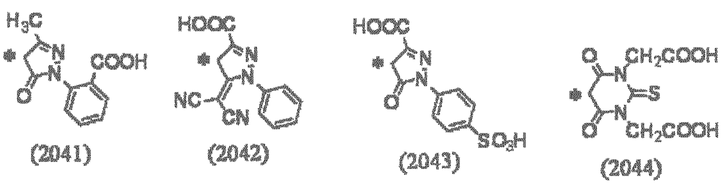

(2041) (2042) (2043) (2044)

wherein symbol * represents a carbon atom to which X and Y in formula (1) are bound;

(11) the photoelectric conversion device according to (10), wherein the ring structure formed by binding of X and Y has a carboxyl group as a substituent;

(12) the photoelectric conversion device according to (11), wherein the ring structure formed by binding of X and Y in formula (1) is represented by formula (2007) or (2012);

(13) the photoelectric conversion device according to (1), wherein $A_1$ to $A_{10}$ in formula (1) represent a hydrogen atom;

(14) the photoelectric conversion device according to (1), wherein $R_1$ in formula (1) represents a group represented by formula (3001) in which $R_{12}$ and $R_{13}$ represent a hydrogen atom or an alkyl group having 1 to 8 carbon atoms, or $R_1$ in formula (1) represents a group represented by formula (3003) in which $R_{14}$ and $R_{15}$ represent a phenyl

group or a group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms;

(15) the photoelectric conversion device according to (14), wherein $R_1$ in formula (1) represents a group represented by any of the following formulae (3101) to (3114);

[Formula 4]

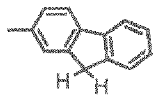

(3101)

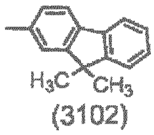

(3102)

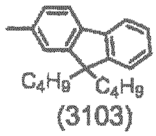

(3103)

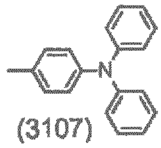

(3107)

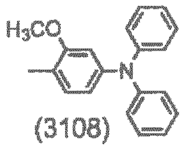

(3108)

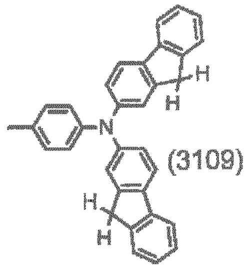

(3109)

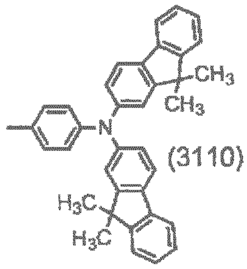

(3110)

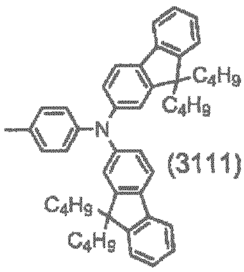

(3111)

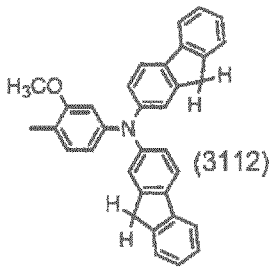

(3112)

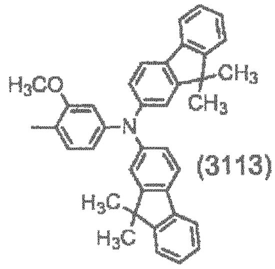

(3113)

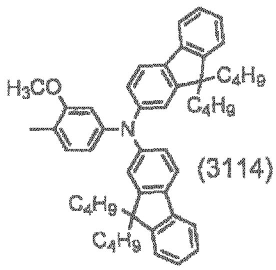

(3114)

(16) the photoelectric conversion device according to (15), wherein $R_1$ in formula (1) represents a group represented by formula (3102), (3103), (3107), (3108), (3110), (3111), (3113) or (3114);

(17) the photoelectric conversion device according to (16), wherein $R_1$ in formula (1) represents a group represented by formula (3103) or (3107);

(18) the photoelectric conversion device according to (1), wherein $R_2$ in formula (1) represents a group represented by formula (3001) in which $R_{12}$ and $R_{13}$ represent a hydrogen atom or an alkyl group having 1 to 8 carbon atoms, or $R_2$ in formula (1) represents a group represented by formula (3003) in which $R_{14}$ and $R_{15}$ represent a phenyl group or a group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms;

(19) the photoelectric conversion device according to (18), wherein $R_2$ in formula (1) represents the group represented by any of formulae (3101) to (3114) recited in (15);

(20) the photoelectric conversion device according to (19), wherein $R_2$ in formula (1) represents a group represented by formula (3107), (3108), (3110), (3111), (3113) or (3114);

(21) the photoelectric conversion device according to (20), wherein $R_2$ in formula (1) represents the group represented

by formula (3107) or (3111);

(22) the photoelectric conversion device according to (1), wherein the methine dye represented by formula (1) is represented by any of the following formulae (179) to (500)

[Formula 5-1]

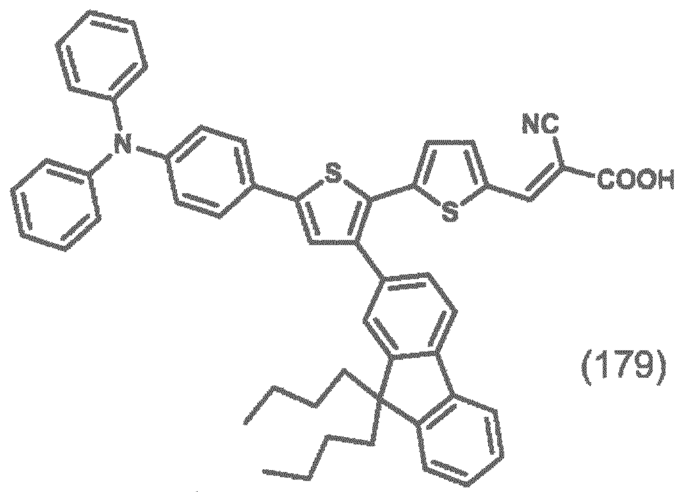

(179)

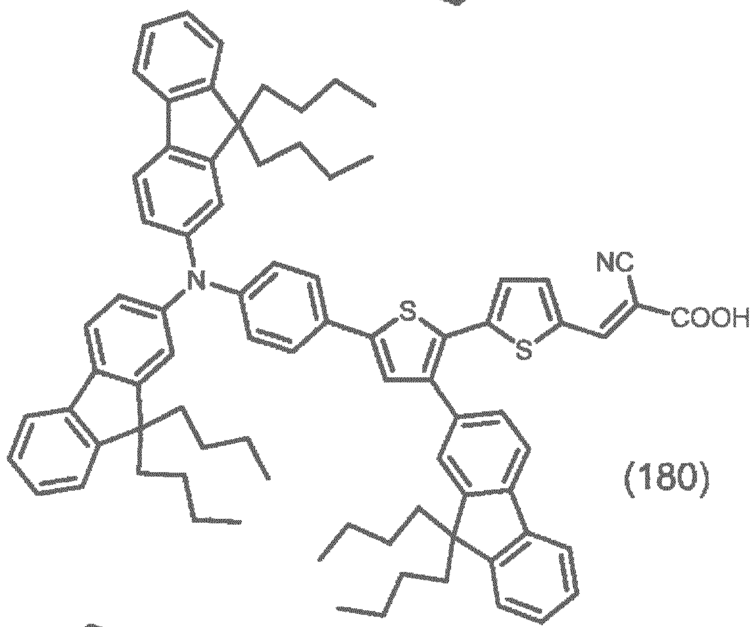

(180)

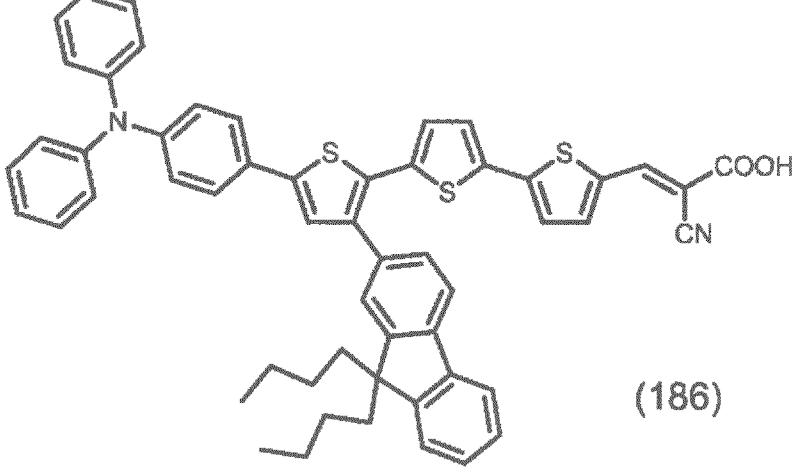

(186)

[Formula 5-2]

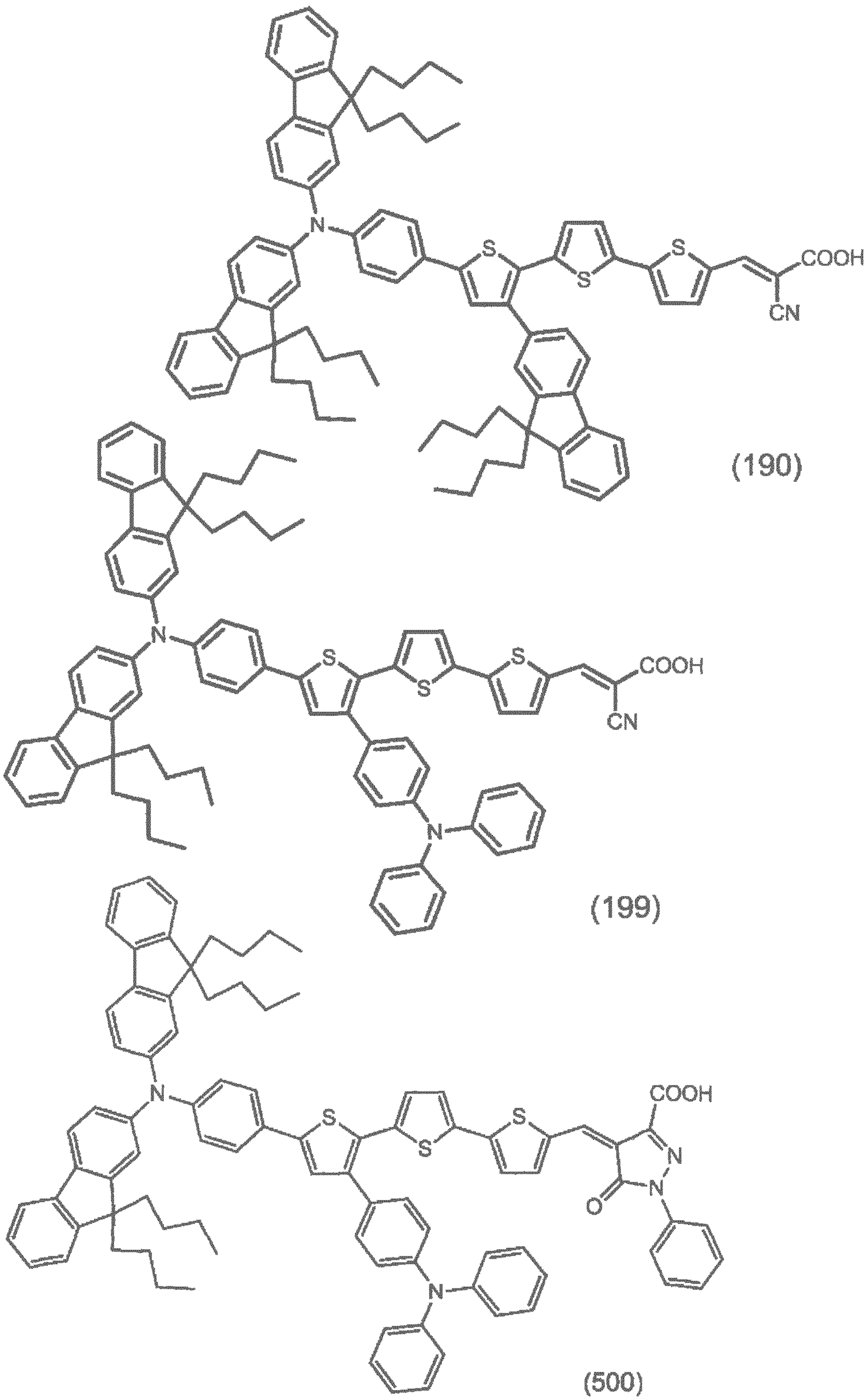

(190)

(199)

(500)

(23) a solar battery comprising the photoelectric conversion device according to any one of (1) to (22); and
(24) a methine compound represented by formula (1) in (1).

Advantageous Effects of Invention

The methine dye having a particular structure has made it possible to provide a solar battery high in conversion efficiency and high in stability.

Description of Embodiments

Hereinafter, the present invention will be described in detail.

The photoelectric conversion device of the present invention comprises a methine dye represented by formula (1) supported on a thin film of an oxide semiconductor fine particle provided on a substrate. The methine dye represented by formula (1) is characterized in that $R_1$ at a particular position represents a particular group or an organometallic complex, and a photoelectric conversion device provided with a thin film of an oxide semiconductor fine particle, on which the methine dye is supported, can effectively convert light as compared with a photoelectric conversion device including a methine dye wherein $R_1$ represents neither a particular group nor an organometallic complex, or a dye other than the methine dye represented by formula (1). Hereinafter, formula (1) is described.

[Formula 6]

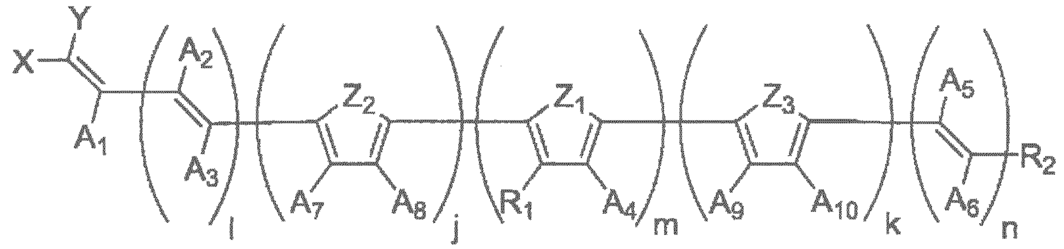

(1)

In formula (1), m denotes an integer of 1 to 5, preferably 1 to 3, more preferably 1 to 2, further preferably 1.
In formula (1), 1 denotes an integer of 0 to 6, preferably 0.
In formula (1), n denotes an integer of 0 to 6, preferably 0.
In formula (1), j denotes an integer of 0 to 3, preferably 1 to 3, more preferably 1 to 2.
In formula (1), k denotes an integer of 0 to 3, preferably 0.

In formula (1), X and Y each independently represent a hydrogen atom, an aromatic residue, an aliphatic hydrocarbon residue, a carboxyl group, a phosphoric group, a sulfonic group, a cyano group, an acyl group, an amide group, an alkoxycarbonyl group or a sulfonylbenzene group.

The aromatic residue represented by X and Y in formula (1) means a group in which one hydrogen atom is removed from an aromatic ring or a condensed ring including an aromatic ring, and the aromatic residue may have a substituent. Specific examples of the aromatic ring include aromatic hydrocarbon rings such as benzene, naphthalene, anthracene, phenanthrene, pyrene, perylene and terrylene, heteroaromatic rings such as indene, azulene, pyridine, pyrazine, pyrimidine, pyrazole, pyrazolidine, thiazolidine, oxazolidine, pyran, chromene, pyrrole, pyrrolidine, benzimidazole, imidazoline, imidazolidine, imidazole, triazole, triazine, diazole, indoline, thiophene, thienothiophene, furan, oxazole, oxadiazole, thiazine, thiazole, indole, benzothiazole, benzothiadiazole, naphthothiazole, benzoxazole, naphthoxazole, indolenine, benzoindolenine, quinoline and quinazoline, and condensed aromatic rings such as fluorene and carbazole, and preferable is a group in which one hydrogen atom is removed from an aromatic ring or a condensed ring including an aromatic ring, having 4 to 20 carbon atoms.

The substituent that the aromatic residue represented by X and Y may have is not particularly limited, but examples thereof include a sulfonic group, a sulfamoyl group, a cyano group, an isocyano group, a thiocyanato group, an isothiocyanato group, a nitro group, a nitrosyl group, a halogen atom, a hydroxyl group, a phosphoric group, a phosphoric acid ester group, a substituted or unsubstituted amino group, a mercapto group, an amide group, an alkoxyl group, an aryloxy group, a carboxyl group, a carbamoyl group, an acyl group, an aldehyde group, and substituted carbonyl groups such as an alkoxycarbonyl group and an arylcarbonyl group, as well as an aromatic residue and an aliphatic hydrocarbon residue.

The halogen atom as the substituent that the aromatic residue may have includes fluorine, chlorine, bromine and iodine atoms, and a bromine atom and a chlorine atom are preferable.

The phosphoric acid ester group as the substituent that the aromatic residue may have includes phosphoric acid (C1 to C4) alkyl ester groups, and specific preferable examples are methyl phosphate, ethyl phosphate, (n-propyl) phosphate and (n-butyl) phosphate.

The substituted or unsubstituted amino group as the substituent that the aromatic residue may have includes

an amino group, alkyl substituted amino groups such as a mono- or dimethylamino group, a mono- or diethylamino group and a mono- or di(n-propyl)amino group, aromatic substituted amino groups such as a mono- or diphenylamino group and a mono- or dinaphthylamino group, amino groups substituted with one alkyl group and one aromatic residue, such as a monoalkylmonophenylamino group, a benzylamino group, an acetylamino group and a phenylacetylamino group.

The mercapto group as the substituent that the aromatic residue may have includes a mercapto group and an alkylmercapto group, and specifically includes C1 to C4 alkylmercapto groups such as a methylmercapto group, an ethylmercapto group, a n-propylmercapto group, an isopropylmercapto group, a n-butylmercapto group, an isobutylmercapto group, a sec-butylmercapto group and a t-butylmercapto group, or phenylmercapto groups.

The amide group as the substituent that the aromatic residue may have includes an amide group, an acetamide group and an alkylamide group, and specific examples preferably include an amide group, an acetamide group, an N-methylamide group, an N-ethylamide group, an N-(n-propyl)amide group, an N-(n-butyl)amide group, an N-isobutylamide group, an N-(sec-butylamide) group, an N-(t-butyl)amide group, an N,N-dimethylamide group, an N,N-diethylamide group, an N,N-di(n-propyl)amide group, an N,N-di(n-butyl)amide group, an N,N-diisobutylamide group, an N-methylacetamide group, an N-ethylacetamide group, an N-(n-propyl)acetamide group, an N-(n-butyl)acetamide group, an N-isobutylacetamide group, an N-(sec-butyl)acetamide group, an N-(t-butyl)acetamide group, an N,N-dimethylacetamide group, an N,N-diethylacetamide group, an N,N-di(n-propyl)acetamide group, an N,N-di(n-butyl)acetamide group and an N,N-diisobutylacetamide group, and also arylamide groups, specifically preferably including a phenylamide group, a naphthylamide group, a phenylacetamide group and a naphthylacetamide group.

The alkoxyl group as the substituent that the aromatic residue may have includes a methoxy group, an ethoxy group, a n-propoxy group, an isopropoxy group, a n-butoxy group, an isobutoxy group, a sec-butoxy group and a t-butoxy group.

The aryloxy group as the substituent that the aromatic residue may have includes a phenoxy group and a naphthoxy group.

Examples of the acyl group as the substituent that the aromatic residue may have include an alkylcarbonyl group having 1 to 10 carbon atoms and an arylcarbonyl group, preferably include an alkylcarbonyl group having 1 to 4 carbon atoms, and specifically include an acetyl group, a propionyl group, a trifluoromethylcarbonyl group, a pentafluoroethylcarbonyl group, a benzoyl group and a naphthoyl group.

Examples of the alkoxycarbonyl group as the substituent that the aromatic residue may have include an alkoxycarbonyl group having 1 to 10 carbon atoms. Specific examples thereof include a methoxycarbonyl group, an ethoxycarbonyl group, a n-propoxycarbonyl group, an isopropoxycarbonyl group, a n-butoxycarbonyl group, an isobutoxycarbonyl group, a sec-butoxycarbonyl group, a t-butoxycarbonyl group, a n-pentoxycarbonyl group, a n-hexyloxycarbonyl group, a n-heptyloxycarbonyl group, a n-nonyloxycarbonyl group and a n-decyloxycarbonyl group.

Examples of the arylcarbonyl group as the substituent that the aromatic residue may have include groups in which an aryl group and carbonyl are linked, such as benzophenone and naphthophenone.

The aromatic residue as the substituent that the aromatic residue may have includes the same aromatic residues as those mentioned in the section for the aromatic residue represented by X and Y in formula (1).

The aliphatic hydrocarbon residue as the substituent that the aromatic residue may have includes a saturated or unsaturated, linear, branched or cyclic alkyl group, and the aliphatic hydrocarbon residue may have a substituent. The aliphatic hydrocarbon residue is preferably a saturated alkyl group and more preferably a saturated linear alkyl group. In addition, the number of carbon atoms in the aliphatic hydrocarbon residue is preferably 1 to 36, more preferably 1 to 18, and further preferably 1 to 8. Specific examples of such an aliphatic hydrocarbon residue include a methyl group, an ethyl group, a n-propyl group, an isopropyl group, a n-butyl group, an iso-butyl group, a sec-butyl group, a t-butyl group, a n-pentyl group, a n-hexyl group, a n-heptyl group, a n-octyl group, a n-nonyl group, a n-decyl group, a n-undecyl group, a n-dodecyl group, a n-tridecyl group, a n-tetradecyl group, a n-pentadecyl group, a n-hexadecyl group, a n-heptadecyl group, a n-octadecyl group, a cyclohexyl group, a vinyl group, a propenyl group, a pentynyl group, a butenyl group, a hexenyl group, a hexadienyl group, an isopropenyl group, an isohexenyl group, a cyclohexenyl group, a cyclopentadienyl group, an ethynyl group, a propynyl group, a pentynyl group, a hexynyl group, an isohexynyl group and a cyclohexynyl group. In addition, examples of the cyclic alkyl group include a cycloalkyl group having 3 to 8 carbon atoms. The linear alkyl group having 1 to 8 carbon atoms is particularly preferable.

The aromatic residue, the aliphatic hydrocarbon residue, the amide group, the acyl group, the alkoxyl group, the aryloxy group, the arylcarbonyl group and the alkoxycarbonyl group as the substituent that the aromatic residue may have may have a substituent, and the substituent includes the same ones as those mentioned in the section for the substituent that the aromatic residue may have.

The aromatic residue represented by X and Y in formula (1) is preferably an aromatic residue having as a substituent at least one or more members selected from the group consisting of a carboxyl group, a hydroxyl group, a phosphoric group, a sulfonic group and salts of such acidic groups, and is more preferably an aromatic residue represented by any of the following formulae (1001) to (1033).

[Formula 7]

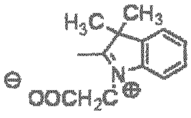
(1001)

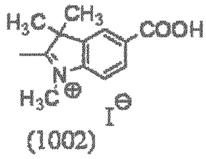
(1002)

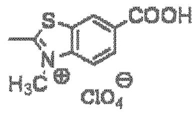
(1003)

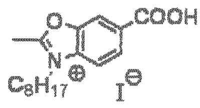
(1004)

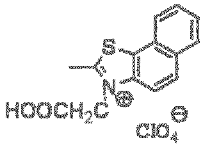
(1005)

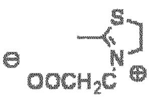
(1006)

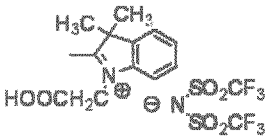
(1007)

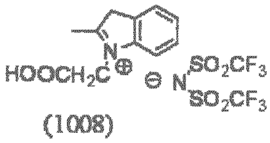
(1008)

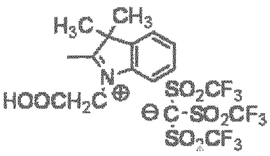
(1009)

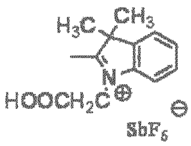
(1010)

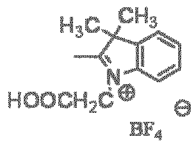
(1011)

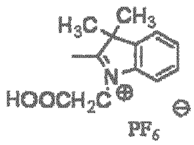
(1012)

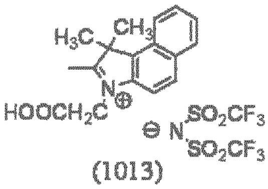
(1013)

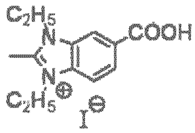
(1014)

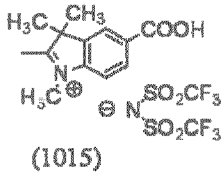
(1015)

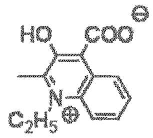
(1016)

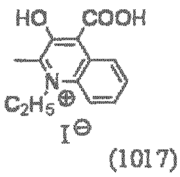
(1017)

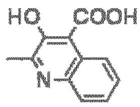
(1018)

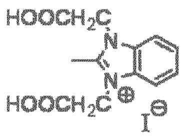
(1019)

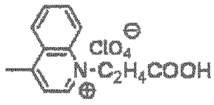
(1020)

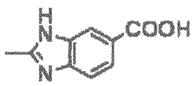
(1021)

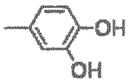
(1022)

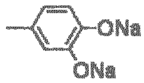
(1023)

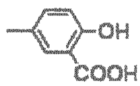
(1024)

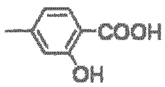
(1025)

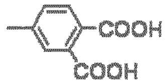
(1026)

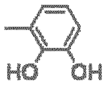
(1027)

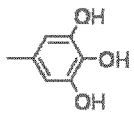
(1028)

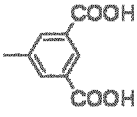
(1029)

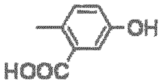
(1030)

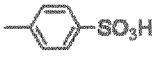
(1031)

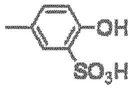
(1032)

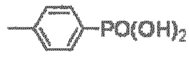
(1033)

The aliphatic hydrocarbon residue represented by X and Y in formula (1) includes the same ones as the aliphatic hydrocarbon residues mentioned in the section for the substituent that the aromatic residue represented by X and Y in formula (1) may have. The aliphatic hydrocarbon residue may have a substituent, and the substituent includes the same ones as those mentioned in the section for the substituent that the aromatic residue represented by X and Y in formula

(1) may have.

The acyl group represented by X and Y in formula (1) includes the same ones as the acyl groups mentioned in the section for the substituent that the aromatic residue represented by X and Y in formula (1) may have. The acyl group may have a substituent, and the substituent includes the same ones as those mentioned in the section for the substituent that the aromatic residue represented by X and Y in formula (1) may have.

The amide group represented by X and Y in formula (1) includes the same ones as those mentioned in the section for the substituent that the aromatic residue represented by X and Y in formula (1) may have. The amide group may have a substituent, and the substituent includes the same ones as the amide groups mentioned in the section for the substituent that the aromatic residue represented by X and Y in formula (1) may have.

The alkoxycarbonyl group represented by X and Y in formula (1) includes the same ones as the alkoxycarbonyl groups mentioned in the section for the substituent that the aromatic residue represented by X and Y in formula (1) may have. The alkoxycarbonyl group may have a substituent, and the substituent includes the same ones as those mentioned in the section for the substituent that the aromatic residue represented by X and Y in formula (1) may have.

In addition, X and Y in formula (1) may be bound to form a ring. The ring may have a substituent, and the substituent includes the same ones as those mentioned in the section for the substituent that the aromatic residue represented by X and Y in formula (1) may have. Specific examples of a ring structure formed by binding of X and Y include rings represented by the following formulae (2001) to (2044), and of these, preferable is the one in which the ring structure has a carboxyl group as the substituent, particularly preferable is the one in which the ring structure is a ring represented by (2007) or (2012) and extremely preferable is a ring represented by (2007).

[Formula 8]

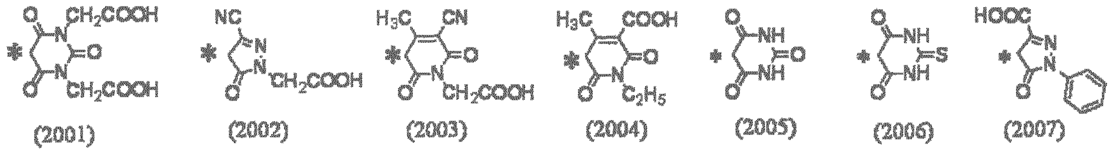

(2001) (2002) (2003) (2004) (2005) (2006) (2007)

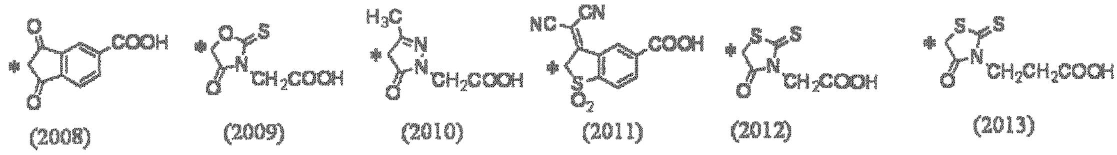

(2008) (2009) (2010) (2011) (2012) (2013)

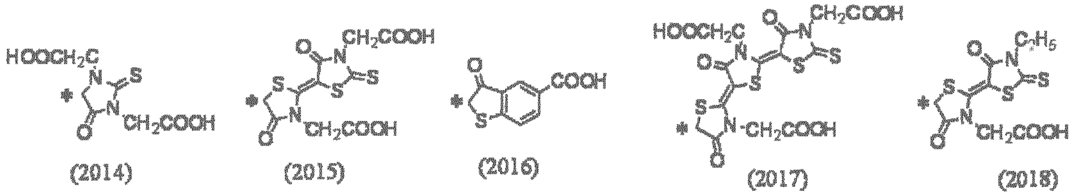

(2014) (2015) (2016) (2017) (2018)

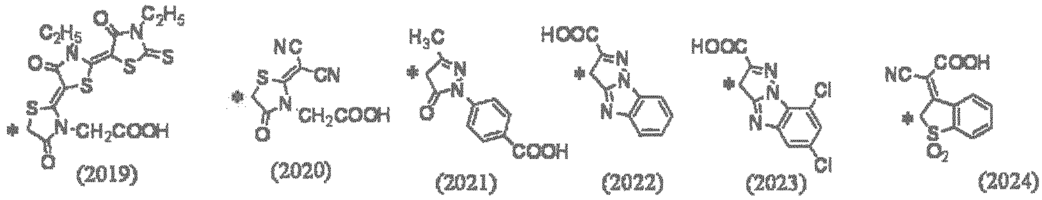

(2019) (2020) (2021) (2022) (2023) (2024)

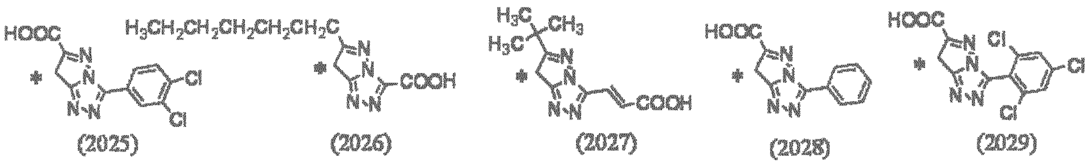

(2025) (2026) (2027) (2028) (2029)

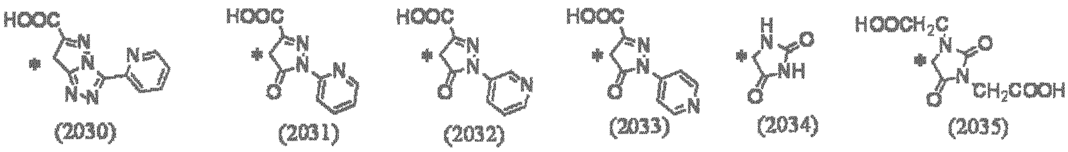

(2030) (2031) (2032) (2033) (2034) (2035)

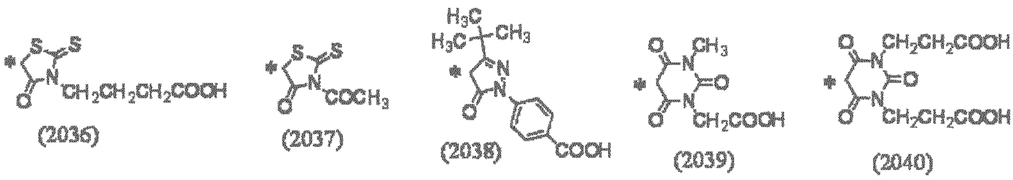

(2036) (2037) (2038) (2039) (2040)

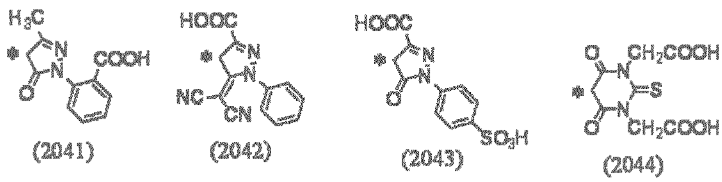

(2041) (2042) (2043) (2044)

Symbol * in formulae (2001) to (2044) denotes the carbon atom to which X and Y in formula (1) are bound.

X and Y in formula (1) is preferably any of the following (i) to (iii):

(i) preferably, X and Y each independently represent a carboxyl group, a phosphoric group, a cyano group or an acyl group, more preferably, X and Y each independently represent a carboxyl group, a cyano group or an acyl group, further preferably, one of X and Y represents a carboxyl group and the other thereof represents a carboxyl group, a cyano group or an acyl group, and particularly preferably, one of X and Y represents a carboxyl group and the other thereof represents a cyano group;

(ii) preferably, at least any one of X and Y represents an aromatic residue having as a substituent at least one or

more members selected from the group consisting of a carboxyl group, a hydroxyl group, a phosphoric group, a sulfonic group and salts of such acidic groups, and more preferably, the aromatic residue is the aromatic residue represented by any of formulae (1001) to (1033); and (iii) preferably, X and Y are bound to form a ring structure, more preferably, the ring structure is represented by any of formulae (2001) to (2044), further preferably, the ring structure has a carboxyl group as the substituent, particularly preferably, the ring structure is represented by (2007) or (2012), and most preferably, the ring structure is represented by formula (2007).

$Z_1$, $Z_2$ and $Z_3$ in formula (1) each independently represent an oxygen atom, a sulfur atom, a selenium atom or $NR_{11}$, and $R_{11}$ represents a hydrogen atom, an aromatic residue or an aliphatic hydrocarbon residue.

The aromatic residue represented by $R_{11}$ includes the same ones as those mentioned in the section for the substituent that the aromatic residue represented by X and Y in formula (1) may have.

The aliphatic hydrocarbon residue represented by $R_{11}$ includes the same ones as the aliphatic hydrocarbon residues mentioned in the section for the substituent that the aromatic residue represented by X and Y in formula (1) may have.

The aromatic residue and the aliphatic hydrocarbon residue represented by $R_{11}$ may have a substituent, and specific examples of the substituent include a sulfamoyl group, a cyano group, an isocyano group, a thiocyanato group, an isothiocyanato group, a nitro group, a nitrosyl group, a halogen atom, a phosphoric acid ester group, a substituted or unsubstituted amino group, an amide group, an alkoxyl group, an aryloxy group, a carbamoyl group, an acyl group and an aldehyde group, and substituted carbonyl groups such as an alkoxycarbonyl group and an arylcarbonyl group, as well as an aromatic residue and an aliphatic hydrocarbon residue.

The halogen atom, the phosphoric acid ester group, the substituted or unsubstituted amino group, the amide group, the alkoxyl group, the aryloxy group, the acyl group, the alkoxycarbonyl group, the arylcarbonyl group and the aliphatic hydrocarbon residue as the substituent that the aromatic residue and the aliphatic hydrocarbon residue represented by $R_{11}$ may have include the same ones as those mentioned in the section for the substituent that the aromatic residue represented by X and Y in formula (1) may have.

The aromatic residue as the substituent that the aromatic residue and the aliphatic hydrocarbon residue represented by $R_{11}$ may have includes the same ones as those mentioned in the section for the aromatic residue represented by X and Y in formula (1).

When at least any one of m, j or k in formula (1) denotes 2 or more and the quantity of any of $Z_1$, $Z_2$ and $Z_3$ present is more than one, each of the more than one $Z_1$, $Z_2$ and $Z_3$ may be the same or different from each other.

$Z_1$, $Z_2$ and $Z_3$ in formula (1) each independently preferably represent an oxygen atom, a sulfur atom and a selenium atom, more preferably a sulfur atom.

$A_1$, $A_2$, $A_3$, $A_5$ and $A_6$ each independently represent a hydrogen atom, an aromatic residue, an aliphatic hydrocarbon residue, a cyano group, a halogen atom, a carbonamide group, an amide group, an alkoxyl group, an aryloxy group, an alkoxycarbonyl group, an arylcarbonyl group or an acyl group.

The aromatic residue represented by $A_1$, $A_2$, $A_3$, $A_5$ and $A_6$ includes the same ones as in the case of the aromatic residue represented by X and Y in formula (1).

The aliphatic hydrocarbon residue, the halogen atom, the amide group, the alkoxyl group, the aryloxy group, the alkoxycarbonyl group, the arylcarbonyl group and the acyl group represented by $A_1$, $A_2$, $A_3$, $A_5$ and $A_6$ each include the same ones as those mentioned in the section for the substituent that the aromatic residue represented by X and Y in formula (1) may have.

The aromatic residue, the aliphatic hydrocarbon residue, the amide group, the alkoxyl group, the aryloxy group, the alkoxycarbonyl group, the arylcarbonyl group and the acyl group represented by $A_1$, $A_2$, $A_3$, $A_5$ and $A_6$ may have a substituent, and the substituent includes the same ones as those mentioned in the section for the substituent that the aromatic residue and the aliphatic hydrocarbon residue represented by $R_{11}$ in formula (1) may have.

When at least one of 1 and n in formula (1) denotes 2 or more and the quantity of any of $A_2$, $A_3$, $A_5$ and $A_6$ present is more than one, each of the more than one $A_2$, $A_3$, $A_5$ and $A_6$ may be the same or different from each other.

When 1 does not denote 0, at least two of $A_1$, $A_2$ and $A_3$ may be bound to form a ring.

The ring formed by $A_1$, $A_2$ and $A_3$ includes an unsaturated hydrocarbon ring or a hetero ring.

Examples of the unsaturated hydrocarbon ring include benzene, naphthalene, anthracene, phenanthrene, pyrene, indene, azulene, fluorene, cyclobutene, cyclohexene, cyclopentene, cyclohexadiene and cyclopentadiene, and examples of the hetero ring include pyran, pyridine, pyrazine, piperidine, indoline, oxazole, thiazole, thiadiazole, oxadiazole, indole, benzothiazole, benzoxazole, quinoline, carbazole and benzopyran. Of these, benzene, cyclobutene, cyclopentene and cyclohexene are preferable.

Such an unsaturated hydrocarbon ring and a hetero ring may have a substituent, and the substituent includes the same ones as those mentioned in the section for the substituent that the aromatic residue and the aliphatic hydrocarbon residue represented by $R_{11}$ in formula (1) may have.

When the hetero ring formed by at least two members selected from $A_1$, $A_2$ and $A_3$ has a substituent such as

a carbonyl group or a thiocarbonyl group, such a substituent may be a cyclic ketone or a cyclic thioketone, and such a ring may further have a substituent. The substituent in this case includes the same ones as those mentioned in the section for the substituent that the aromatic residue and the aliphatic hydrocarbon residue represented by $R_{11}$ in formula (1) may have.

Of these, $A_1$, $A_2$, $A_3$, $A_5$ and $A_6$ in formula (1) each independently preferably represent a hydrogen atom or an aliphatic hydrocarbon residue, more preferably a hydrogen atom.

$A_4$ in formula (1) represents a hydrogen atom, an aliphatic hydrocarbon residue, a cyano group, a halogen atom, a carbonamide group, an alkoxyl group, an amide group, an alkoxycarbonyl group or an acyl group.

The aliphatic hydrocarbon residue, the halogen atom, the alkoxyl group, the amide group, the alkoxycarbonyl group and the acyl group represented by $A_4$ includes the same ones as those mentioned in the section for the substituent that the aromatic residue represented by X and Y in formula (1) may have.

The aliphatic hydrocarbon residue, the alkoxyl group, the amide group, the alkoxycarbonyl group and the acyl group represented by $A_4$ may have a substituent, and the substituent includes the same ones as those mentioned in the section for the substituent that the aromatic residue and the aliphatic hydrocarbon residue represented by $R_{11}$ in formula (1) may have.

When m denotes 2 or more and the quantity of $A_4$ present is more than one, each of the more than one $A_4$ may be the same or different from each other.

$A_4$ in formula (1) is preferably a hydrogen atom or an aliphatic hydrocarbon residue, and more preferably a hydrogen atom.

$A_7$, $A_8$, $A_9$ and $A_{10}$ in formula (1) each independently represent a hydrogen atom, an aliphatic hydrocarbon residue, a cyano group, a halogen atom, a carbonamide group, an alkoxyl group, an alkoxycarbonyl group or an acyl group.

The aliphatic hydrocarbon residue, the halogen atom, the alkoxyl group, the alkoxycarbonyl group and the acyl group represented by $A_7$, $A_8$, $A_9$ and $A_{10}$ include the same ones as those mentioned in the section for the substituent that the aromatic residue represented by X and Y in formula (1) may have.

The aliphatic hydrocarbon residue, the alkoxyl group, the alkoxycarbonyl group and the acyl group represented by $A_7$, $A_8$, $A_9$ and $A_{10}$ may have a substituent, and the substituent includes the same ones as those mentioned in the section for the substituent that the aromatic residue and the aliphatic hydrocarbon residue represented by $R_{11}$ in formula (1) may have.

When at least any one of j or k denotes 2 or more and the quantity of any of $A_7$, $A_8$, $A_9$ and $A_{10}$ present is more than one, each of the more than one $A_7$, $A_8$, $A_9$ and $A_{10}$ may be the same or different from each other.

$A_7$, $A_8$, $A_9$ and $A_{10}$ in formula (1) each independently represent a hydrogen atom or an aliphatic hydrocarbon residue, more preferably a hydrogen atom.

$R_1$ in formula (1) each independently represents a group represented by the following formula (3001) or (3003), or an organometallic complex residue.

[Formula 9]

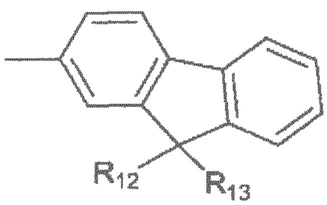

(3001)

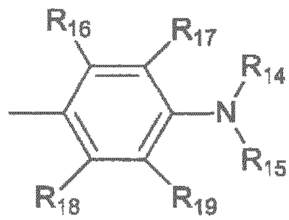

(3003)

$R_{12}$, $R_{13}$, $R_{14}$ and $R_{15}$ in formulae (3001) to (3003) each independently represent a hydrogen atom, an aromatic residue or an aliphatic hydrocarbon residue. $R_{16}$, $R_{17}$, $R_{18}$ and $R_{19}$ each independently represent a hydrogen atom, an aromatic residue, an aliphatic hydrocarbon residue, a cyano group, an acyl group, an amide group, an alkoxyl group, an alkoxycarbonyl group or a sulfonylbenzene group.

The aromatic residue represented by $R_{12}$, $R_{13}$, $R_{14}$ and $R_{15}$ include the same ones as those mentioned in the section for the aromatic residue represented by X and Y in formula (1).

The aliphatic hydrocarbon residue represented by $R_{12}$, $R_{13}$, $R_{14}$ and $R_{15}$ include the same ones as the aliphatic hydrocarbon residues mentioned in the section for the substituent that the aromatic residue represented by X and Y in formula (1) may have.

The aromatic residue and the aliphatic hydrocarbon residue represented by $R_{12}$, $R_{13}$, $R_{14}$ and $R_{15}$ may have a substituent, and the substituent includes the same ones as those mentioned in the section for the substituent that the aromatic residue and the aliphatic hydrocarbon residue represented by $R_{11}$ in formula (1) may have.

$R_{12}$ and $R_{13}$ in formula (3001) each independently preferably represent a hydrogen atom or an aliphatic hydrocarbon residue, each independently more preferably a hydrogen atom or an alkyl group having 1 to 18 carbon atoms, further preferably an alkyl group having 1 to 8 carbon atoms, particularly preferably a linear alkyl group having 1 to 8 carbon atoms.

$R_{14}$ and $R_{15}$ in formula (3003) each independently preferably represent an aromatic residue, each independently more preferably represent a phenyl group or the group represented by formula (3001), and further preferably represent the same phenyl group or the same group represented by formula (3001). Herein, $R_{12}$ and $R_{13}$ in the group represented by formula (3001), represented by $R_{14}$ and $R_{15}$, are the same as described above and preferable ones are also the same as described above.

The aromatic residue represented by $R_{16}$, $R_{17}$, $R_{18}$ and $R_{19}$ includes the same ones as those mentioned in the section for the aromatic residue represented by X and Y in formula (1).

The aliphatic hydrocarbon residue, the acyl group, the amide group, the alkoxyl group and the alkoxycarbonyl group represented by $R_{16}$, $R_{17}$, $R_{18}$ and $R_{19}$ include the same ones as those mentioned in the section for the substituent that the aromatic residue represented by X and Y in formula (1) may have.

The aromatic residue, the aliphatic hydrocarbon residue, the acyl group, the amide group, the alkoxyl group, the alkoxycarbonyl group and the sulfonylbenzene group represented by $R_{16}$, $R_{17}$, $R_{18}$ and $R_{19}$ may have a substituent, and the substituent includes the same ones as those mentioned in the section for the substituent that the aromatic residue and the aliphatic hydrocarbon residue represented by $R_{11}$ in formula (1) may have.

$R_{16}$, $R_{17}$, $R_{18}$ and $R_{19}$ in formula (3003) each independently represent a hydrogen atom or an alkoxyl group, more preferably a hydrogen atom or an alkoxyl group having 1 to 4 carbon atoms, further preferably a hydrogen atom.

The organometallic complex residue represented by $R_1$ includes an organometallic complex, or an organometallic complex in which one hydrogen atom is removed from the substituent bound to the organometallic complex, and such an organometallic complex compound includes ferrocene, ruthenocene, titanocene, zirconocene, porphyrin, phthalocyanine and bipyridyl complexes. The organometallic complex residue may have a substituent, and the substituent includes the same ones as those mentioned in the section for the substituent that the aromatic residue and the aliphatic hydrocarbon residue represented by $R_{11}$ in formula (1) may have.

When m denotes 2 or more and the quantity of $R_1$ present is more than one, each of the more than one $R_1$ may be the same or different from each other.

More preferably, $R_1$ in formula (1) represents the group represented by formula (3001) in which $R_{12}$ and $R_{13}$ represent a hydrogen atom or an alkyl group having 1 to 8 carbon atoms, or $R_1$ in formula (1) represents the group represented by formula (3003) in which $R_{14}$ and $R_{15}$ represent a phenyl group or the group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms, and further preferably, $R_1$ in formula (1) represents the group represented by formula (3001) in which $R_{12}$ and $R_{13}$ represents an alkyl group having 1 to 8 carbon atoms, or $R_1$ in formula (1) represents the group represented by formula (3003) in which $R_{14}$ and $R_{15}$ represents a phenyl group, and $R_{16}$ to $R_{19}$ each represent a hydrogen atom.

More specifically, $R_1$ preferably represents a group represented by any of the following formulae (3101) to (3119), more preferably represents a group represented by any of the following formulae (3101) to (3114), further preferably represents a group represented by the following formula (3102), (3103), (3107), (3108), (3110), (3111), (3113) or (3114), particularly preferably represents a group represented by the following formula (3103), (3107) or (3111), and most preferably represents a group represented by the following formula (3103) or (3107).

[Formula 10]

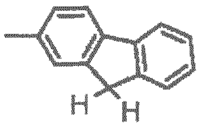
(3101)

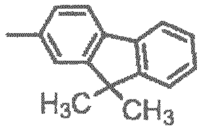
(3102)

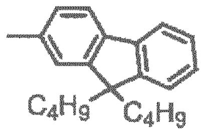
(3103)

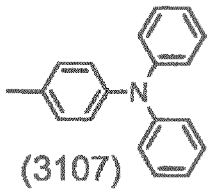
(3107)

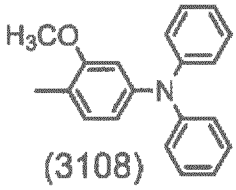
(3108)

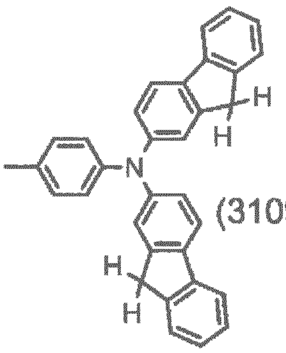
(3109)

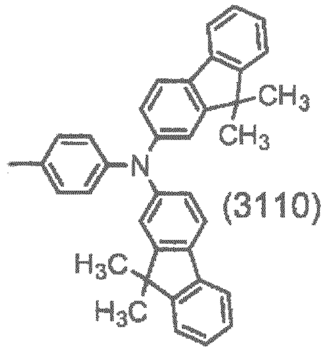
(3110)

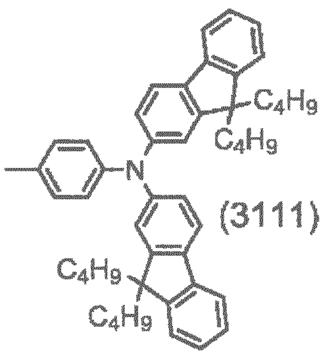
(3111)

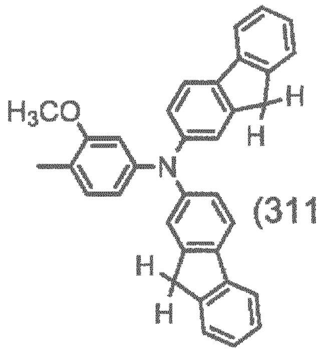
(3112)

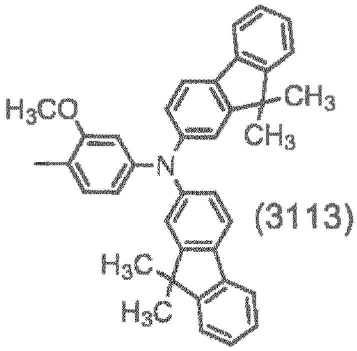
(3113)

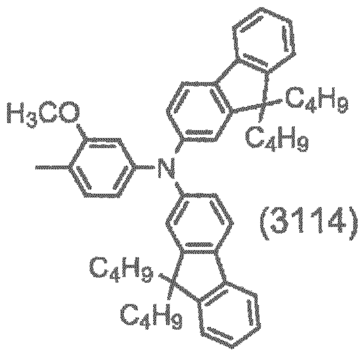
(3114)

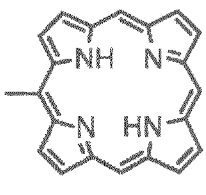
(3115)

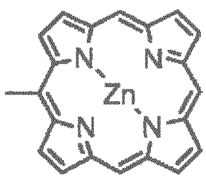
(3119)

$R_2$ in formula (1) represents the group represented by formula (3001) or (3003), a hydrogen atom, an aliphatic hydrocarbon residue or an organometallic complex residue.

The aliphatic hydrocarbon residue represented by $R_2$ includes the same ones as the aliphatic hydrocarbon residues mentioned in the section for the substituent that the aromatic residue represented by X and Y in formula (1) may have.

$R_{12}$ to $R_{19}$ in formula (3001) and formula (3003) represented by $R_2$ include the same ones as those mentioned in the section for formula (3001) and formula (3003) represented by $R_1$, and preferable ones are also the same as those mentioned in the section for formula (3001) and formula (3003) represented by $R_1$.

The organometallic complex residue represented by $R_2$ includes the same ones as those mentioned in the section for the organometallic complex residue represented by $R_1$.

When n does not denote 0, at least two members selected from $A_5$, $A_6$ and $R_2$ may be bound to form a ring.

The ring formed by $A_5$, $A_6$ and $R_2$ may have a substituent, and the substituent includes the same ones as those mentioned in the section for the substituent that the aromatic residue and the aliphatic hydrocarbon residue represented by $R_{11}$ in formula (1) may have.

More preferably, $R_2$ in formula (1) represents the group represented by formula (3001) in which $R_{12}$ and $R_{13}$ represent a hydrogen atom or an alkyl group having 1 to 8 carbon atoms, or $R_2$ in formula (1) represents the group represented by formula (3003) in which $R_{14}$ and $R_{15}$ represent a phenyl group or the group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms. Further preferably, $R_2$ in formula (1) represents the group represented by formula (3003) in which $R_{14}$ and $R_{15}$ represent a phenyl group, and $R_{16}$ to $R_{19}$ each independently represent a hydrogen atom or an alkoxyl group having 1 to 4 carbon atoms, or $R_2$ in formula (1) represents the group represented by formula (3003) in which $R_{14}$ and $R_{15}$ represent the group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms.

More specifically, $R_2$ in formula (1) preferably represents the group represented by any of formulae (3101) to (3119), more preferably represents the group represented by any of formulae (3101) to (3114), further preferably represents the group represented by formula (3102), (3103), (3107), (3108), (3110), (3111), (3113) or (3114), particularly preferably represents the group represented by formula (3103), (3107) or (3111), and most preferably the group represented by formula (3107) or (3111).

When the methine dye represented by formula (1) has as a substituent an acidic group such as a carboxyl group, a phosphoric group, a hydroxyl group and a sulfonic group, each group can form a salt and examples of the salt include a salt with an alkali metal such as lithium, sodium or potassium, or an alkali earth metal such as magnesium or calcium, or an organic base, for example, a quaternary ammonium salt such as tetramethyl ammonium, tetrabutyl ammonium, pyridinium, imidazolium, piperazinium or piperidinium.

The methine dye represented by formula (1) may have a structural isomer such as a cis-isomer, a trans-isomer or a racemic mixture, but is not particularly limited, and all such isomers and mixture can be favorably used as a photosensitizing dye in the present invention.

A preferable combination of m, l, n, j, k, X, Y, $Z_1$ to $Z_3$, $A_1$ to $A_{10}$ and $R_1$ to $R_2$ in formula (1) is a combination of those preferable in each of m, l, n, j, k, X, Y, $Z_1$ to $Z_3$, $A_1$ to $A_{10}$ and $R_1$ to $R_2$ above, and a more preferable combination is as follows.

That is, 1 and n denote 0, m and j denote 1 to 3, k denotes 0 to 2, $Z_1$, $Z_2$ and $Z_3$ each independently represent an oxygen atom, a sulfur atom, a selenium atom, an amino group, an N-methylamino group or an N-phenylamino group, $R_1$ and $R_2$ represent a group represented by any of formulae (3101) to (3119), X represents a group selected from the group consisting of a carboxyl group, a phosphoric group and a cyano group, Y represents any of a hydrogen atom, a cyano group, a carboxyl group, an acetyl group, a trifluoroacetyl group and a sulfonylbenzene group (provided that any one of X and Y represents a carboxyl group in this case), or one of X and Y represents the group represented by any of formula (1001) to (1033) and the other thereof represents a hydrogen atom or a cyano group, or X and Y form a ring, wherein the ring is a group selected from the group consisting of the groups represented by formulae (2001) to (2044), and $A_1$, $A_4$ and $A_7$ to $A_{10}$ each independently represent a hydrogen atom, a chlorine atom, a cyano group or an alkyl group having 1 to 36 carbon atoms.

A particularly preferable combination is as follows: m denotes 1 to 3,1 and n denote 0, j denotes 1 to 3, k denotes 0, $Z_1$ and $Z_2$ represent a sulfur atom, $R_1$ and $R_2$ each independently represent the group represented by formula (3103), (3107) or (3111), one of X and Y represents a carboxyl group and the other thereof represents a cyano group, or a ring formed by binding of X and Y is a group represented by formula (2007), and $A_1$, $A_4$ and $A_7$ to $A_8$ each independently represent a hydrogen atom, a chlorine atom, a cyano group or an alkyl group having 1 to 18 carbon atoms.

The most preferable combination is as follows: m denotes 1 to 3,1 and n denote 0, j denotes 1 to 3, k denotes 0, $Z_1$ and $Z_2$ represent a sulfur atom, $R_1$ represents the group represented by formula (3103) or (3107), $R_2$ represents the group represented by formula (3107) or (3111), one of X and Y represents a carboxyl group and the other thereof represents a cyano group, or a ring formed by binding X and Y is the group represented by formula (2007), $A_1$ and $A_4$ represent a hydrogen atom, and $A_7$ and $A_8$ represent a hydrogen atom.

As represented by formulae (1001) to (1017), (1019) and (1020), a counterion for neutralizing the positive charge of a nitrogen atom may be formed either intermolecularly or intramolecularly. Examples of a preferable counterion that is formed intermolecularly include respective anions of iodine, perchloric acid, bistrifluoromethylsulfonimide, tristrifluoromethylsulfonylmethane, hexafluoride antimonate, and tetrafluoroboric acid. Examples of a preferable counterion that is formed intramolecularly include respective anions of acetic acid-2-yl, propionic acid-3-yl, and sulfoethan-2-yl, which are bound to a nitrogen atom having a positive charge.

The methine dye represented by formula (1) can be produced by, for example, a reaction formula shown below, but the present invention is not limited to such a synthesis method. Compound (3) and Boronic acid (4) are reacted with

each other to produce Compound (5). Compound (5) is treated with N-iodosuccinimide to provide Compound (6). Then, Compound (6) and Boronic acid (7) are reacted with each other to be induced to Compound (8), and Compound (8) is further reacted with Boronic acids (9) to provide Carbonyl compound (10). Compound (10) and a compound having active methylene represented by formula (11) are if necessary condensed in the presence of a basic catalyst such as sodium hydroxide, sodium methylate, sodium acetate, diethylamine, triethylamine, piperidine, piperazine or diazabicycloundecene in a solvent, for example, alcohols such as methanol, ethanol, isopropanol and butanol, aprotic polar solvents such as dimethylformamide and N-methylpyrrolidone, toluene, acetic anhydride, and acetonitrile at 20°C to 180°C, preferably 50°C to 150°C to thereby provide the methine compound (dye) represented by formula (1). When Compound (11) having active methylene has an ester group in the reaction, it is also possible to obtain the corresponding carboxylic acid derivative by performing hydrolysis or the like after the condensation reaction.

[Formula 11]

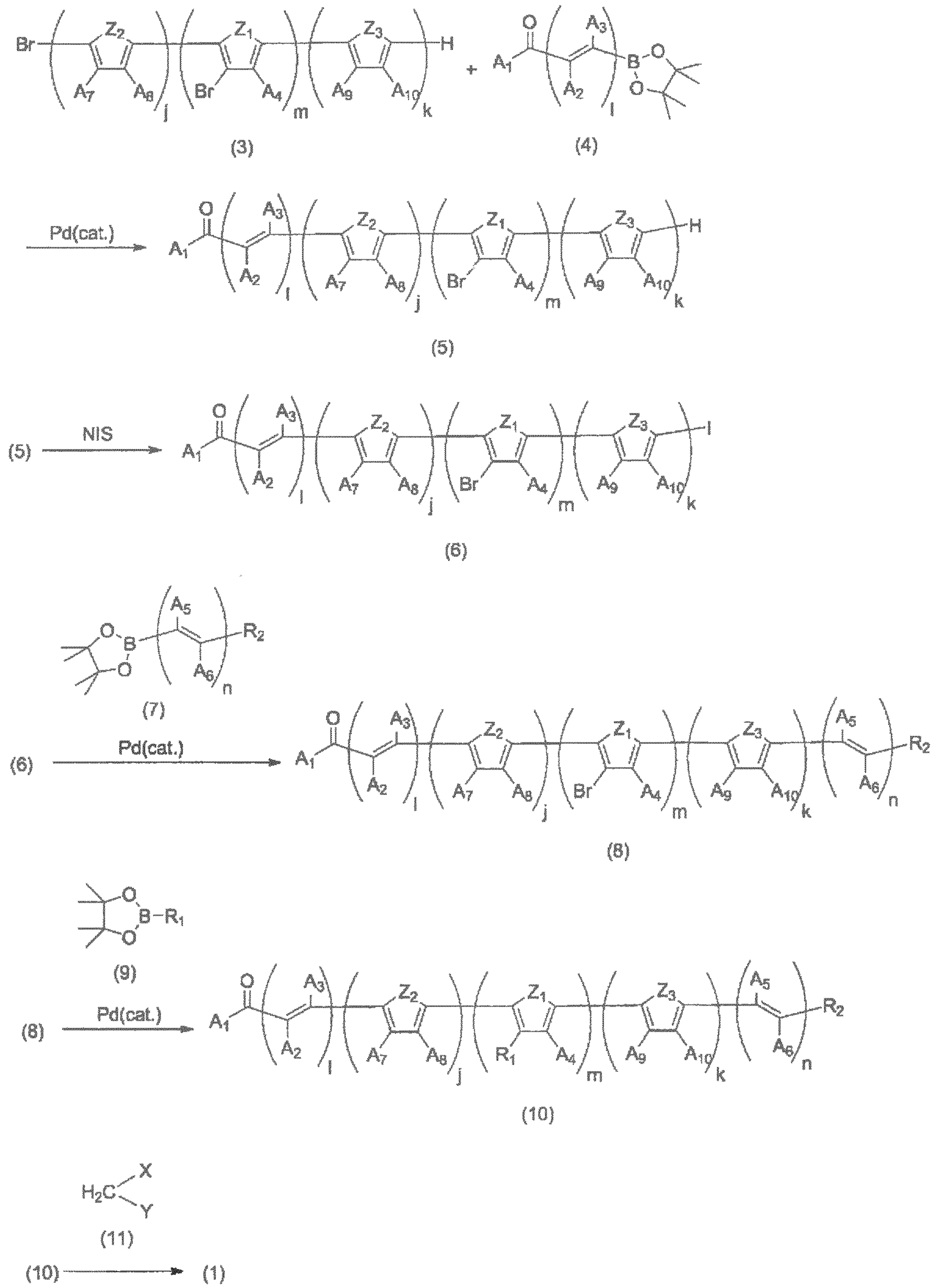


In addition, when the methine dye represented by formula (1) wherein l denotes 0 is adopted, the reaction of Compound (3) with Boronic acid (4) is not performed, and the following Compound (5') can be used instead of Compound (5) to perform the same synthesis.

[Formula 12]

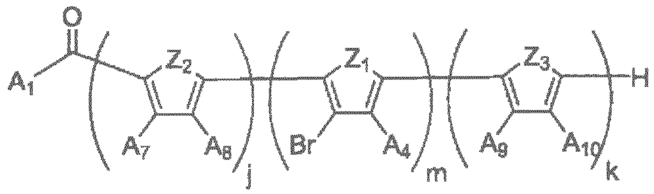

(5')

In addition, when the methine dye represented by formula (1) wherein n denotes 0 and $R_2$ represents a hydrogen atom or an aliphatic hydrocarbon residue is adopted, the following Compound (3') can be used instead of Compound (3) to synthesize Compound (5''), and such Compound (5'') can be used instead of Compound (8) to thereby synthesize the corresponding Compound (1).

[Formula 13]

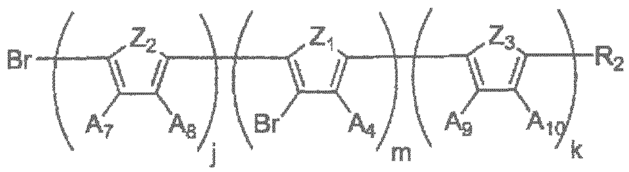

(3')

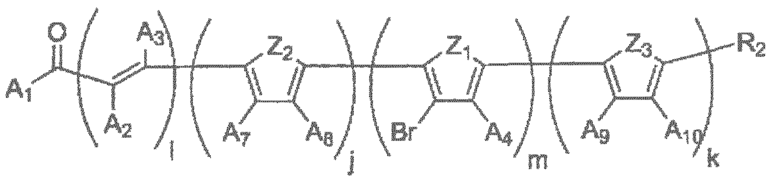

(5'')

Specific examples of a methine dye represented by formula (1-1) (methine dye in which j and k in formula (1) denote 0) are shown in Table 1 to Table 4. In each Table, Ph means a phenyl group. Those designated as (1001) to (1033) correspond to the above formulae (1001) to (1033), respectively. Those designated as (2001) to (2044) represent a ring formed by binding of X and Y, and correspond to the above formulae (2001) to (2044), respectively. In addition, those designated as (3101) to (3119) correspond to the above formulae (3101) to (3119), respectively

[Formula 14]

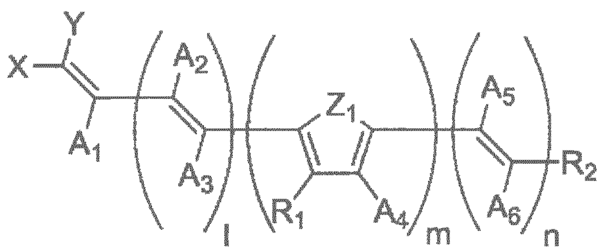

(1-1)

[Table 1]

Table 1. Specific examples of methine dye represented by formula (1-1)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 1 | 0 | 1 | 0 | COOH | CN | S | H | - | - | H | - | - | (3103) | (3111) |

(continued)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 2 | 0 | 1 | 0 | COOH | CN | S | $CH_3$ | - | - | H | - | - | (3103) | (3111) |
| 3 | 1 | 1 | 0 | COOH | CN | S | H | H | H | H | - | - | (3103) | (3111) |
| 4 | 1 | 1 | 0 | COOH | CN | S | H | $CH_3$ | H | H | - | - | (3103) | (3111) |
| 5 | 1 | 1 | 0 | COOH | CN | S | H | H | $CH_3$ | H | - | - | (3103) | (3111) |
| 6 | 1 | 1 | 0 | COOH | CN | S | H | $CH_3$ | $CH_3$ | H | - | - | (3103) | (3111) |
| 7 | 2 | 1 | 0 | COOH | CN | S | H | H | H | H | - | - | (3103) | (3111) |
| 8 | 2 | 1 | 0 | COOH | COOH | S | H | H | H | H | - | - | (3103) | (3111) |
| 9 | 2 | 1 | 0 | COOH | $COCH_3$ | S | H | H | H | H | - | - | (3103) | (3111) |
| 10 | 2 | 1 | 0 | COOH | $COCF_3$ | S | H | H | H | H | - | - | (3103) | (3111) |
| 11 | 2 | 1 | 0 | COOLi | CN | S | H | H | H | H | - | - | (3103) | (3111) |
| 12 | 2 | 1 | 0 | COONa | CN | S | H | H | H | H | - | - | (3103) | (3111) |
| 13 | 2 | 1 | 0 | COOK | CN | S | H | H | H | H | - | - | (3103) | (3111) |
| 14 | 2 | 1 | 0 | $PO(OH)_2$ | CN | S | H | H | H | H | - | - | (3103) | (3111) |
| 15 | 2 | 1 | 0 | CN | COOH | S | H | H | H | H | - | - | (3103) | (3111) |
| 16 | 2 | 1 | 0 | COOH | CN | 0 | H | H | H | H | - | - | (3103) | (3111) |
| 17 | 2 | 1 | 0 | COOH | CN | NH | H | H | H | H | - | - | (3103) | (3111) |
| 18 | 2 | 1 | 0 | COOH | CN | $MCH_3$ | H | H | H | H | - | - | (3103) | (3111) |
| 19 | 2 | 1 | 0 | COOH | CN | $NC_4H_9$ | H | H | H | H | - | - | (3103) | (3111) |
| 20 | 2 | 1 | 0 | COOH | CN | NPh | H | H | H | H | - | - | (3103) | (3111) |
| 21 | 2 | 1 | 0 | COOH | CN | S | $CH_3$ | H | H | H | - | - | (3103) | (3111) |
| 22 | 2 | 1 | 0 | COOH | CN | S | Cl | H | H | H | - | - | (3103) | (3111) |
| 23 | 2 | 1 | 0 | COOH | CN | S | H | H | H | $CH_3$ | - | - | (3103) | (3111) |
| 24 | 2 | 1 | 0 | COOH | CN | S | H | H | H | $C_4H_9$ | - | - | (3103) | (3111) |
| 25 | 2 | 1 | 0 | COOH | CN | S | H | H | H | $C_6H_{13}$ | - | - | (3103) | (3111) |
| 26 | 2 | 1 | 0 | COOH | CN | S | H | H | H | $C_8H_{17}$ | - | - | (3103) | (3111) |
| 27 | 2 | 1 | 0 | COOH | CN | S | H | H | $CH_3$ | H | - | - | (3103) | (3111) |
| 28 | 2 | 1 | 0 | COOH | CN | S | H | $CH_3$ | H | H | - | - | (3103) | (3111) |
| 29 | 2 | 1 | 0 | COOH | CN | S | H | $CH_3$ | $CH_3$ | H | - | - | (3103) | (3111) |
| 30 | 2 | 1 | 1 | COOH | CN | S | H | H | H | H | H | H | (3103) | (3111) |
| 31 | 2 | 1 | 1 | COOH | CN | S | H | H | H | H | $CH_3$ | $CH_3$ | (3103) | (3111) |
| 32 | 2 | 1 | 1 | COOH | CN | S | H | $CH_3$ | $CH_3$ | H | H | H | (3103) | (3111) |
| 33 | 2 | 1 | 1 | COOH | CN | S | H | $CH_3$ | $CH_3$ | H | $CH_3$ | $CH_3$ | (3103) | (3111) |
| 34 | 2 | 1 | 2 | COOH | CN | S | H | H | H | H | H | H | (3103) | (3111) |
| 35 | 2 | 1 | 2 | COOH | CN | S | H | H | H | H | $CH_3$ | $CH_3$ | (3103) | (3111) |
| 36 | 2 | 1 | 2 | COOH | CN | S | H | $CH_3$ | $CH_3$ | H | H | H | (3103) | (3111) |
| 37 | 2 | 1 | 2 | COOM | CN | S | H | $CH_3$ | $CH_3$ | H | $CH_3$ | $CH_3$ | (3103) | (3111) |
| 38 | 3 | 1 | 0 | COOH | CN | S | H | H | H | H | - | - | (3103) | (3111) |
| 39 | 3 | 1 | 0 | COOH | CN | S | H | $CH_3$ | $CH_3$ | H | - | - | (3103) | (3111) |

(continued)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 40 | 4 | 1 | 0 | COOH | CN | S | H | H | H | H | - | - | (3103) | (3111) |

[Table 2]

Table 2 Specific examples of methine dye represented by formula (1-1)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 41 | 4 | 1 | 0 | COOH | CN | S | H | $CH_3$ | $CH_3$ | H | - | - | (3103) | (3111) |
| 42 | 0 | 2 | 0 | COOH | CN | S | H | - | - | H | - | - | (3103) | (3111) |
| 43 | 1 | 2 | 0 | COOH | CN | S | H | H | H | H | - | - | (3103) | (3111) |
| 44 | 1 | 2 | 0 | COOH | CN | S | H | $CH_3$ | H | H | - | - | (3103) | (3111) |
| 46 | 1 | 2 | 0 | COOH | CN | S | H | H | $CH_3$ | H | - | - | (3103) | (3111) |
| 46 | 1 | 2 | 0 | COOH | CN | S | H | $CH_3$ | $CH_3$ | H | - | - | (3103) | (3111) |
| 47 | 2 | 2 | 0 | COOH | CN | S | H | H | H | H | - | - | (3103) | (3111) |
| 48 | 2 | 2 | 0 | COOH | CN | S | H | H | $CH_3$ | H | - | - | (3103) | (3111) |
| 49 | 2 | 2 | 0 | COOH | CN | S | H | $CH_3$ | H | H | - | - | (3103) | (3111) |
| 50 | 2 | 2 | 0 | COOH | CN | S | H | $CH_3$ | $CH_3$ | H | - | - | (3103) | (3111) |
| 51 | 0 | 3 | 0 | COOH | CN | S | H | - | - | H | - | - | (3103) | (3111) |
| 52 | 1 | 3 | 0 | COOH | CN | S | H | H | H | H | - | - | (3103) | (3111) |
| 53 | 1 | 3 | 0 | COOH | CN | S | H | $CH_3$ | H | H | - | - | (3103) | (3111) |
| 54 | 1 | 3 | 0 | COOH | CN | S | H | H | $CH_3$ | H | - | - | (3103) | (3111) |
| 55 | 1 | 3 | 0 | COOH | CN | S | H | $CH_3$ | $CH_3$ | H | - | - | (3103) | (3111) |
| 56 | 2 | 1 | 0 | (1001) | H | S | H | H | H | H | - | - | (3103) | (3111) |
| 57 | 2 | 1 | 0 | (1002) | H | S | H | H | H | H | - | - | (3103) | (3111) |
| 78 | 2 | 1 | 0 | (1003) | H | S | H | H | H | H | - | - | (3103) | (3111) |
| 59 | 2 | 1 | 0 | (1004) | H | S | H | H | H | H | - | - | (3103) | (3111) |
| 60 | 2 | 1 | 0 | (1005) | H | S | H | H | H | H | - | - | (3103) | (3111) |
| 61 | 2 | 1 | 0 | (1006) | H | s | H | H | H | H | - | - | (3103) | (3111) |
| 62 | 2 | 1 | 0 | (1007) | H | S | H | H | H | H | - | - | (3103) | (3111) |
| 63 | 2 | 1 | 0 | (1008) | H | S | H | H | H | H | - | - | (3103) | (3111) |
| 64 | 2 | 1 | 0 | (1009) | H | S | H | H | H | H | - | - | (3103) | (3111) |
| 65 | 2 | 1 | 0 | (1010) | H | S | H | H | H | H | - | - | (3103) | (3111) |
| 66 | 2 | 1 | 0 | (1011) | H | S | H | H | H | H | - | - | (3103) | (3111) |
| 67 | 2 | 1 | 0 | (1012) | H | S | H | H | H | H | - | - | (3103) | (3111) |
| 68 | 2 | 1 | 0 | (1013) | H | S | H | H | H | H | - | - | (3103) | (3111) |
| 69 | 2 | 1 | 0 | (1014) | H | S | H | H | H | H | - | - | (3103) | (3111) |
| 70 | 2 | 1 | 0 | (1015) | H | S | H | H | H | H | - | - | (3103) | (3111) |
| 71 | 2 | 1 | 0 | (1016) | H | S | H | H | H | H | - | - | (3103) | (3111) |
| 72 | 2 | 1 | 0 | (1017) | H | S | H | H | H | H | - | - | (3103) | (3111) |
| 73 | 2 | 1 | 0 | (1018) | H | S | H | H | H | H | - | - | (3103) | (3111) |

(continued)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 74 | 2 | 1 | 0 | (1019) | H | S | H | H | H | H | - | - | (3103) | (3111) |
| 75 | 2 | 1 | 0 | (1020) | H | S | H | H | H | H | - | - | (3103) | (3111) |
| 76 | 2 | 1 | 0 | (1021) | H | S | H | H | H | H | - | - | (3103) | (3111) |
| 77 | 2 | 1 | 0 | (1022) | H | S | H | H | H | H | - | - | (3103) | (3111) |
| 78 | 2 | 1 | 0 | (1023) | H | S | H | H | H | H | - | - | (3103) | (3111) |
| 79 | 2 | 1 | 0 | (1024) | H | S | H | H | H | H | - | - | (3103) | (3111) |
| 80 | 2 | 1 | 0 | (1025) | H | S | H | H | H | H | - | - | (3103) | (3111) |

[Table 3]

Table 3 Specific examples of methine dye represented by formulae (1-1)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 81 | 2 | 1 | 0 | (1026) | H | S | H | H | H | H | - | - | (3103) | (3111) |
| 82 | 2 | 1 | 0 | (1027) | H | S | H | H | H | H | - | - | (3103) | (3111) |
| 83 | 2 | 1 | 0 | (1028) | H | S | H | H | H | H | - | - | (3103) | (3111) |
| 84 | 2 | 1 | 0 | (1029) | H | S | H | H | H | H | - | - | (3103) | (3111) |
| 85 | 2 | 1 | 0 | (1030) | H | S | H | H | H | H | - | - | (3103) | (3111) |
| 86 | 2 | 1 | 0 | (1031) | H | S | H | H | H | H | - | - | (3103) | (3111) |
| 87 | 2 | 1 | 0 | (1032) | H | S | H | H | H | H | - | - | (3103) | (3111) |
| 88 | 2 | 1 | 0 | (1033) | H | S | H | H | H | H | - | - | (3103) | (3111) |
| 89 | 2 | 1 | 0 | (2001) | | S | H | H | H | H | - | - | (3103) | (3111) |
| 90 | 2 | 1 | 0 | (2002) | | S | H | H | H | H | - | - | (3103) | (3111) |
| 91 | 2 | 1 | 0 | (2003) | | S | H | H | H | H | - | - | (3103) | (3111) |
| 92 | 2 | 1 | 0 | (2004) | | S | H | H | H | H | - | - | (3103) | (3111) |
| 93 | 2 | 1 | 0 | (2005) | | S | H | H | H | H | - | - | (3103) | (3111) |
| 94 | 2 | 1 | 0 | (2006) | | S | H | H | H | H | - | - | (3103) | (3111) |
| 95 | 2 | 1 | 0 | (2007) | | S | H | H | H | H | - | - | (3103) | (3111) |
| 96 | 2 | 1 | 0 | (2008) | | S | H | H | H | H | - | - | (3103) | (3111) |
| 97 | 2 | 1 | 0 | (2009) | | S | H | H | H | H | - | - | (3103) | (3111) |
| 98 | 2 | 1 | 0 | (2010) | | S | H | H | H | H | - | - | (3103) | (3111) |
| 99 | 2 | 1 | 0 | (2011) | | S | H | H | H | H | - | | (3103) | (3111) |
| 100 | 2 | 1 | 0 | (2012) | | S | H | H | H | H | - | - | (3103) | (3111) |
| 101 | 2 | 1 | 0 | (2013) | | S | H | H | H | H | - | - | (3103) | (3111) |
| 102 | 2 | 1 | 0 | (2014) | | S | H | H | H | H | - | - | (3103) | (3111) |
| 103 | 2 | 1 | 0 | (2015) | | S | H | H | H | H | - | - | (3103) | (3111) |
| 104 | 2 | 1 | 0 | (2016) | | S | H | H | H | H | - | - | (3103) | (3111) |
| 105 | 2 | 1 | 0 | (2017) | | S | H | H | H | H | - | - | (3103) | (3111) |
| 106 | 2 | 1 | 0 | (2018) | | S | H | H | H | H | - | - | (3103) | (3111) |
| 107 | 2 | 1 | 0 | (2019) | | S | H | H | H | H | - | - | (3103) | (3111) |

(continued)

| Compound | l | m | n | X | Y | $Z_1$ | $A_1$ | $A_2$ | $A_3$ | $A_4$ | $A_5$ | $A_6$ | $R_1$ | $R_2$ |
|---|---|---|---|---|---|---|---|---|---|---|---|---|---|---|
| 108 | 2 | 1 | 0 | (2020) | | S | H | H | H | H | - | - | (3103) | (3111) |
| 109 | 2 | 1 | 0 | (2021) | | S | H | H | H | H | - | - | (3103) | (3111) |
| 110 | 2 | 1 | 0 | (2022) | | S | H | H | H | H | - | - | (3103) | (3111) |
| 111 | 2 | 1 | 0 | (2023) | | S | H | H | H | H | - | - | (3103) | (3111) |
| 112 | 2 | 1 | 0 | (2024) | | S | H | H | H | H | - | - | (3103) | (3111) |
| 113 | 2 | 1 | 0 | (2025) | | S | H | H | H | H | - | - | (3103) | (3111) |
| 114 | 2 | 1 | 0 | (2026) | | S | H | H | H | H | | - | (3103) | (3111) |
| 115 | 2 | 1 | 0 | (2027) | | S | H | H | H | H | - | - | (3103) | (3111) |
| 116 | 2 | 1 | 0 | (2028) | | S | H | H | H | H | - | - | (3103) | (3111) |
| 117 | 2 | 1 | 0 | (2029) | | S | H | H | H | H | - | - | (3103) | (3111) |
| 118 | 2 | 1 | 0 | (2030) | | S | H | H | H | H | - | - | (3103) | (3111) |
| 119 | 2 | 1 | 0 | (2031) | | S | H | H | H | H | - | - | (3103) | (3111) |
| 120 | 2 | 1 | 0 | (2032) | | S | H | H | H | H | - | - | (3103) | (3111) |

[Table 4]

Table 4 Specific examples of methine dye represented by formula (1-1)

| Compound | l | m | n | X | Y | $Z_1$ | $A_1$ | $A_2$ | $A_3$ | $A_4$ | $A_5$ | $A_5$ | $R_1$ | $R_2$ |
|---|---|---|---|---|---|---|---|---|---|---|---|---|---|---|
| 121 | 2 | 1 | 0 | (2033) | | S | H | H | H | H | - | - | (3103) | (3112) |
| 122 | 2 | 1 | 0 | (2034) | | S | H | H | H | H | - | - | (3103) | (3112) |
| 123 | 2 | 1 | 0 | (2035) | | S | H | H | H | H | - | - | (3103) | (3112) |
| 124 | 2 | 1 | 0 | (2036) | | S | H | H | H | H | - | - | (3103) | (3112) |
| 125 | 2 | 1 | 0 | (2037) | | S | H | H | H | H | - | - | (3103) | (3112) |
| 126 | 2 | 1 | 0 | (2038) | | S | H | H | H | H | - | - | (3103) | (3112) |
| 127 | 2 | 1 | 0 | (2039) | | S | H | H | H | H | - | - | (3103) | (3112) |
| 128 | 2 | 1 | 0 | (2040) | | S | H | H | H | H | - | - | (3103) | (3112) |
| 129 | 2 | 1 | 0 | (2041) | | S | H | H | H | H | - | - | (3103) | (3112) |
| 130 | 2 | 1 | 0 | (2042) | | S | H | H | H | H | - | - | (3103) | (3112) |
| 131 | 2 | 1 | 0 | (2043) | | S | H | H | H | H | - | - | (3103) | (3112) |
| 132 | 2 | 1 | 0 | (2044) | | S | H | H | H | H | - | - | (3103) | (3112) |
| 133 | 2 | 1 | 0 | (2007) | | S | H | H | $CH_3$ | H | - | - | (3103) | (3112) |
| 134 | 2 | 1 | 0 | (2007) | | S | H | $CH_3$ | H | H | - | - | (3103) | (3112) |
| 135 | 2 | 1 | 0 | (2007) | | S | H | $CH_3$ | $CH_3$ | H | - | - | (3103) | (3112) |
| 136 | 3 | 1 | 0 | (2007) | | S | H | H | H | H | - | - | (3103) | (3112) |
| 137 | 3 | 1 | 0 | (2007) | | S | H | $CH_3$ | $CH_3$ | H | - | - | (3103) | (3112) |
| 138 | 4 | 1 | 0 | (2007) | | S | H | H | H | H | - | - | (3103) | (3112) |
| 139 | 4 | 1 | 0 | (2007) | | S | H | $CH_3$ | $CH_3$ | H | - | - | (3103) | (3112) |
| 140 | 0 | 1 | 0 | (2007) | | S | H | - | - | H | - | - | (3103) | (3112) |
| 141 | 0 | 2 | 0 | (2007) | | S | H | - | - | H | - | - | (3103) | (3112) |

(continued)

| Compound | l | m | n | X | Y | $Z_1$ | $A_1$ | $A_2$ | $A_3$ | $A_4$ | $A_5$ | $A_5$ | $R_1$ | $R_2$ |
|---|---|---|---|---|---|---|---|---|---|---|---|---|---|---|
| 142 | 1 | 1 | 0 | (2007) | | S | H | H | H | H | - | - | (3103) | (3112) |
| 143 | 1 | 2 | 0 | (2007) | | S | H | H | H | H | - | - | (3103) | (3112) |
| 144 | 1 | 2 | 0 | (2007) | | S | H | $CH_3$ | H | H | - | - | (3103) | (3112) |
| 145 | 1 | 2 | 0 | (2007) | | S | H | H | $CH_3$ | H | - | - | (3103) | (3112) |
| 146 | 1 | 2 | 0 | (2007) | | S | H | $CH_3$ | $CH_3$ | H | - | - | (3103) | (3112) |
| 147 | 2 | 1 | 1 | (2007) | | S | H | H | H | H | H | H | (3103) | (3112) |
| 148 | 2 | 1 | 1 | (2007) | | S | H | H | H | H | $CH_3$ | $CH_3$ | (3103) | (3112) |
| 149 | 2 | 1 | 1 | (2007) | | S | H | $CH_3$ | $CH_3$ | H | H | H | (3103) | (3112) |
| 150 | 2 | 1 | 1 | (2007) | | S | H | $CH_3$ | $CH_3$ | H | $CH_3$ | $CH_3$ | (3103) | (3112) |
| 151 | 2 | 1 | 2 | (2007) | | S | H | H | H | H | H | H | (3103) | (3112) |
| 152 | 2 | 1 | 2 | (2007) | | S | H | H | H | H | $CH_3$ | $CH_3$ | (3103) | (3112) |
| 153 | 2 | 1 | 2 | (2007) | | S | H | $CH_3$ | $CH_3$ | H | H | H | (3103) | (3112) |
| 154 | 2 | 1 | 2 | (2007) | | S | H | $CH_3$ | $CH_3$ | H | $CH_3$ | $CH_3$ | (3103) | (3112) |
| 155 | 2 | 2 | 0 | (2007) | | S | H | H | H | H | - | - | (3103) | (3112) |
| 156 | 2 | 2 | 0 | (2007) | | S | H | H | $CH_3$ | H | - | - | (3103) | (3112) |
| 157 | 2 | 2 | 0 | (2007) | | S | H | $CH_3$ | H | H | - | - | (3103) | (3112) |
| 158 | 2 | 2 | 0 | (2007) | | S | H | $CH_3$ | $CH_3$ | H | - | - | (3103) | (3112) |

Specific examples of a methine dye represented by the following formula (1-2) (methine dye in which 1 and n in formula (1) denote 0) are shown in Table 5 to Table 10. In each Table, Ph means a phenyl group. Substituents designated as (1001) to (1033) correspond to the above formulae (1001) to (1033), respectively. Substituents designated as (2001) to (2044) represent a ring formed by binding of X and Y, and correspond to the above formulae (2001) to (2044), respectively. In addition, substituents designated as (3101) to (3119) correspond to the above formulae (3101) to (3119), respectively.

[Formula 15]

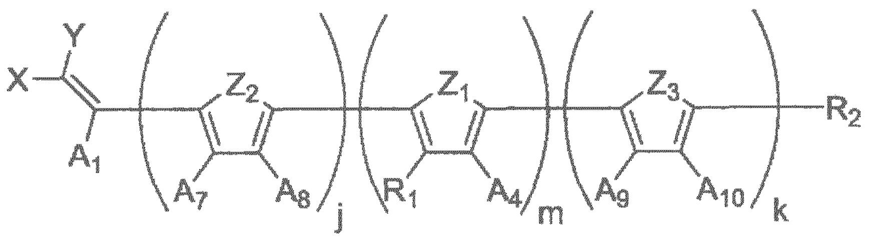

(1-2)

[Table 5]

Table 5 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 159 | 0 | 1 | 0 | COOH | CN | S | - | - | H | - | - | H | - | - | (3103) | (3111) |
| 160 | 0 | 1 | 0 | COOH | COOH | S | - | - | H | - | - | H | - | - | (3103) | (3111) |
| 161 | 0 | 1 | 0 | COOH | $COCH_9$ | S | - | - | H | - | - | - H | - | - | (3103) | (3111) |
| 162 | 0 | 1 | 0 | COOH | $COCF_3$ | S | - | - | H | - | - | H | - | - | (3103) | (3111) |
| 163 | 0 | 1 | 0 | COOLi | CN | S | - | - | H | - | - | H | - | - | (3103) | (3111) |
| 164 | 0 | 1 | 0 | COONa | CN | S | - | - | H | - | - | H | - | - | (3103) | (3111) |
| 165 | 0 | 1 | 0 | COOK | CN | S | - | - | H | - | - | H | - | - | (3103) | (3111) |
| 166 | 0 | 1 | 0 | $PO(OH)_2$ | CN | S | - | - | H | - | - | H | - | - | (3103) | (3111) |
| 167 | 0 | 1 | 0 | CN | COOH | S | - | - | H | - | - | H | - | - | (3103) | (3111) |
| 168 | 0 | 1 | 0 | COOH | CN | 0 | - | - | H | - | - | H | - | - | (3103) | (3111) |
| 169 | 0 | 1 | 0 | COOH | CN | NH | - | - | H | - | - | H | - | - | (3103) | (3111) |
| 170 | 0 | 1 | 0 | COOH | CN | $NCH_3$ | - | - | H | - | - | H | - | - | (3103) | (3111) |
| 171 | 0 | 1 | 0 | COOH | CN | $NC_4H_9$ | - | - | H | - | - | H | - | - | (3103) | (3111) |
| 172 | 0 | 1 | 0 | COOH | CN | NPh | - | - | H | - | - | H | - | - | (3103) | (3111) |
| 173 | 0 | 1 | 0 | COOH | CN | S | - | - | $CH_3$ | - | - | H | - | - | (3103) | (3111) |
| 174 | 0 | 1 | 0 | COOH | CN | S | - | - | Cl | - | - | H | - | - | (3103) | (1111) |
| 175 | 0 | 1 | 0 | COOH | CN | s | - | - | H | - | - | $CH_3$ | - | - | (3103) | (3111) |
| 176 | 0 | 1 | 0 | COOH | CN | S | - | - | H | - | - | $C_4H_9$ | - | - | (3103) | (3111) |
| 177 | 0 | 1 | 0 | COOH | CN | S | - | - | H | - | - | $C_6H_{13}$ | - | - | (3103) | (3111) |
| 178 | 0 | 1 | 0 | COOH | CN | S | - | - | H | - | - | $C_8H_{17}$ | - | - | (3103) | (3111) |
| 179 | 1 | 1 | 0 | COOH | CN | S | S | - | H | H | H | H | - | - | (3103) | (3107) |
| 180 | 1 | 1 | 0 | COOH | CN | S | S | - | H | H | H | H | - | - | (3103) | (3111) |
| 181 | 1 | 1 | 0 | COOH | CN | S | S | - | H | $CH_3$ | H | H | - | - | (3103) | (3111) |
| 182 | 1 | 1 | 0 | COOH | CN | S | S | - | H | H | $CH_3$ | H | - | - | (3103) | (3111) |
| 183 | 1 | 1 | 0 | COOH | CN | S | s | - | H | $CH_3$ | $CH_3$ | H | - | - | (3103) | (3111) |

(continued)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 184 | 2 | 1 | 0 | COOH | CN | S | S | - | H | H | H | H | - | - | (3101) | (3012) |
| 185 | 2 | 1 | 0 | COOH | CN | S | S | - | H | H | H | H | - | - | (3102) | (3012) |
| 186 | 2 | 1 | 0 | COOH | CN | S | S | - | H | H | H | H | - | - | (3103) | (3107) |
| 187 | 2 | 1 | 0 | COOH | CN | S | S | - | H | H | H | H | - | - | (3103) | (3108) |
| 188 | 2 | 1 | 0 | COOH | CN | S | S | - | H | H | H | H | - | - | (3103) | (3109) |
| 189 | 2 | 1 | 0 | COOH | CN | S | S | - | H | H | H | H | - | - | (3103) | (3110) |
| 190 | 2 | 1 | 0 | COOH | CN | S | S | - | H | H | H | H | - | - | (3103) | (3111) |
| 191 | 2 | 1 | 0 | COOH | CN | S | S | - | H | H | - | H | - | - | (3103) | (3112) |
| 192 | 2 | 1 | 0 | COOH | CN | S | S | - | H | H | H | H | - | - | (3103) | (3113) |
| 193 | 2 | 1 | 0 | COOH | CN | S | S | - | H | H | - | H | - | - | (3103) | (3114) |
| 194 | 2 | 1 | 0 | COOH | CN | S | S | - | H | H | - | H | - | - | (3103) | (3115) |
| 195 | 2 | 1 | 0 | COOH | CN | S | S | - | H | H | H | H | - | - | (3103) | (3119) |
| 200 | 2 | 1 | 0 | COOH | CN | S | S | - | H | H | H | H | - | - | (3108) | (3111) |

[Table 6]

Table 6 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 201 | 2 | 1 | 0 | COOH | CN | S | S | - | H | H | H | H | - | - | (3109) | (3111) |
| 202 | 2 | 1 | 0 | COOH | CN | S | S | - | H | H | H | H | - | - | (3110) | (3111) |
| 203 | 2 | 1 | 0 | COOH | CN | S | S | - | H | H | H | H | - | - | (3111) | (3111) |
| 204 | 2 | 1 | 0 | COOH | CN | S | S | - | H | H | H | H | - | - | (3112) | (3111) |
| 205 | 2 | 1 | 0 | COOH | CN | S | S | - | H | H | H | H | - | - | (3113) | (3111) |
| 206 | 2 | 1 | 0 | COOH | CN | S | S | - | H | H | H | H | - | - | (3114) | (3111) |
| 207 | 2 | 1 | 0 | COOH | CN | S | S | - | H | H | H | H | - | - | (3115) | (3111) |
| 211 | 2 | 1 | 0 | COOH | CN | S | S | - | H | H | H | H | - | - | (3119) | (3111) |
| 215 | 2 | 1 | 0 | COOH | CN | S | S | - | H | H | $CH_3$ | H | - | - | (3103) | (3111) |
| 126 | 2 | 1 | 0 | COOH | CN | S | S | - | H | $CH_3$ | H | H | - | - | (3103) | (3111) |
| 217 | 2 | 1 | 0 | COOH | CN | S | S | - | H | $CH_3$ | $CH_3$ | H | - | - | (3103) | (3111) |
| 218 | 2 | 1 | 0 | COOH | CN | S | s | - | H | H | H | H | - | - | (3103) | (3111) |
| 219 | 2 | 1 | 0 | COOH | CN | S | S | - | H | $CH_3$ | $CH_3$ | H | - | - | (3103) | (3111) |
| 220 | 2 | 1 | 0 | COOH | CN | S | - | S | H | - | - | H | H | H | (3103) | (3111) |
| 221 | 2 | 1 | 0 | COOH | CN | S | - | S | H | - | - | H | $CH_3$ | $CH_3$ | (3103) | (3111) |
| 222 | 2 | 1 | 0 | COOH | CN | S | - | S | H | - | - | H | H | H | (3103) | (3111) |
| 223 | 2 | 1 | 0 | COOH | CN | S | - | S | H | - | - | H | $CH_3$ | $CH_3$ | (3103) | (3111) |
| 224 | 2 | 1 | 0 | COOH | CN | S | - | - | H | - | - | H | - | - | (3103) | (3111) |
| 225 | 2 | 1 | 0 | COOH | CN | S | S | - | H | H | H | H | - | - | (3103) | (3111) |
| 226 | 2 | 1 | 0 | COOH | CN | S | S | - | H | $CH_3$ | H | H | - | - | (3103) | (3111) |
| 227 | 3 | 1 | 0 | COOH | CN | S | S | - | H | H | $CH_3$ | H | - | - | (3103) | (3111) |
| 228 | 3 | 1 | 0 | COOH | CN | S | S | - | H | $CH_3$ | $CH_3$ | H | - | - | (3103) | (3111) |
| 229 | 0 | 1 | 1 | COOH | CN | S | S | - | H | H | H | H | - | - | (3103) | (3111) |
| 230 | 0 | 1 | 1 | COOH | CN | S | S | - | H | H | $CH_3$ | H | - | - | (3103) | (3111) |
| 231 | 0 | 1 | 2 | COOH | CN | S | S | - | H | $CH_3$ | $CH_3$ | H | - | - | (3103) | (3111) |
| 232 | 0 | 1 | 2 | COOH | CN | S | S | - | H | $CH_3$ | $CH_3$ | H | - | - | (3103) | (3111) |
| 233 | 0 | 2 | 0 | COOH | CN | S | - | - | H | - | - | H | - | - | (3103) | (3111) |
| 234 | 1 | 2 | 0 | COOH | CN | S | S |  | H | H | H | H | - | - | (3103) | (3111) |
| 235 | 1 | 2 | 0 | COOH | CN | S | S | - | H | $CH_3$ | H | H | - | - | (3103) | (3111) |
| 236 | 1 | 2 | 0 | COOH | CN | S | S | - | H | H | $CH_3$ | H | - | - | (3103) | (3111) |
| 237 | 1 | 2 | 0 | COOH | CN | S | S | - | H | $CH_3$ | $CH_3$ | H | - | - | (3103) | (3111) |
| 238 | 2 | 2 | 0 | (1001) | H | S | - | - | H | - | - | H | - | - | (3103) | (3111) |
| 239 | 2 | 2 | 0 | (1002) | H | S | - | - | H | - | - | H | - | - | (3103) | (3111) |
| 240 | 2 | 2 | 0 | (1003) | H | S | - | - | H | - | - | H | - | - | (3103) | (3111) |
| 241 | 2 | 2 | 0 | (1004) | H | S | - | - | H | - | - | H | - | - | (3103) | (3111) |
| 242 | 0 | 3 | 0 | (1005) | H | S | - | - | H | - | - | H | - | - | (3103) | (3111) |

[Table 7]

Table 7 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 243 | 1 | 3 | 0 | (1006) | H | S | - | - | H | - | - | H | - | - | (3103) | (3111) |
| 244 | 1 | 3 | 0 | (1007) | H | S | - | - | H | - | - | H | - | - | (3103) | (3111) |
| 245 | 1 | 3 | 0 | (1008) | H | S | - | - | H | - | - | H | - | - | (3103) | (3111) |
| 246 | 1 | 3 | 0 | (1009) | H | S | - | - | H | - | - | H | - | - | (3103) | (3111) |
| 247 | 0 | 1 | 0 | (1010) | H | S | - | - | H | - | - | H | - | - | (3103) | (3111) |
| 248 | 0 | 1 | 0 | (1011) | H | S | - | - | H | - | - | H | - | - | (3103) | (3111) |
| 249 | 0 | 1 | 0 | (1012) | H | S | - | - | H | - | - | H | - | - | (3103) | (3111) |
| 250 | 0 | 1 | 0 | (1013) | H | S | - | - | H | - | - | H | - | - | (3103) | (3111) |
| 251 | 0 | 1 | 0 | (1014) | H | S | - | - | H | - | - | H | - | - | (3103) | (3111) |
| 252 | 0 | 1 | 0 | (1015) | H | S | - | - | H | - | - | H | - | - | (3103) | (3111) |
| 253 | 0 | 1 | 0 | (1016) | H | S | - | - | H | - | - | H | - | - | (3103) | (3111) |
| 254 | 0 | 1 | 0 | (1017) | H | S | - | - | H | - | - | H | - | - | (3103) | (3111) |
| 255 | 0 | 1 | 0 | (1018) | H | S | - | - | H | - | - | H | - | - | (3103) | (3111) |
| 256 | 0 | 1 | 0 | (1019) | H | S | - | - | H | - | - | H | - | - | (3103) | (3111) |
| 257 | 0 | 1 | 0 | (1020) | H | S | - | - | H | - | - | H | - | - | (3103) | (3111) |
| 258 | 0 | 1 | 0 | (1021) | H | S | - | - | H | - | - | H |  | - | (3103) | (3111) |
| 259 | 0 | 1 | 0 | (1022) | H | S | - | - | H | - | - | H | - | - | (3103) | (3111) |
| 260 | 0 | 1 | 0 | (1023) | H | S | - | - | H | - | - | H | - | - | (3103) | (3111) |
| 261 | 0 | 1 | 0 | (1024) | H | S | - | - | H | - | - | H | - | - | (3103) | (3111) |
| 262 | 0 | 1 | 0 | (1025) | H | S | - | - | H | - | - | H | - | - | (3103) | (3111) |
| 263 | 0 | 1 | 0 | (1026) | H | S | - | - | H | - | - | H | - | - | (3103) | (3111) |
| 264 | 0 | 1 | 0 | (1027) | H | S | - | - | H | - | - | H | - | - | (3103) | (3111) |
| 265 | 0 | 1 | 0 | (1028) | H | S | - | - | H | - | - | H | - | - | (3103) | (3111) |
| 266 | 0 | 1 | 0 | (1029) | H | S | - | - | H | - | - | H | - | - | (3103) | (3111) |
| 267 | 0 | 1 | 0 | (1030) | H | S | - | - | H | - | - | H | - | - | (3103) | (3111) |
| 268 | 0 | 1 | 0 | (1031) | H | S | - | - | H | - | - | H | - | - | (3103) | (3111) |
| 269 | 0 | 1 | 0 | (1032) | H | S | - | - | H | - | - | H | - | - | (3103) | (3111) |
| 270 | 0 | 1 | 0 | (1033) | H | S | - | - | H | - | - | H | - | - | (3103) | (3111) |
| 271 | 0 | 1 | 0 | (2001) |  | S | - | - | H | - | - | H | - | - | (3103) | (3111) |
| 272 | 0 | 1 | 0 | (2002) |  | S | - | - | H | - | - | H | - | - | (3103) | (3111) |
| 273 | 0 | 1 | 0 | (2003) |  | S | - | - | H | - | - | H | - | - | (3103) | (3111) |
| 274 | 0 | 1 | 0 | (2004) |  | S | - | - | H | - | - | H | - | - | (3103) | (3111) |
| 275 | 0 | 1 | 0 | (2006) |  | S | - | - | H | - | - | H | - | - | (3103) | (3111) |
| 276 | 0 | 1 | 0 | (2006) |  | S | - | - | H | - | - | H | - | - | (3103) | (3111) |
| 277 | 0 | 1 | 0 | (2007) |  | S | - | - | H | - | - | H | - | - | (3103) | (3111) |
| 278 | 0 | 1 | 0 | (2008) |  | S | - | - | H | - | - | H | - | - | (3103) | (3111) |
| 279 | 0 | 1 | 0 | (2009) |  | S | - | - | H | - | - | H | - | - | (3103) | (3111) |

(continued)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 280 | 0 | 1 | 0 | (2010) | | S | - | - | H | - | - | H | - | - | (3103) | (3111) |
| 281 | 0 | 1 | 0 | (2011) | | S | - | - | H | - | - | H | - | - | (3103) | (3111) |
| 282 | 0 | 1 | 0 | (2012) | | S | - | - | H | - | - | H | - | - | (3103) | (3111) |
| 283 | 0 | 1 | 0 | (2013) | | S | - | - | H | - | - | H | - | - | (3103) | (3111) |
| 284 | 0 | 1 | 0 | (2014) | | S | - | - | H | - | - | H | - | - | (3103) | (3111) |

[Table 8]

Table 8 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 285 | 0 | 1 | 0 | (2015) | | S | - | - | H | - | - | H | - | - | (3103) | (3111) |
| 286 | 0 | 1 | 0 | (2016) | | S | - | - | H | - | - | - | - | - | (3103) | (3111) |
| 287 | 0 | 1 | 0 | (2017) | | S | - | - | H | - | - | H | - | - | (3103) | (3111) |
| 288 | 0 | 1 | 0 | (2018) | | S | - | - | H | - | - | H | - | - | (3103) | (3111) |
| 289 | 0 | 1 | 0 | (2019) | | S | - | - | H | - | - | H | - | - | (3103) | (3111) |
| 290 | 0 | 1 | 0 | (2020) | | S | - | - | H | - | - | H | - | - | (3103) | (3111) |
| 291 | 0 | 1 | 0 | (2021) | | S | - | - | H | - | - | H | - | - | (3103) | (3111) |
| 292 | 0 | 1 | 0 | (2022) | | S | - | - | H | - | - | H | - | - | (3103) | (3111) |
| 293 | 0 | 1 | 0 | (2023) | | S | - | - | H | - | - | H | - | - | (3103) | (3111) |
| 294 | 0 | 1 | 0 | (2024) | | S | - | - | H | - | - | H | - | - | (3103) | (3111) |
| 295 | 0 | 1 | 0 | (2026) | | S | - | - | H | - | - | H | - | - | (3103) | (3111) |
| 296 | 0 | 1 | 0 | (2026) | | S | - | - | H | - | - | H | - | - | (3103) | (3111) |
| 297 | 0 | 1 | 0 | (2027) | | S | - | - | H | - | - | H | - | - | (3103) | (3111) |
| 298 | 0 | 1 | 0 | (2028) | | S | - | - | H | - | - | H | - | - | (3103) | (3111) |
| 299 | 0 | 1 | 0 | (2029) | | S | - | - | H | - | - | H | - | - | (3103) | (3111) |
| 300 | 0 | 1 | 0 | (2030) | | S | | | H | - | - | H | - | - | (3103) | (3111) |
| 301 | 0 | 1 | 0 | (2031) | | S | - | - | H | - | - | H | - | - | (3103) | (3111) |
| 302 | 0 | 1 | 0 | (2032) | | S | - | - | H | - | - | H | - | - | (3103) | (3111) |
| 303 | 0 | 1 | 0 | (2033) | | S | - | - | H | - | - | H | - | - | (3103) | (3111) |
| 304 | 0 | 1 | 0 | (2034) | | S | - | - | H | - | - | H | - | - | (3103) | (3111) |
| 305 | 0 | 1 | 0 | (2035) | | S | - | - | H | - | - | H | - | - | (3103) | (3111) |
| 306 | 0 | 1 | 0 | (2036) | | S | - | - | H | - | - | H | - | - | (3103) | (3111) |
| 307 | 0 | 1 | 0 | (2037) | | S | - | - | H | - | - | H | - | - | (3103) | (3111) |
| 308 | 0 | 1 | 0 | (2038) | | S | - | - | H | - | - | H | - | - | (3103) | (3111) |
| 309 | 0 | 1 | 0 | (2039) | | S | - | - | H | - | - | H | - | - | (3103) | (3111) |
| 310 | 0 | 1 | 0 | (2040) | | S | - | - | H | - | - | H | - | - | (3103) | (3111) |
| 311 | 0 | 1 | 0 | (2041) | | S | - | - | H | - | - | H | - | - | (3103) | (3111) |
| 312 | 0 | 1 | 0 | (2042) | | S | - | - | H | - | - | H | - | - | (3103) | (3111) |
| 313 | 0 | 1 | 0 | (2043) | | S | - | - | H | - | - | H | - | - | (3103) | (3111) |

(continued)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 314 | 0 | 1 | 0 | (2044) | | S | - | - | H | - | - | H | - | - | (3103) | (3111) |
| 315 | 0 | 1 | 0 | (1001) | H | S | S | - | H | H | - | H | - | - | (3103) | (3111) |
| 316 | 0 | 1 | 0 | (1002) | H | S | S | - | H | H | H | H | - | - | (3103) | (3111) |
| 317 | 0 | 1 | 0 | (1003) | H | S | S | - | H | H | H | H | - | - | (3103) | (3111) |
| 318 | 0 | 1 | 0 | (1004) | H | S | S | - | H | H | H | H | - | - | (3103) | (3111) |
| 319 | 0 | 1 | 0 | (1005) | H | S | S | - | H | H | H | H | - | - | (3103) | (3111) |
| 320 | 0 | 1 | 0 | (1006) | H | S | S | - | H | H | H | H | - | - | (3103) | (3111) |
| 321 | 0 | 1 | 0 | (1007) | H | S | S | - | H | H | H | H | - | - | (3103) | (3111) |
| 322 | 0 | 1 | 0 | (1008) | H | S | S | - | H | H | H | H | - | - | (3103) | (3111) |
| 323 | 0 | 1 | 0 | (1009) | H | S | S | - | H | H | H | H | - | - | (3103) | (3111) |
| 324 | 1 | 1 | 0 | (1010) | H | S | S | - | H | H | H | H | - | - | (3103) | (3111) |
| 325 | 1 | 1 | 0 | (1011) | H | S | S | - | H | H | H | H | - | - | (3103) | (3111) |
| 326 | 1 | 1 | 0 | (1012) | H | S | S | - | H | H | H | H | - | - | (3103) | (3111) |

[Table 9]

Table 9 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 327 | 1 | 1 | 0 | (1013) | H | S | S | - | H | H | H | H | - | - | (3103) | (3111) |
| 328 | 1 | 1 | 0 | (1014) | H | S | S | - | H | H | H | H | - | - | (3103) | (3111) |
| 329 | 1 | 1 | 0 | (1015) | H | S | S | - | H | H | H | H | - | - | (3103) | (3111) |
| 330 | 1 | 1 | 0 | (1016) | H | S | S | - | H | H | H | H | - | - | (3103) | (3111) |
| 331 | 1 | 1 | 0 | (1017) | H | S | S | - | H | H | H | H | - | - | (3103) | (3111) |
| 332 | 1 | 1 | 0 | (1018) | H | S | S | - | H | H | H | H | - | - | (3103) | (3111) |
| 333 | 1 | 1 | 0 | (1019) | H | S | S | - | H | H | H | H | - | - | (3103) | (3111) |
| 334 | 1 | 1 | 0 | (1020) | H | S | S | - | H | H | H | H | - | - | (3103) | (3111) |
| 335 | 1 | 1 | 0 | (1021) | H | S | S | - | H | H | H | H | - | - | (3103) | (3111) |
| 336 | 1 | 1 | 0 | (1022) | H | S | S | - | H | H | H | H | - | - | (3103) | (3111) |
| 337 | 1 | 1 | 0 | (1023) | H | S | S | - | H | H | H | H | - | - | (3103) | (3111) |
| 338 | 1 | 1 | 0 | (1024) | H | S | S | - | H | H | H | H | - | - | (3103) | (3111) |
| 339 | 1 | 1 | 0 | (1026) | H | S | S | - | H | H | H | H | - | - | (3103) | (3111) |
| 340 | 1 | 1 | 0 | (1026) | H | S | S | - | H | H | H | H | - | - | (3103) | (3111) |
| 341 | 1 | 1 | 0 | (1027) | H | S | S | - | H | H | H | H | - | - | (3103) | (3111) |
| 342 | 1 | 1 | 0 | (1028) | H | S | S | - | H | H | H | H | - | - | (3103) | (3111) |
| 343 | 1 | 1 | 0 | (1029) | H | S | S | - | H | H | H | H | - | - | (3103) | (3111) |
| 344 | 1 | 1 | 0 | (1030) | H | S | S | - | H | H | H | H | - | - | (3103) | (3111) |
| 345 | 1 | 1 | 0 | (1031) | H | S | S | - | H | H | H | H | - | - | (3103) | (3111) |
| 346 | 1 | 1 | 0 | (1032) | H | S | S | - | H | H | H | H | - | - | (3103) | (3111) |
| 347 | 1 | 1 | 0 | (1033) | H | S | S | - | H | H | H | H | - | - | (3103) | (3111) |

(continued)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 348 | 1 | 1 | 0 | (2001) | | S | S | - | H | H | H | H | - | - | (3103) | (3111) |
| 349 | 1 | 1 | 0 | (2002) | | S | S | - | H | H | H | H | - | - | (3103) | (3111) |
| 350 | 1 | 1 | 0 | (2003) | | S | S | - | H | H | H | H | - | - | (3103) | (3111) |
| 351 | 1 | 1 | 0 | (2004) | | S | S | - | H | H | H | H | - | - | (3103) | (3111) |
| 352 | 1 | 1 | 0 | (2005) | | S | S | - | H | H | H | H | - | - | (3103) | (3111) |
| 253 | 1 | 1 | 0 | (2006) | | S | S | - | H | H | H | H | - | - | (3103) | (3111) |
| 354 | 1 | 1 | 0 | (2007) | | S | S | - | H | H | H | H | - | - | (3103) | (3111) |
| 355 | 1 | 1 | 0 | (2008) | | S | S | - | H | H | H | H | - | - | (3103) | (3111) |
| 356 | 1 | 1 | 0 | (2009) | | S | S | - | H | H | H | H | - | - | (3103) | (3111) |
| 357 | 1 | 1 | 0 | (2010) | | S | S | - | H | H | H | H | - | - | (3103) | (3111) |
| 358 | 1 | 1 | 0 | (2011) | | S | S | - | H | H | H | H | - | - | (3103) | (3111) |
| 359 | 1 | 1 | 0 | (2012) | | S | S | - | H | H | H | H | - | - | (3103) | (3111) |
| 360 | 1 | 1 | 0 | (2013) | | S | S | - | H | H | H | H | - | - | (3103) | (3111) |
| 361 | 1 | 1 | 0 | (2014) | | S | S | - | H | H | H | H | - | - | (3103) | (3111) |
| 362 | 1 | 1 | 0 | (2015) | | S | S | - | H | H | H | H | - | - | (3103) | (3111) |
| 363 | 1 | 1 | 0 | (2016) | | S | S | - | H | H | H | H | - | - | (3103) | (3111) |
| 364 | 1 | 1 | 0 | (2017) | | S | S | - | H | H | H | H | - | - | (3103) | (3111) |
| 365 | 1 | 1 | 0 | (2018) | | S | S | - | H | H | H | H | - | - | (3103) | (3111) |
| 366 | 1 | 1 | 0 | (2019) | | S | S | - | H | H | H | H | - | - | (3103) | (3111) |
| 367 | 1 | 1 | 0 | (2020) | | S | S | - | H | H | H | H | - | - | (3103) | (3111) |
| 368 | 1 | 1 | 0 | (2021) | | S | S | - | H | H | H | H | - | - | (3103) | (3111) |

[Table 10]

Table 10 Specific examples of methine dye represented by formula (1-2)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 369 | 1 | 1 | 0 | (2022) | | S | S | - | H | H | H | H | - | - | (3103) | (3111) |
| 370 | 1 | 1 | 0 | (2023) | | S | S | - | H | H | H | H | - | - | (3103) | (3111) |
| 371 | 1 | 1 | 0 | (2024) | | S | S | - | H | H | H | H | - | - | (3103) | (3111) |
| 372 | 1 | 1 | 0 | (2025) | | S | S | - | H | H | H | H | - | - | (3103) | (3111) |
| 373 | 1 | 1 | 0 | (2026) | | S | S | - | H | H | H | H | - | - | (3103) | (3111) |
| 374 | 1 | 1 | 0 | (2027) | | S | S | - | H | H | H | H | - | - | (3103) | (3111) |
| 376 | 1 | 1 | 0 | (2028) | | S | S | - | H | H | H | H | - | - | (3103) | (3111) |
| 376 | 1 | 1 | 0 | (2029) | | S | S | - | H | H | H | H | - | - | (3103) | (3111) |
| 377 | 1 | 1 | 0 | (2030) | | S | S | - | H | H | H | H | - | - | (3103) | (3111) |
| 378 | 1 | 1 | 0 | (2031) | | S | S | - | H | H | H | H | - | - | (3103) | (3111) |
| 379 | 1 | 1 | 0 | (2032) | | S | S | - | H | H | H | H | - | - | (3103) | (3111) |
| 380 | 1 | 1 | 0 | (2033) | | S | S | - | H | H | H | H | - | - | (3103) | (3111) |
| 381 | 1 | 1 | 0 | (2034) | | S | S | - | H | H | H | H | - | - | (3103) | (3111) |

(continued)

| Compound | j | m | k | X | Y | $Z_1$ | $Z_2$ | $Z_3$ | $A_1$ | $A_7$ | $A_8$ | $A_4$ | $A_9$ | $A_{10}$ | $R_1$ | $R_2$ |
|---|---|---|---|---|---|---|---|---|---|---|---|---|---|---|---|---|
| 382 | 1 | 1 | 0 | (2035) | | S | S | - | H | H | H | H | - | - | (3103) | (3111) |
| 383 | 1 | 1 | 0 | (2036) | | S | S | - | H | H | H | H | - | - | (3103) | (3111) |
| 384 | 1 | 1 | 0 | (2037) | | S | S | - | H | H | H | H | - | - | (3103) | (3111) |
| 385 | 1 | 1 | 0 | (2038) | | S | S | - | H | H | H | H | - | - | (3103) | (3111) |
| 386 | 1 | 1 | 0 | (2039) | | S | S | - | H | H | H | H | - | - | (3103) | (3111) |
| 387 | 1 | 1 | 0 | (2040) | | S | S | - | H | H | H | H | - | - | (3103) | (3111) |
| 388 | 1 | 1 | 0 | (2041) | | S | S | - | H | H | H | H | - | - | (3103) | (3111) |
| 389 | 1 | 1 | 0 | (2042) | | S | S | - | H | H | H | H | - | - | (3103) | (3111) |
| 390 | 1 | 1 | 0 | (2043) | | S | S | - | H | H | H | H | - | - | (3103) | (3111) |
| 391 | 1 | 1 | 0 | (2044) | | S | S | - | H | H | H | H | - | - | (3103) | (3111) |
| 392 | 1 | 1 | 0 | (2007) | | S | S | - | H | H | H | H | - | - | (3103) | (3111) |
| 393 | 1 | 1 | 0 | (2007) | | S | S | - | H | H | $CH_3$ | H | - | - | (3103) | (3111) |
| 394 | 1 | 1 | 0 | (2007) | | S | S | - | H | $CH_3$ | H | H | - | | (3103) | (3111) |
| 395 | 1 | 1 | 0 | (2007) | | S | S | - | H | $CH_3$ | $CH_3$ | H | - | - | (3103) | (3111) |
| 396 | 1 | 1 | 0 | (2007) | | S | S | - | H | H | H | H | - | - | (3103) | (3111) |
| 397 | 1 | 1 | 0 | (2007) | | S | S | - | H | $CH_3$ | $CH_3$ | H | - | - | (3103) | (3111) |
| 398 | 1 | 1 | 0 | (2007) | | S | - | S | H | - | - | H | H | H | (3103) | (3111) |
| 399 | 1 | 1 | 0 | (2007) | | S | - | S | H | - | - | H | $CH_3$ | $CH_3$ | (3103) | (3111) |
| 400 | 1 | 1 | 0 | (2007) | | S | - | S | H | - | - | H | H | H | (3103) | (3111) |
| 401 | 2 | 1 | 0 | (2007) | | S | - | S | H | - | - | H | $CH_3$ | $CH_3$ | (3103) | (3111) |
| 402 | 2 | 1 | 0 | (2007) | | S | - | - | H | - | - | H | - | - | (3103) | (3111) |
| 403 | 2 | 1 | 0 | (2007) | | S | S | - | H | H | H | H | - | - | (3103) | (3111) |
| 404 | 2 | 1 | 0 | (2007) | | S | S | - | H | $CH_8$ | H | H | - | - | (3103) | (3111) |
| 405 | 3 | 1 | 0 | (2007) | | S | S | - | H | H | $CH_3$ | H | - | - | (3103) | (3111) |
| 406 | 3 | 1 | 0 | (2007) | | S | S | - | H | $CH_3$ | $CH_3$ | H | - | - | (3103) | (3111) |
| 407 | 0 | 1 | 1 | (2007) | | S | S | - | H | H | H | H | - | - | (3103) | (3111) |
| 408 | 0 | 1 | 1 | (2007) | | S | S | - | H | H | $CH_3$ | H | - | - | (3103) | (3111) |
| 409 | 0 | 1 | 2 | (2007) | | S | S | - | H | $CH_3$ | $CH_3$ | H | - | - | (3103) | (3111) |
| 410 | 0 | 1 | 2 | (2007) | | S | S | - | H | $CH_3$ | $CH_3$ | H | - | - | (3103) | (3111) |

The photoelectric conversion device of the present invention is obtained by, for example, using an oxide semiconductor fine particle to provide a thin film of the oxide semiconductor fine particle on a substrate, and then having the dye represented by formula (1) supported on this thin film.

The substrate on which the thin film of the oxide semiconductor fine particle is provided is preferably a substrate of which the surface is conductive, and such a substrate is easily available in the market. For example, a material obtained by providing, on the surface of a glass or transparent polymer material such as polyethylene terephthalate or polyethersulfone, a thin film made of a conductive metal oxide such as tin oxide doped with indium, fluorine or antimony, or made of a metal such as copper, silver or gold can be used as the substrate. The conductivity may be usually 1000 Ω or less, and is particularly preferably 100 Ω or less.

In addition, the oxide semiconductor fine particle is preferably made of a metal oxide, and specific examples of the metal oxide include oxides of titanium, tin, zinc, tungsten, zirconium, gallium, indium, yttrium, niobium, tantalum and vanadium. Of these, oxides of titanium, tin, zinc, niobium, indium and the like are preferable, and titanium oxide,

zinc oxide and tin oxide are most preferable. Such an oxide semiconductor can be used alone, but can be used in combination of two or more, or can be used with the surface of the semiconductor being coated. In addition, the particle size of the oxide semiconductor fine particle is usually 1 to 500 nm and preferably 1 to 100 nm as the average particle size. In addition, such an oxide semiconductor fine particle can also be used as a mixture or layers of a particle having a large particle size and a particle having a small particle size.

The thin film of the oxide semiconductor fine particle can be produced by a method including directly spraying the oxide semiconductor fine particle on the substrate to form the thin film of the semiconductor fine particle; a method using the substrate as an electrode to allow the semiconductor fine particle to be electrically precipitated in the form of a thin film; a method applying, on the substrate, a paste containing a fine particle obtained by hydrolysis of a precursor of the semiconductor fine particle, such as a slurry of the semiconductor fine particle or a semiconductor alkoxide, followed by drying, curing or calcining; or the like. The method using a slurry is preferable in terms of performances of the electrode using the oxide semiconductor. When this method is adopted, the slurry is obtained by dispersing the oxide semiconductor fine particle as a secondary aggregate in a dispersion medium by an ordinary method so that the average primary particle diameter is 1 to 200 nm.

The dispersion medium for dispersing the slurry may be any one that can disperse the semiconductor fine particle, and water, an alcohol such as ethanol, a ketone such as acetone or acetylacetone, a hydrocarbon such as hexane, or the like can be used. These may be mixed and used, and water is preferably used in that the change in viscosity of the slurry is small. In order to stabilize the dispersion state of the oxide semiconductor fine particle, a dispersion stabilizer can be used. Examples of the dispersion stabilizer that can be used include acids such as acetic acid, hydrochloric acid and nitric acid, or organic solvents such as acetylacetone, acrylic acid, polyethylene glycol and polyvinyl alcohol.

The substrate to which the slurry is applied may be calcined. The calcination temperature is usually 100°C or higher and preferably 200°C or higher, and the upper limit thereof is approximately the melting point (softening point) of the material of the substrate, usually 900°C and preferably 600°C or lower. In addition, the calcination time is not particularly limited, but is preferably about 4 hours or less. The thickness of the thin film on the substrate is usually 1 to 200 μm and preferably 1 to 50 μm.

The thin film of the oxide semiconductor fine particle may be subjected to a secondary treatment. That is, the thin film of the oxide semiconductor fine particle can be enhanced in terms of performances by, for example, immersing the thin film together with the substrate in a solution of an alkoxide of the same metal as that of the semiconductor, chloride, nitride, sulfide or the like, for drying or re-calcination. The metal alkoxide includes titanium ethoxide, titanium isopropoxide, titanium t-butoxide and n-dibutyl-diacetyltin, and an alcohol solution of such an alkoxide is used. Examples of the chloride include titanium tetrachloride, tin tetrachloride and zinc chloride, and an aqueous solution of such a chloride is used. The oxide semiconductor thin film thus obtained is made of the oxide semiconductor fine particle.

Then, a method for having the methine dye represented by formula (1) in the present invention supported on the thin film of the oxide semiconductor fine particle is described.

The method for having the methine dye represented by formula (1) supported includes a method including immersing the substrate, on which the thin film of the oxide semiconductor fine particle is provided, in a solution obtained by dissolving the dye in a solvent that can dissolve the dye, or in a dispersion obtained by dispersing the dye in the case where the dye is hardly dissolved. The concentration in the solution or the dispersion is appropriately determined depending on the dye. The thin film of the semiconductor fine particle formed on the substrate is immersed in the solution or the dispersion. The immersing temperature is from about room temperature to the boiling point of the solvent, and the immersing time is from about 1 minute to 48 hours. Specific examples of the solvent that can dissolve the dye include methanol, ethanol, isopropanol, tetrahydrofuran (THF), acetonitrile, dimethyl sulfoxide (DMSO), dimethylformamide (DMF), acetone, n-butanol, t-butanol, water, n-hexane, chloroform, dichloromethane and toluene, and these can be used singly or as a mixture thereof depending on the solubility of the dye. The dye concentration in the solution is usually $1 \times 10^{-6}$ M to 1 M and preferably $1 \times 10^{-5}$ M to $1 \times 10^{-1}$ M.

After completion of the immersion, the solvent is removed by air drying or if necessary heating. Thus, the photoelectric conversion device having the thin film of the oxide semiconductor fine particle sensitized by the methine dye represented by formula (1), of the present invention, is obtained.

The methine dye represented by formula (1) to be supported may be of one kind or may be a mixture of two or more. For making a mixture, a methine dye represented by formula (1) in the present invention may be mixed with another methine dye represented by formula (1) in the present invention, or with the other type of dye or a metal complex dye. In particular, dyes having a different absorption wavelength can be mixed to thereby allow a wide range of absorption wavelength to be utilized, thereby providing a solar battery having a high conversion efficiency. Examples of the metal complex dye that can be mixed are not particularly limited, but a ruthenium complex described in Non-Patent Literature 2 and a quaternary ammonium salt compound thereof, phthalocyanine, porphyrin, and the like are preferable, and examples of the organic dye that is mixed and utilized include metal-free phthalocyanine, porphyrin, cyanine, merocyanine, oxonol and triphenylmethane dyes, methine dyes such as an acrylic dye described in Patent Literature 2, and

xanthene, azo, anthraquinone and perylene dyes. Preferable examples include a ruthenium complex, a merocyanine dye, and methine dyes such as an acrylic dye. When two or more dyes are used, such dyes may be allowed to sequentially adsorb to the thin film of the semiconductor fine particle, or may be dissolved and mixed together, then allowed to adsorb.

The ratio of such dyes mixed is not particularly limited, and the optimal conditions of each of such dyes are appropriately selected, but in general such dyes are mixed in an equal molar and preferably one of them is used in an amount of about 10% excess. When a solution of two or more dyes dissolved or dispersed is used to allow such dyes to adsorb to the thin film of the oxide semiconductor fine particle, the total concentration of such dyes in the solution may be the same as in the case where only one dye is supported. When such dyes are mixed and used, any of the above solvents can be used, and the solvents of the respective dyes to be used may be the same or different.

When the dye is supported on the thin film of the oxide semiconductor fine particle, the dye is advantageously supported in coexistence with a clathrate compound in order to prevent association of the dye. The clathrate compound here includes a steroid compound such as cholic acid, and crown ether, cyclodextrin, calixarene and polyethylene oxide, and specific examples preferably include cholic acids such as deoxycholic acid, dehydrodeoxycholic acid, chenodeoxycholic acid, cholic acid methyl ester and sodium cholate, and polyethylene oxide. After the dye is supported, the thin film of the semiconductor fine particle may also be treated with an amine compound such as 4-t-butylpyridine. As the treatment method, for example, a method is adopted which includes immersing the substrate provided with the thin film of the semiconductor fine particle, on which the dye is supported, in a solution of an amine in ethanol.

The solar battery of the present invention is configured from, as one electrode, the photoelectric conversion device in which the dye is supported on the thin film of the oxide semiconductor fine particle, a counter electrode, and a redox electrolyte, a positive hole transport material, p-type semiconductor or the like. The redox electrolyte, the positive hole transport material, the p-type semiconductor or the like that can be used may be the known one per se, such as liquid form, solidified form (gel and gel-like form), and solid form. The liquid form includes those obtained by dissolving each of the redox electrolyte, a molten salt, the positive hole transport material and the p-type semiconductor in a solvent, and a molten salt at ordinary temperature, the solidified form (gel and gel-like form) includes the above liquid form included in a polymer matrix or a low molecular weight gelling agent. As the solid form, the redox electrolyte, the molten salt, the positive hole transport material, the p-type semiconductor or the like can be used. The positive hole transport material includes amine derivatives, conductive polymers such as polyacetylene, polyaniline and polythiophene, and a triphenylene compound. The p-type semiconductor includes CuI and CuSCN. The counter electrode is preferably an electrode having conductivity and catalytically active for the reduction reaction of the redox electrolyte. For example, a glass or polymer film, on which platinum, carbon, rhodium, ruthenium or the like is deposited, or to which a conductive fine particle is applied, can be used.

The redox electrolyte for use in the solar battery of the present invention can include a halogen oxidation-reduction electrolyte that includes a halogen compound having a halogen ion as a counterion, and a halogen molecule; a metal oxidation-reduction electrolyte of ferrocyanic acid salt-ferricyanic acid salt, a ferrocene-ferricinium ion, a metal complex such as a cobalt complex, and the like; and an organic oxidation-reduction electrolyte of alkyl thiol-alkyl disulfide, a viologen dye, hydroquinone-quinone, and the like; but is preferably a halogen oxidation-reduction electrolyte. Examples of the halogen molecule in the halogen oxidation-reduction electrolyte that includes halogen compound-halogen molecule include an iodine molecule and a bromine molecule, and an iodine molecule is preferable. Examples of the halogen compound having a halogen ion as a counterion include metal halide salts such as LiBr, NaBr, KBr, LiI, NaI, KI, CsI, $CaI_2$, $MgI_2$ and CuI; or organic quaternary ammonium salts of halogens, such as tetraalkylammonium iodide, imidazolium iodide and pyridinium iodide; but salts having an iodine ion as a counterion are preferable. An electrolyte having an imide ion such as a bis(trifluoromethanesulfonyl)imide ion or a dicyanoimide ion as a counterion, in addition to the iodine ion, is also preferably used.

When the redox electrolyte is configured in the form of a solution thereof, an electrochemically inert solvent is used as a solvent therefor. Examples include acetonitrile, propylene carbonate, ethylene carbonate, 3-methoxypropionitrile, methoxyacetonitrile, ethylene glycol, propylene glycol, diethylene glycol, triethylene glycol, γ-butyrolactone, dimethoxyethane, diethyl carbonate, diethyl ether, diethyl carbonate, dimethyl carbonate, 1,2-dimethoxyethane, dimethylformamide, dimethylsulfoxide, 1,3-dioxolane, methyl formate, 2-methyltetrahydrofuran, 3-methyl-oxazolidine-2-one, sulfolane, tetrahydrofuran and water, and of these, in particular, acetonitrile, propylene carbonate, ethylene carbonate, 3-methoxypropionitrile, methoxyacetonitrile, ethylene glycol, 3-methyl-oxazolidine-2-one, γ-butyrolactone and the like are preferable. These may be used alone or in combination of two or more. The gel-like electrolyte includes oligomer and polymer matrices in which an electrolyte or an electrolyte solution is incorporated, and a low molecular weight gelling agent in which an electrolyte or an electrolyte solution is similarly incorporated. The concentration of the redox electrolyte is usually about 0.01 to 99% by mass and preferably about 0.1 to 90% by mass.

The solar battery of the present invention can be obtained by disposing a counter electrode beside the electrode of a photoelectric conversion device produced by supporting the methine dye represented by Formula (1) of the present invention on a thin film of oxide semiconductor fine particles provided on a substrate, and then filling a solution comprising a redox electrolyte therebetween.

Examples

Hereinafter, the present invention is described based on Examples in more detail, but the present invention is not limited to these Examples. In Examples, "part(s)" represents "part(s) by mass", unless otherwise indicated. "M" that expresses the concentration of a solution represents "mol/L". In addition, each compound number corresponds to each compound number in specific examples described above. The maximum absorption wavelength was measured by a UV-VIS spectrophotometer (UV-3100PC manufactured by Shimadzu Corporation). Nuclear magnetic resonance analysis was made by Gemini 300 (manufactured by Varian Inc.) with respect to compounds (179), (180), (186) and (190), and made by JNM-ECS400 (manufactured by Jeol Ltd.) with respect to compound (199), respectively.

Synthesis Example 1

To 340 parts of 1,2-dimethoxyethane were added 26 parts of 9,9-dibutyl-2-iodofluorene, 10 parts of 3-thiopheneboronic acid, 2.3 parts of tetrakis(triphenylphosphine)palladium (0) and 180 parts of an aqueous 20% sodium carbonate solution, and the resultant was subjected to reaction under reflux for 5 hours. The reaction mixture was extracted with toluene-water, and the toluene phase was concentrated and then subjected to separation and purification by column chromatography (toluene-hexane), thereby providing 15 parts of the following compound (700) as a colorless oil.

[Formula 16]

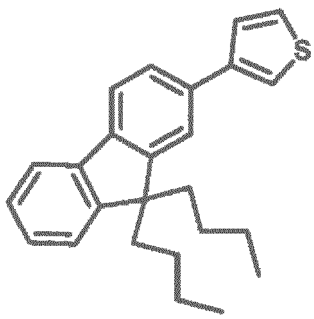

(700)

Synthesis Example 2

In a mixed liquid of 40 parts of acetic acid and 60 parts of chloroform was dissolved 15 parts of compound (700), 5 parts of N-bromosuccinimide was added thereto, and the resultant was stirred under reflux. After 1 hour, 2.5 parts of N-bromosuccinimide was added thereto, and the resultant was stirred under reflux for additional 1 hour. The reaction mixture was extracted with chloroform-water, and the chloroform phase was concentrated and then subjected to separation and purification by column chromatography (hexane), thereby providing 17 parts of the following compound (701) as a colorless oil.

[Formula 17]

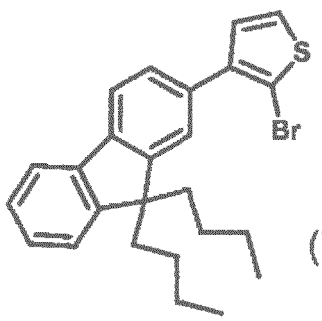

(701)

Synthesis Example 3

To a solution of 17 parts of compound (701) dissolved in 210 parts of acetic acid was added 8.6 parts of N-iodosuccinimide, and the resultant was stirred under light shielding at 100°C for 5 hours. The reaction mixture was

extracted with chloroform-water, and the chloroform phase was concentrated and then subjected to separation and purification by column chromatography (chloroform-hexane), thereby providing 17 parts of the following compound (702) as a colorless oil.

[Formula 18]

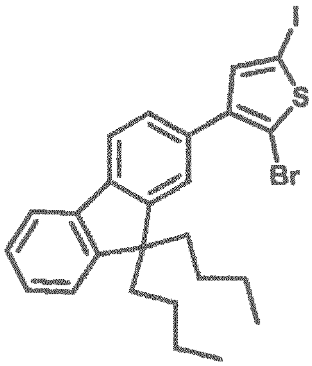

(702)

Synthesis Example 4

To 160 parts of 1,2-dimethoxyethane were added 17 parts of compound (702), 10 parts of 4-(diphenylamino)phenylboronic acid, 1 part of tetrakis(triphenylphosphine)palladium (0) and 84 parts of an aqueous 20% sodium carbonate solution, and the resultant was subjected to reaction under reflux for 5 hours. The reaction mixture was extracted with chloroform-water, and the chloroform phase was concentrated and then subjected to separation and purification by column chromatography (chloroform-hexane), thereby providing 6.9 parts of the following compound (703) as a white solid.

[Formula 19]

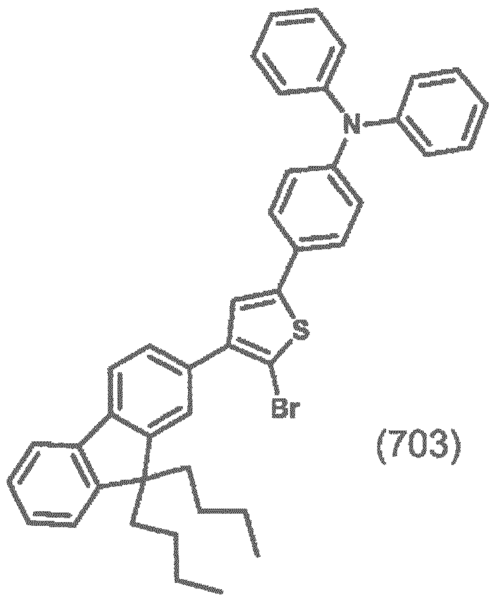

(703)

Synthesis Example 5

To 15 parts of 1,2-dimethoxyethane were added 1 part of compound (703), 0.23 parts of 5-formyl-2-thiopheneboronic acid, 0.052 parts of tetrakis(triphenylphosphine)palladium (0) and 4 parts of an aqueous 20% sodium carbonate solution, and the resultant was subjected to reaction under reflux for 1 hour. Thereto were added 0.23 parts of 5-formyl-2-thiopheneboronic acid and 0.052 parts of tetrakis(triphenylphosphine)palladium (0), and the resultant was subjected to reaction under reflux for additional 1 hour. Thereto were added 0.33 parts of 5-formyl-2-thiopheneboronic acid and 0.066 parts of tetrakis(triphenylphosphine)palladium (0) again, and the resultant was subjected to reaction under reflux

for 5 hours. The reaction mixture was extracted with chloroform-water, and the chloroform phase was concentrated and then subjected to separation and purification by column chromatography (chloroform-hexane), thereby providing 0.2 parts of the following compound (704) as a yellow solid.

[Formula 20]

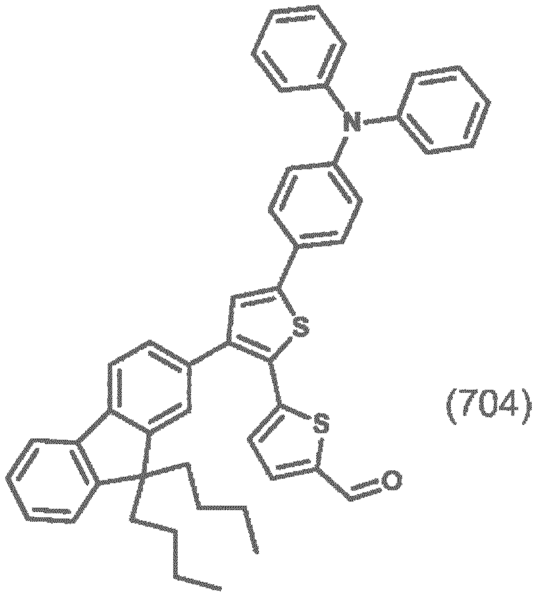

(704)

Example 1

In 4 parts of toluene were dissolved 0.2 parts of compound (704) and 0.037 parts of cyanoacetic acid, and 0.001 parts of anhydrous piperazine was added thereto and the resultant was subjected to reaction under reflux for 6 hours. The reaction mixture was extracted with chloroform-water, and the chloroform phase was concentrated and then subjected to separation and purification by column chromatography (chloroform-ethanol). A black-red solid obtained after the concentration was recrystallized from chloroform-hexane, thereby providing 0.034 parts of the following compound (179) as a black-red solid.

The maximum absorption wavelength of the compound (179) and the measurement value in a nuclear magnetic resonance apparatus thereof are as follows.

$$\text{Maximum absorption wavelength; } \lambda max = 439 \text{ nm } (1.6 \times 10^{-5}\text{M},$$
$$\text{dimethylsulfoxide/ethanol} = 1/9 \text{ solution})$$

Measurement value by nuclear magnetic resonance; $^1$H-NMR (PPM: DMSO-d6): 0.50 (m. 4H), 0.59 (m.6H), 0.97 (m. 4H), 1.89 (m.4H), 6.98 (d.2H), 7.12 (m.7H), 7.40 (m.9H), 7.62 (s.1H), 7.70 (d.2H), 7.83 (m.2H), 7.91 (d.1H), 9.31 (s, 1H)

[Formula 21]

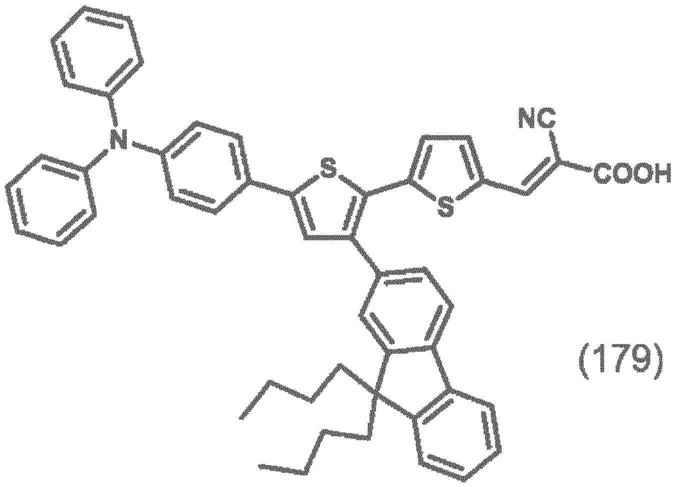

(179)

Synthesis Example 6

To 93 parts of 1,2-dimethoxyethane were added 4.1 parts of compound (701), 2.2 parts of 5-formyl-2-thiopheneboronic acid, 0.32 parts of tetrakis(triphenylphosphine)palladium (0) and 25 parts of an aqueous 20% sodium carbonate solution, and the resultant was subjected to reaction under reflux for 4 hours. Thereto were added 2.2 parts of 5-formyl-2-thiopheneboronic acid and 0.32 parts of tetrakis(triphenylphosphine)palladium (0), and the resultant was subjected to reaction under reflux for additional 3 hours. The reaction mixture was extracted with chloroform-water, and the chloroform phase was concentrated and then subjected to separation and purification by column chromatography (chloroform-hexane), thereby providing 0.76 parts of the following compound (705).

[Formula 22]

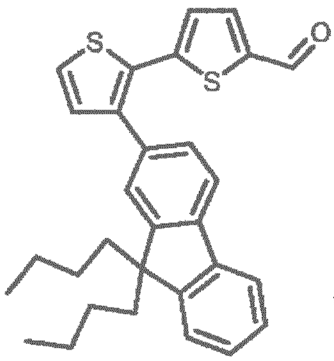

(705)

Synthesis Example 7

In a mixed liquid of 10 parts of acetic acid and 15 parts of chloroform was dissolved 1 part of compound (705), 0.25 parts of N-bromosuccinimide was added thereto, and the resultant was stirred under reflux. After 1 hour, 0.13 parts of N-bromosuccinimide was added thereto, and the resultant was stirred under reflux for additional 1 hour. The reaction mixture was extracted with chloroform-water, and the chloroform phase was concentrated and then subjected to separation and purification by column chromatography (clnoroform-hexane), thereby providing 0.98 parts of the following compound (706) as a brown oil.

[Formula 23]

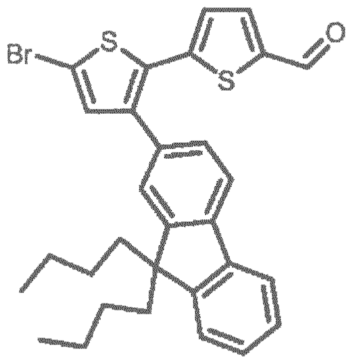

(706)

Synthesis Example 8

To 22 parts of dimethylsulfoxide were added 1.6 parts of a [1,1'-bis(diphenylphosphino)ferrocene]dichloro palladium (II) dichloromethane adduct, 2 parts of potassium acetate and 2 parts of bis(pinacolato)diboron, and the resultant was stirred under a nitrogen atmosphere. Thereto was added a solution of 5 parts of 9,9-dibutyl-N-(9,9-dibutylfluorene-2-yl)-N-(4-iodophenyl)fluorene-2-amine dissolved in 66 parts of dimethylsulfoxide, and the resultant was stirred at 80°C for 5 hours. The reaction mixture was extracted with toluene-water, the toluene phase was concentrated and then subjected to separation and purification by column chromatography (chloroform-hexane), thereby providing 3.5 parts of the following compound (707) as a white solid.

[Formula 24]

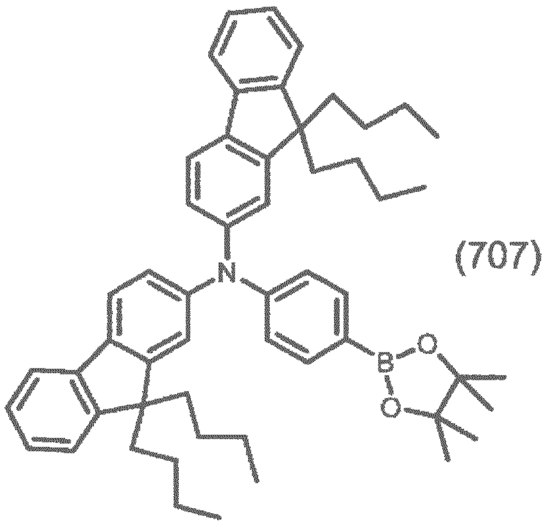

(707)

Synthesis Example 9

To 20 parts of 1,2-dimethoxyethane were added 2.3 parts of compound (707), 0.99 parts of compound (706), 0.062 parts of tetrakis(triphenylphosphine)palladium (0) and 5 parts of an aqueous 20% sodium carbonate solution, and the resultant was subjected to reaction under reflux for 5 hours. The reaction mixture was extracted with chloroform-water, and the chloroform phase was concentrated and then subjected to separation and purification by column chromatography (chloroform-hexane), thereby providing 1.7 parts of the following compound (708) as an orange solid.

[Formula 25]

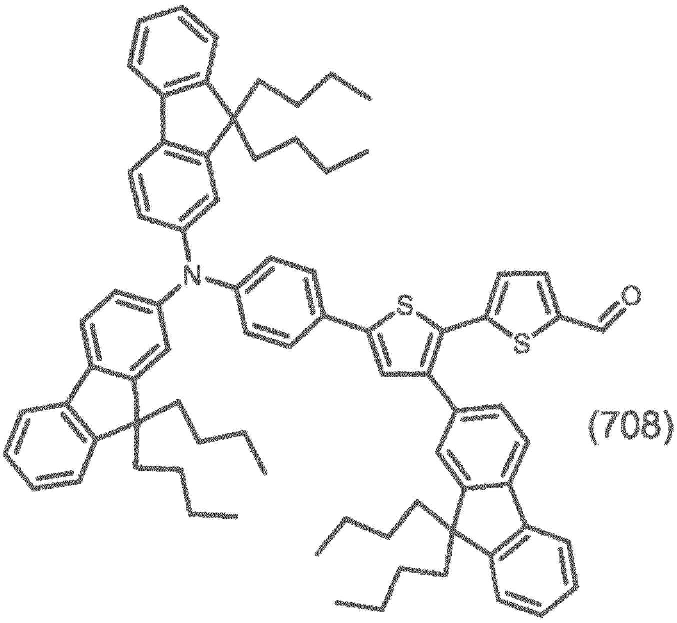

(708)

Example 2

In 300 parts of a mixed liquid of ethanol-toluene (2 : 1) were dissolved 1.7 parts of compound (708) and 0.38 parts of cyanoacetic acid, 0.01 parts of anhydrous piperazine was added thereto, and the resultant was subjected to reaction under reflux for 6 hours. Thereto was added 0.38 parts of cyanoacetic acid, and the resultant was subjected to reaction for additional 4 hours. The reaction mixture was extracted with chloroform-water, and the chloroform phase was concentrated and then subjected to separation and purification by column chromatography (chloroform-ethanol). A black-red solid obtained after the concentration was recrystallized from chloroform-methanol, thereby providing 0.28 parts of the following compound (180) as a black-red solid.

The maximum absorption wavelength of the compound (180) and the measurement value in a nuclear magnetic resonance apparatus thereof are as follows.

Maximum absorption wavelength; $\lambda max$ = 441 nm ($1.6 \times 10^{-5}$M, dimethylsulfoxide solution) Measurement value by nuclear magnetic resonance; $^1$H-NMR (PPM: DMSO-d6): 0.57 (m.12H), 0.64 (m.18H), 1.00 (m.12H), 1.87 (m.12H), 7.03 (m.5H), 7.19 (d.2H), 7.30 (m.6H), 7.39 (m. 4H), 7.46 (m.1H), 7.50 (m.1H), 7.57 (s.1H), 7.65 (d, 2H), 7.74 (m, 4H), 7.81 (m, 1H), 7.88 (m, 2H)

[Formula 26]

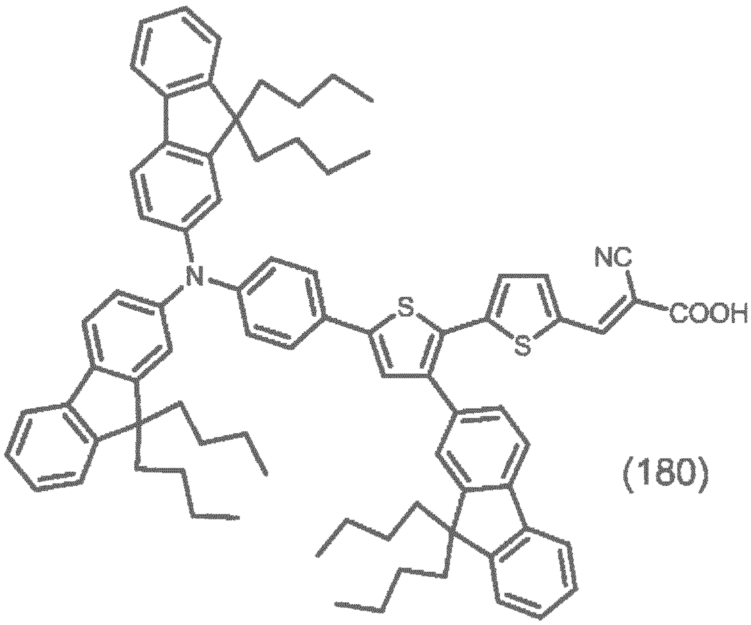

(180)

Synthesis Example 10

To 63 parts of 1,2-dimethoxyethane were added 2.8 parts of compound (701), 3 parts of 5-formyl-5'-(4,4,5,5-tetramethyl-1,3,2-dioxaborolan-2-yl)-2,2'-bithiophene, 0.22 parts of tetrakis(triphenylphosphine)palladium (0) and 17 parts of an aqueous 20% sodium carbonate solution, and the resultant was subjected to reaction under reflux for 5 hours. The reaction mixture was extracted with chloroform-water, and the chloroform phase was concentrated and then subjected to separation and purification by column chromatography (chloroform-hexane), thereby providing 0.66 parts of the following compound (709) as a brown solid.

[Formula 27]

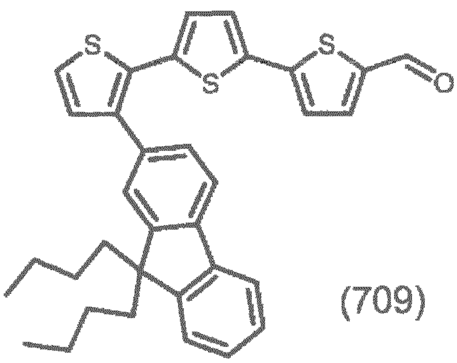

(709)

Synthesis Example 11

In a mixed liquid of 20 parts of acetic acid and 30 parts of chloroform was dissolved 2.6 parts of compound (709), 0.56 parts of N-bromosuccinimide was added thereto, and the resultant was stirred under reflux. After 1 hour, 0.28 parts of N-bromosuccinimide was added thereto, and the resultant was stirred under reflux for additional 1 hour. The reaction mixture was extracted with chloroform-water, and the chloroform phase was concentrated and then subjected to separation and purification by column chromatography (chloroform-hexane), thereby providing 2.8 parts of the following compound (710) as a yellow-brown solid.

[Formula 28]

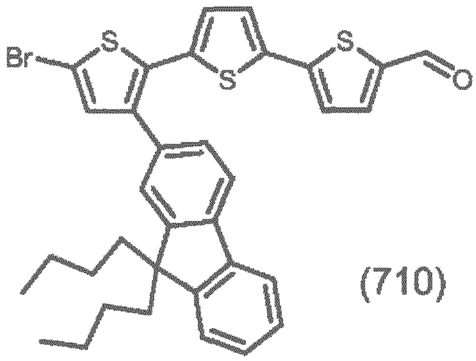

(710)

Synthesis Example 12

To 10 parts of 1,2-dimethoxyethane were added 0.55 parts of compound (710), 0.32 parts of 4-(diphenylamino)phenylboronic acid, 0.03 parts of tetrakis(triphenylphosphine)palladium (0) and 4 parts of an aqueous 20% sodium carbonate solution, and the resultant was subjected to reaction under reflux for 3 hours. The reaction mixture was extracted with chloroform-water, and the chloroform phase was concentrated and then subjected to separation and purification by column chromatography (chloroform-hexane), thereby providing 0.65 parts of the following compound (711) as a yellow-brown solid.

[Formula 29]

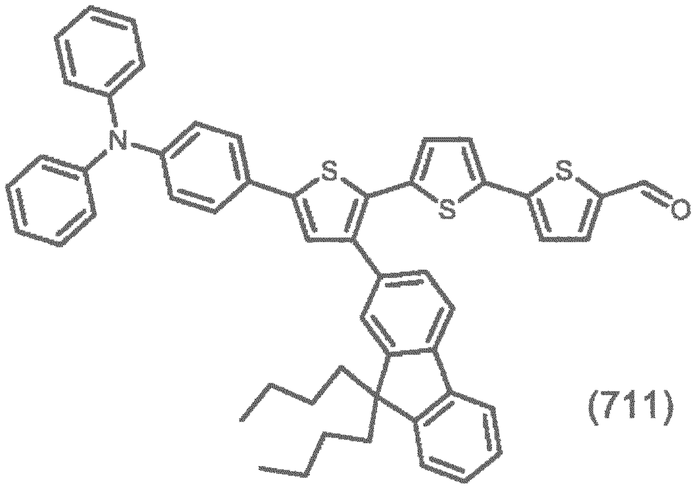

(711)

Example 3

In 150 parts of a mixed liquid of ethanol-toluene (2 : 1) were dissolved 0.65 parts of compound (711) and 0.2 parts of cyanoacetic acid, 0.001 parts of anhydrous piperazine was added thereto, and the resultant was subjected to reaction under reflux for 1.5 hours. Thereto were added 0.2 parts of cyanoacetic acid and 0.001 parts of anhydrous piperazine, and the resultant was subjected to reaction for additional 4 hours. The reaction mixture was extracted with chloroform-water, and the chloroform phase was concentrated and then subjected to separation and purification by column chromatography (chloroform-ethanol). A black-brown solid obtained after the concentration was recrystallized from chloroform-hexane, thereby providing 0.44 parts of the following compound (186) as a black-brown solid.

The maximum absorption wavelength of compound (186) and the measurement value in a nuclear magnetic resonance apparatus thereof are as follows.

Maximum absorption wavelength; $\lambda max$ = 449 nm ($1.6 \times 10^{-5}$M, dimethylsulfoxide/ethanol = 1/9 solution)

Measurement value by nuclear magnetic resonance; $^1$H-NMR (PPM: DMSO-d6): 0.50 (m.10H), 0.90 (m. 4H), 1.89 (m. 4H), 6.99 (d.2H), 7.10 (m.6H), 7.39 (m.11H), 7.45 (d.1H), 7.58 (s.1H), 7.67 (d.2H), 7.85 (m.2H), 7.92 (d, 1H), 8.37 (s, 1H)

[Formula 30]

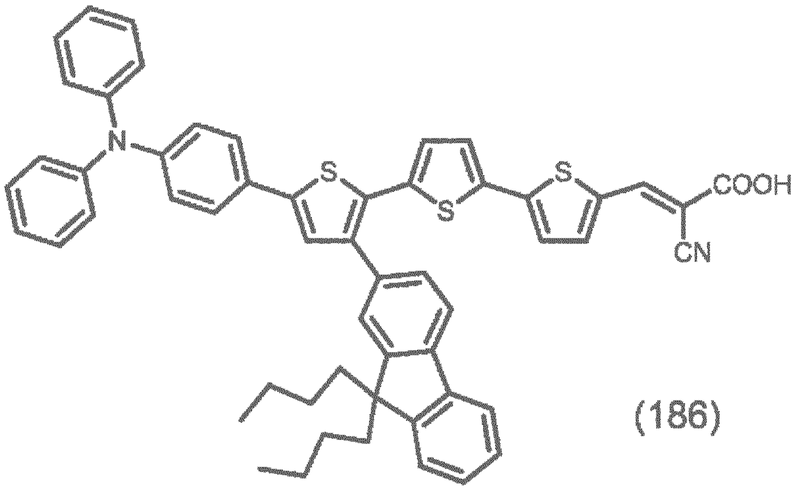

(186)

Synthesis Example 13

To 25 parts of 1,2-dimethoxyethane were added 1.5 parts of compound (710), 2.7 parts of compound (707), 0.083 parts of tetrakis(triphenylphosphine)palladium (0) and 6.3 parts of an aqueous 20% sodium carbonate solution, and the resultant was subjected to reaction under reflux for 5 hours. The reaction mixture was extracted with chloroform-water, and the chloroform phase was concentrated and then subjected to separation and purification by column chromatography (chloroform-hexane), thereby providing 2.1 parts of the following compound (712) as a red-orange solid.

[Formula 31]

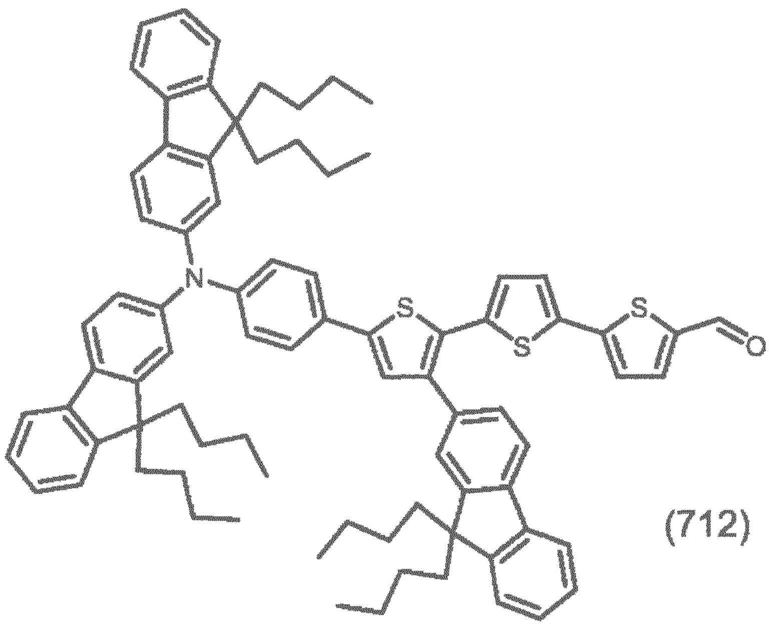

(712)

Example 4

In 520 parts of a mixed liquid of ethanol-toluene (2 : 1) were dissolved 2.1 parts of compound (712) and 0.66 parts of cyanoacetic acid, 0.01 parts of anhydrous piperazine was added thereto, and the resultant was subjected to reaction under reflux for 1 hour. Thereto was added 0.66 parts of cyanoacetic acid, and the resultant was subjected to reaction for additional 4 hours. The reaction mixture was extracted with chloroform-water, and the chloroform phase was concentrated and then subjected to separation and purification by column chromatography (chloroform-ethanol). A black-red solid obtained after the concentration was recrystallized from chloroform-ethanol, thereby providing 0.60

parts of the following compound (190) as a black-red solid.

The maximum absorption wavelength of compound (190) and the measurement value in a nuclear magnetic resonance apparatus thereof are as follows.

Maximum absorption wavelength; λmax = 465nm (1.6 × $10^{-5}$M, dimethylsulfoxide solution) Measurement value by nuclear magnetic resonance; $^1$H-NMR (PPM: DMSO-d6): 0.57 (m.30H), 0.94 (m.12H), 1.87 (m.12H), 7.05 (m.5H), 7.19 (d.2H), 7.35 (m.13H), 7.52 (s.1H), 7.62 (d.2H), 7.72 (m.4H), 7.86 (m.3H), 8.38 (s.1H)

[Formula 32]

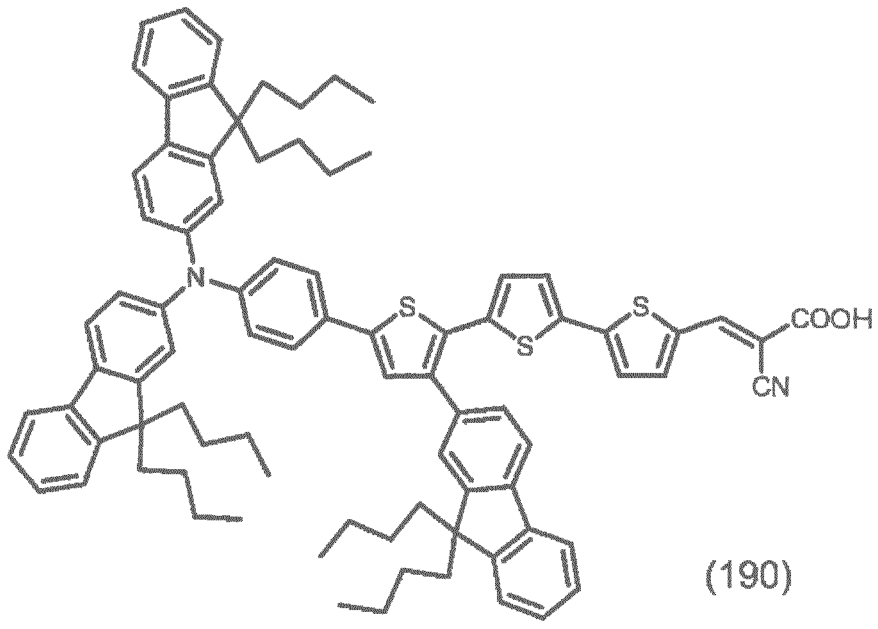

(190)

Synthesis Example 14

To 126 parts of 1,4-dioxane were added 5 parts of 2,3-dibromothiophene, 5.5 parts of 5'-formyl-2,2'-bithiophene-5-boronic acid, 0.22 parts of bis(tri-tert-butylphosphine)palladium (0), 6.4 parts of cesium fluoride and 28 parts of water, and the resultant was subjected to reaction at 80°C for 3 hours. The reaction mixture was extracted with chloroform-water, and the chloroform phase was concentrated and then subjected to separation and purification by column chromatography (chloroform-hexane), thereby providing 2.8 parts of the following compound (713) as a yellow solid.

[Formula 33]

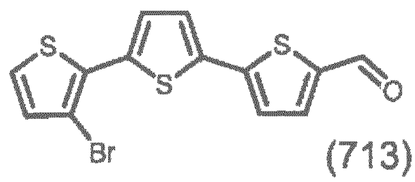

(713)

Synthesis Example 15

In a solution of 2.5 parts of compound (713) dissolved in a mixed liquid of 250 parts of acetic acid and 375 parts of chloroform was added 1.6 parts of N-iodosuccinimide, and the resultant was stirred under light shielding at ordinary temperature for 5 hours. Thereto was added 0.8 parts of N-iodosuccinimide, and the resultant was further stirred under light shielding at ordinary temperature for 19 hours. After reaction, a precipitate was taken out by filtration and washed with hexane, thereby providing 2.9 parts of the following compound (714) as a light orange solid.

[Formula 34]

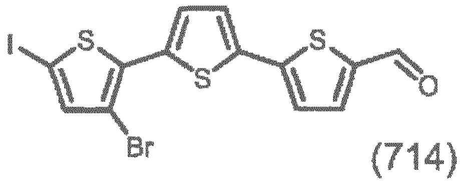

(714)

Synthesis Example 16

To 300 parts of 1,2-dimethoxyethane were added 2.1 parts of compound (714), 4.1 parts of compound (707), 0.15 parts of tetrakis(triphenylphosphine)palladium (0) and 16 parts of an aqueous 20% sodium carbonate solution, and the resultant was subjected to reaction under reflux for 4 hours. Thereto were added 2.0 parts of compound (707) and 0.08 parts of tetrakis(triphenylphosphine)palladium (0), and the resultant was further subjected to reaction under reflux for 3 hours. The reaction mixture was extracted with chloroform-water, and the chloroform phase was concentrated and then subjected to separation and purification by column chromatography (chloroform-hexane and toluene-hexane), thereby providing 1.2 parts of the following compound (715) as a dark orange solid.

[Formula 35]

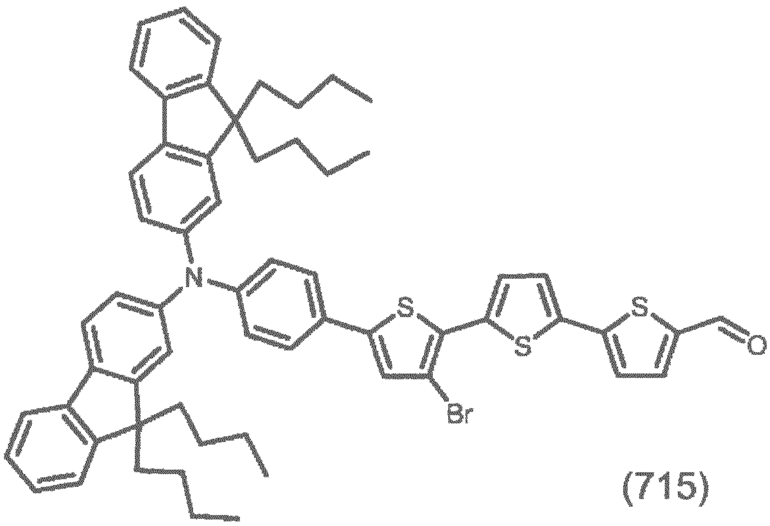

(715)

Synthesis Example 16

To 21 parts of 1,4-dioxane were added 1.2 parts of compound (715), 0.52 parts of 4-(diphenylamino)phenylboronic acid, 0.012 parts of bis(tri-tert-butylphosphine)palladium (0), 0.37 parts of cesium fluoride and 1.6 parts of water, the resultant was subjected to reaction at 80°C for 5 hours, thereafter 0.022 parts of bis(tri-tert-butylphosphine)palladium (0) was added thereto, and the resultant was further subjected to reaction at 80°C for 3 hours. The reaction mixture was extracted with chloroform-water, and the chloroform phase was concentrated and then subjected to separation and purification by column chromatography (chloroform-hexane), thereby providing 1.3 parts of the following compound (716) as an orange solid.

[Formula 36]

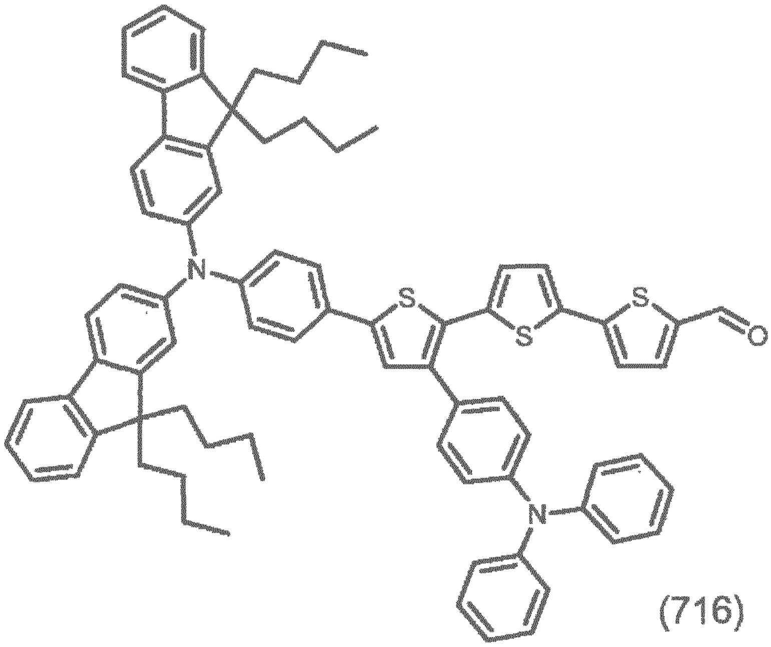

(716)

Example 5

In 220 parts of a mixed liquid of ethanol-toluene (2 : 1) were dissolved 1.3 parts of compound (716) and 0.29 parts of cyanoacetic acid, 0.01 parts of anhydrous piperazine was added thereto, and the resultant was subjected to reaction under reflux for 1 hour. Thereto was added 0.29 parts of cyanoacetic acid, and the resultant was further subjected to reaction under reflux for 8 hours. The reaction mixture was extracted with toluene-water, and the toluene phase was concentrated and then subjected to separation and purification by column chromatography (chloroform-methanol). A black-red solid obtained after the concentration was recrystallized from chloroform-hexane, thereby providing 1.0 part of the following compound (199) as a reddish brown solid.

The maximum absorption wavelength of compound (199) and the measurement value in a nuclear magnetic resonance apparatus thereof are as follows.

Maximum absorption wavelength; $\lambda max$ = 505 nm ($1.6 \times 10^{-5}$M, chloroform solution) Measurement value by nuclear magnetic resonance; $^{1}$H-NMR (PPM: DMSO-d6): 0.55 (m.8H), 0.64 (t.12H), 1.02 (m.8H), 1.89 (m.8H), 7.50 (m.12H), 7.15 (d.1H), 7.19 (d.2H), 7.30 (m.10H), 7.40 (dd.2H), 7.43 (d.1H), 7.46 (d.1H), 7.49 (s.1H), 7.61 (d.2H), 7.73 (m. 4H), 7.83 (d, 1H), 8.28 (s, 1H)

[Formula 37]

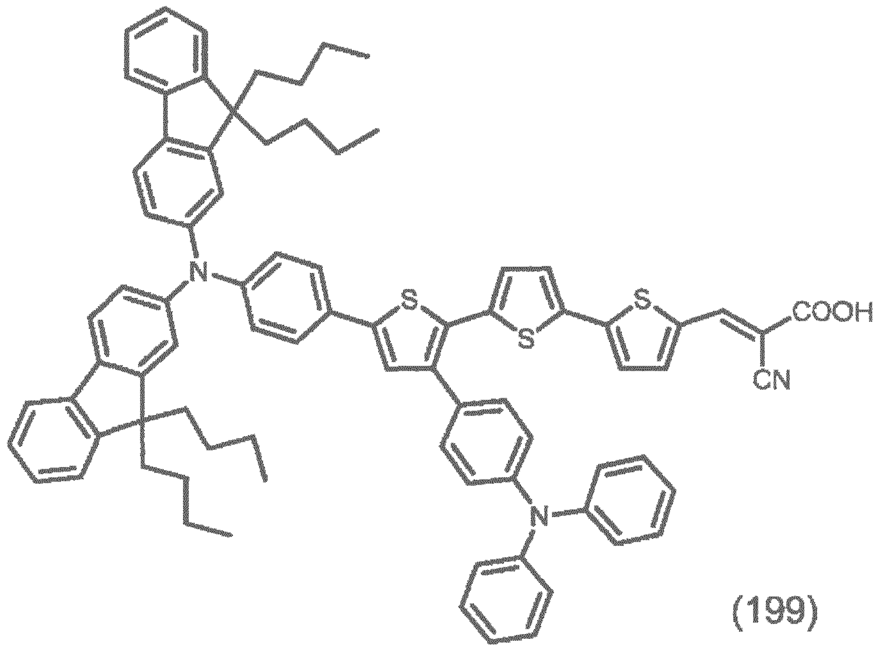

(199)

Example 6

In 45 parts of a mixed liquid of ethanol-toluene (2 : 1) were dissolved 0.46 parts of compound (716) obtained in Synthesis Example 16 and 0.1 parts of 1-phenyl-5-pyrazolone-3-carboxylic acid, and the resultant was subjected to reaction under reflux for 4 hours. The reaction mixture was extracted with toluene-water, and the toluene phase was concentrated and then subjected to separation and purification by column chromatography (chloroform-methanol). A black-purple solid obtained after the concentration was recrystallized from chloroform-hexane, thereby providing 0.13 parts of the following compound (500) as a black-purple solid.

The maximum absorption wavelength of compound (500) and the measurement value in a nuclear magnetic resonance apparatus thereof are as follows.

Maximum absorption wavelength; $\lambda$max = 554 nm (1.6 $\times$ $10^{-5}$ M, THF solution)

Measurement value by nuclear magnetic resonance; $^1$H-NMR (PPM: DMSO-d6): 0.58 (m.8H), 0.65 (t.12H), 1.01 (m.8H), 1.90 (m.8H), 7.04 (m.8H), 7.11 (m.4H), 7.21 (m.3H), 7.35 (m.15H), 7.51 (s.1H), 7.55 (d.1H), 7.59 (d.1H), 7.63 (d.2H), 7.75 (m.4H), 7.90 (d.2H), 8.03 (d, 1H), 9.05 (s, 1H)

[Formula 38]

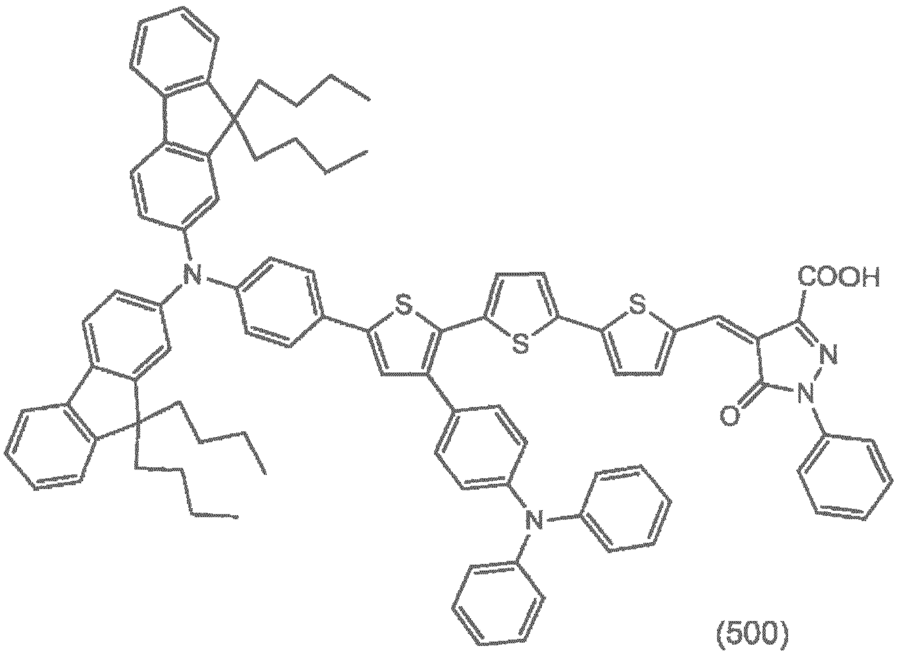

(500)

Examples 7 to 12 and Comparative Examples 1 to 5

Each of methine dyes and Comparative Example dyes of compound numbers shown in Table 11 and each of cholic acids below (formula (a), (b) or (c)) were dissolved in ethanol (tetrahydrofuran in Example 12 and Comparative Example 5) so that the concentrations of each dye and each cholic acid were $3.2 \times 10^{-4}$ M ($1.6 \times 10^{-4}$M in Example 12 and Comparative Example 5) and $3 \times 10^{-2}$ M ($5 \times 10^{-3}$ M in Example 12 and Comparative Example 5), respectively. A porous substrate (semiconductor thin film electrode obtained by sintering porous titanium oxide on a transparent conductive glass electrode at 450°C for 30 minutes) was immersed in this solution at room temperature for 3 hours to overnight to allow the dye to be supported, and the resultant was washed with a solvent and dried to thereby provide a dye-sensitized semiconductor thin film treated with cholic acids. The conductive glass of which the surface was subjected to sputtering of platinum was secured so that the surface was sandwiched between the thin film and the glass, and a solution including an electrolyte was injected to a space therebetween. As the electrolyte solution, one in which iodine/lithium iodide/1,2-dimethyl-3-n-propylimidazolium iodide/t-butylpyridine were dissolved in 3-methoxypropionitrile so that the respective concentrations were 0.1 M/0.1 M/0.6 M/1 M (0 M in Example 12 and Comparative Example 5) was used.

The size of the efficient part of a battery to be measured was 0.25 $cm^2$. The light source was a 500 W Xenon lamp and the amount of light was 100 $mW/cm^2$ through an AM (air mass) 5 filter. The short circuit current, the open voltage and the conversion efficiency were measured by using potentio-/galvano-stat.

[Formula 39]

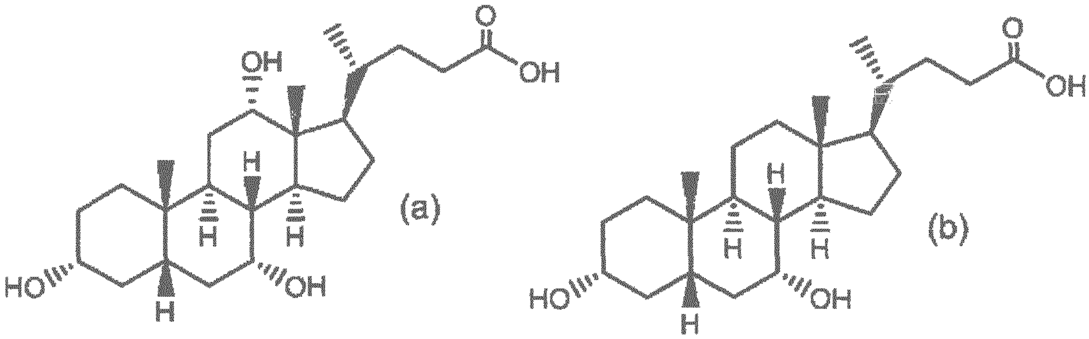

(a) (b)

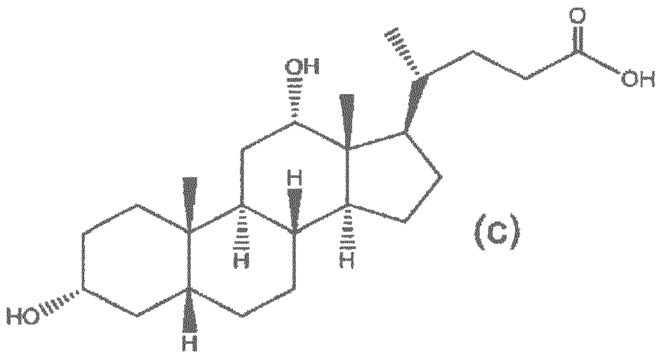

(c)

Compound (246) and compound (248) described in International Publication WO 2004/08261, and compound (160) and compound (161) described in International Publication WO 2007/100033 were used as compounds A, B, C and D, respectively, and evaluated as Comparative dyes. In addition, compound (281) described in International Publication WO 2007/100033 was used as compound E, and evaluated as Comparative dye.

[Formula 40]

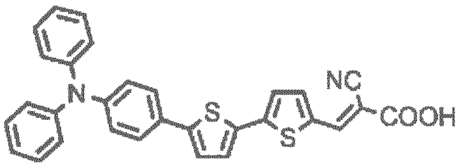

(A)

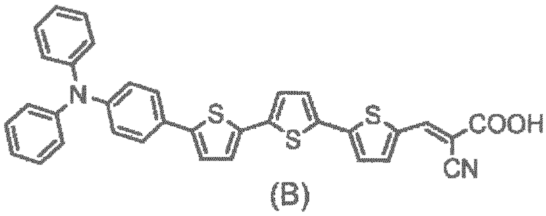

(B)

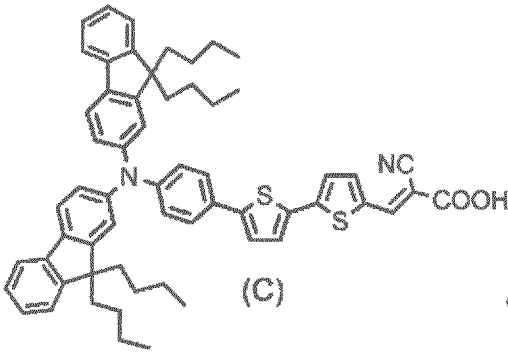

(C)

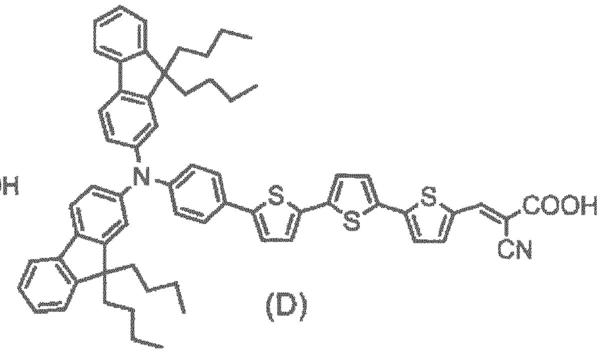

(D)

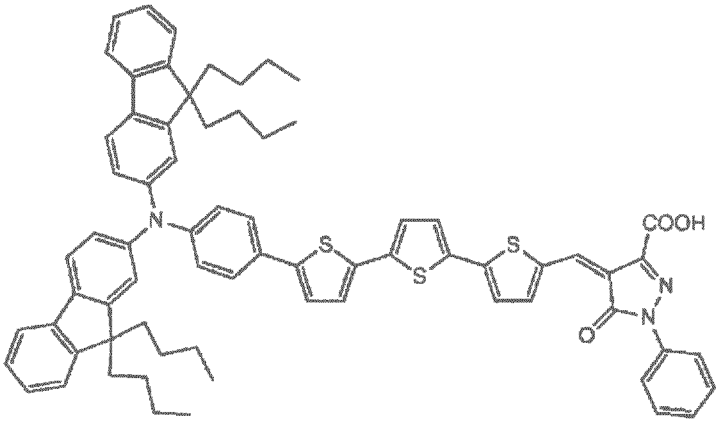

(E)

[Table 11]

Table 11 Evaluation results of photoelectric conversion properties

| | Compound number | Cholic acids | Short circuit current (mA/cm$^2$) | Open voltage (V) | Conversion efficiency (%) |
|---|---|---|---|---|---|
| Example 7 | 179 | (b) | 9.64 | 0.74 | 4.7 |
| Example 8 | 180 | (a) | 9.19 | 0.73 | 4.61 |
| Example 9 | 186 | (a) | 9.07 | 0.73 | 4.27 |
| Example 10 | 190 | (a) | 11.86 | 0.72 | 5.45 |
| Example 11 | 199 | (a) | 12.23 | 0.71 | 5.72 |
| Example 12 | 500 | (c) | 18.12 | 0.56 | 5.83 |
| Comparative Example 1 | A | (b) | 8.63 | 0.65 | 3.69 |
| Comparative Example 2 | B | (a) | 8.30 | 0.64 | 3.42 |

(continued)

| | Compound number | Cholic acids | Short circuit current ($mA/cm^2$) | Open voltage (V) | Conversion efficiency (%) |
|---|---|---|---|---|---|
| Comparative Example 3 | C | (a) | 9.06 | 0.69 | 3.83 |
| Comparative Example 4 | D | (a) | 9.10 | 0.66 | 4.01 |
| Comparative Example 5 | E | (c) | 17.08 | 0.55 | 5.29 |

It can be seen from Table 11 that the photoelectric conversion device sensitized by the methine dye represented by general formula (1) can be used to efficiently convert visible light to electricity.

Industrial Applicability

A dye having a particular part structure can be used in the dye-sensitized photoelectric conversion device of the present invention to thereby provide a solar battery having a high conversion efficiency and a high stability.

## Claims

1. A photoelectric conversion device comprising a methine dye represented by the following formula (1) supported on a thin film of an oxide semiconductor fine particle provided on a substrate:

[Formula 1]

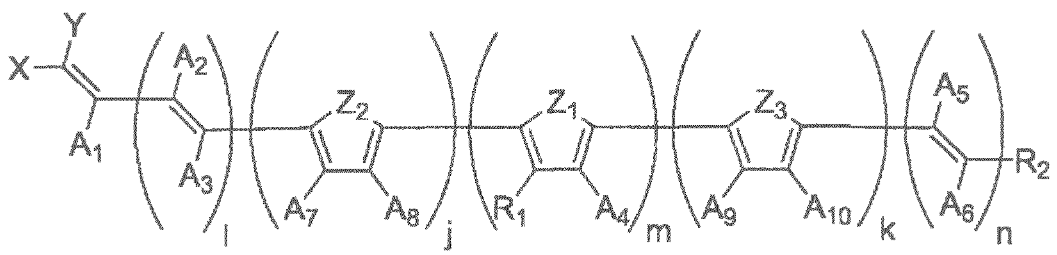

(1)

wherein m represents an integer of 1 to 5,1 and n each represent an integer of 0 to 6, and j and k each represent an integer of 0 to 3; X and Y each independently represent a hydrogen atom, an aromatic residue, an aliphatic hydrocarbon residue, a carboxyl group, a phosphoric group, a sulfonic group, a cyano group, an acyl group, an amide group, an alkoxycarbonyl group or a sulfonylbenzene group, and X and Y may be bound to form a ring; $Z_1$, $Z_2$ and $Z_3$ each independently represent an oxygen atom, a sulfur atom, a selenium atom or $NR_{11}$; $R_{11}$ represents a hydrogen atom, an aromatic residue or an aliphatic hydrocarbon residue; when at least one of m, j and k denotes 2 or more and a quantity of any of $Z_1$, $Z_2$ and $Z_3$ present is more than one, each of the more than one $Z_1$, $Z_2$ and $Z_3$ may be the same or different from each other; $A_1$, $A_2$, $A_3$, $A_5$ and $A_6$ each independently represent a hydrogen atom, an aromatic residue, an aliphatic hydrocarbon residue, a cyano group, a halogen atom, a carbonamide group, an amide group, an alkoxyl group, an aryloxy group, an alkoxycarbonyl group, an arylcarbonyl group or an acyl group; when at least one of 1 and n denote 2 or more and a quantity of any of $A_2$, $A_3$, $A_5$ and $A_6$ present is more than one, each of the more than one $A_2$, $A_3$, $A_5$ and $A_6$ may be the same or different from each other; when 1 does not denote 0, at least two of $A_1$, $A_2$ and $A_3$ may be bound to form a ring; $A_4$ represents a hydrogen atom, an aliphatic hydrocarbon residue, a cyano group, a halogen atom, a carbonamide group, an alkoxyl group, an amide group, an alkoxycarbonyl group or an acyl group; when m denotes 2 or more and a quantity of $A_4$ present is more than one, each of the more than one $A_4$ may be the same or different from each other; $A_7$, $A_8$, $A_9$ and $A_{10}$ each independently represent a hydrogen atom, an aliphatic hydrocarbon residue, a cyano group, a halogen atom, a carbonamide group, an alkoxyl group, an alkoxycarbonyl group or an acyl group; when at least any one of j or k denotes 2 or more and a quantity of any of $A_7$, $A_8$, $A_9$ and $A_{10}$ present is more than one, each of the more than one $A_7$, $A_8$, $A_9$ and $A_{10}$ may be the same or different from each other; $R_1$ represents an organometallic complex residue or a group represented

by the following formula (3001) or (3003):

[Formula 2]

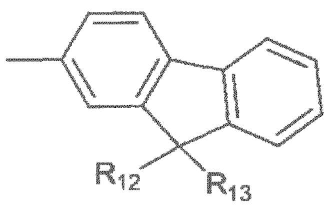

(3001)

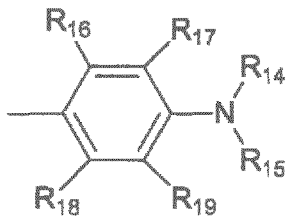

(3003)

wherein $R_{12}$, $R_{13}$, $R_{14}$ and $R_{15}$ each independently represent a hydrogen atom, an aromatic residue or an aliphatic hydrocarbon residue; $R_{16}$, $R_{17}$, $R_{18}$ and $R_{19}$ each independently represent a hydrogen atom, an aromatic residue, an aliphatic hydrocarbon residue, a cyano group, an acyl group, an amide group, an alkoxyl group, an alkoxycarbonyl group or a sulfonylbenzene group; $R_2$ represents a group represented by formula (3001) or (3003), a hydrogen atom, an aliphatic hydrocarbon residue or an organometallic complex residue; when m denotes 2 or more and a quantity of $R_1$ present is more than one, each of the more than one $R_1$ may be the same or different from each other; and when n does not denote 0, at least two of $A_5$, $A_6$ and $R_2$ may be bound to form a ring.

**2.** The photoelectric conversion device according to claim 1, wherein m in formula (1) denotes 1 to 3

**3.** The photoelectric conversion device according to claim 2, wherein m in formula (1) denotes 1.

**4.** The photoelectric conversion device according to claim 1, wherein $Z_1$ to $Z_3$ in formula (1) represent a sulfur atom.

**5.** The photoelectric conversion device according to claim 1, wherein 1 and n in formula (1) denote 0.

**6.** The photoelectric conversion device according to claim 5, wherein k in formula (1) denotes 0.

**7.** The photoelectric conversion device according to claim 1, wherein one of X and Y in formula (1) represents a carboxyl group and the other thereof represents a carboxyl group, a cyano group or an acyl group.

**8.** The photoelectric conversion device according to claim 7, wherein one of X and Y in formula (1) represents a carboxyl group and the other thereof represents a cyano group.

**9.** The photoelectric conversion device according to claim 1, wherein X and Y in formula (1) are bound to form a ring structure.

**10.** The photoelectric conversion device according to claim 9, wherein the ring structure formed by binding of X and Y in formula (1) is represented by any of the following formulae (2001) to (2044):

[Formula 3]

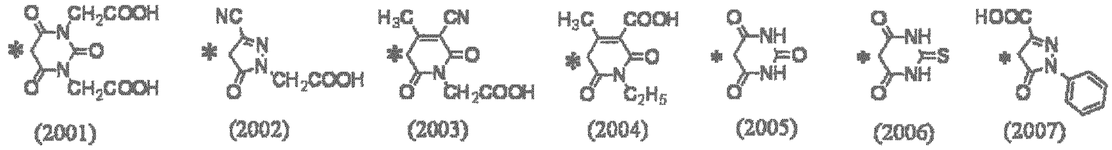

(2001) (2002) (2003) (2004) (2005) (2006) (2007)

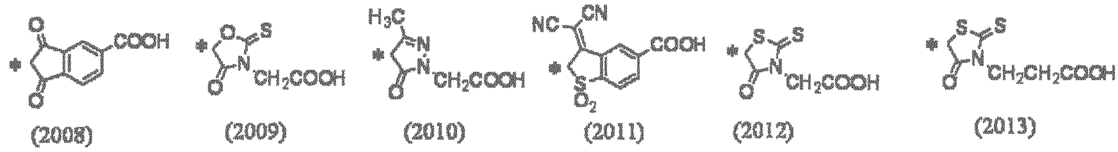

(2008) (2009) (2010) (2011) (2012) (2013)

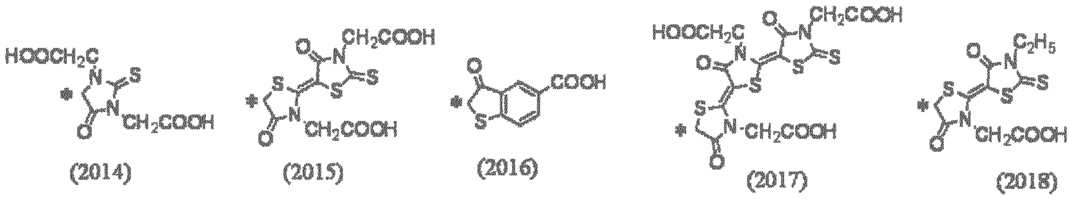

(2014) (2015) (2016) (2017) (2018)

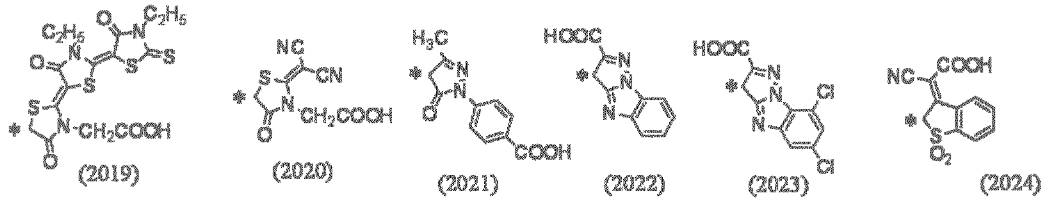

(2019) (2020) (2021) (2022) (2023) (2024)

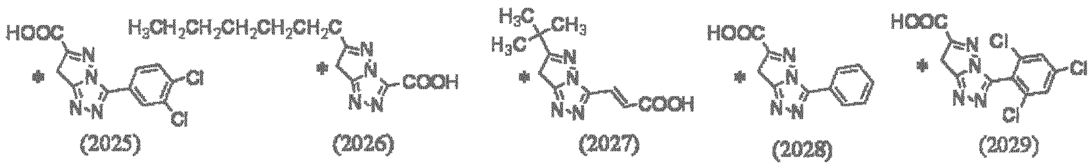

(2025) (2026) (2027) (2028) (2029)

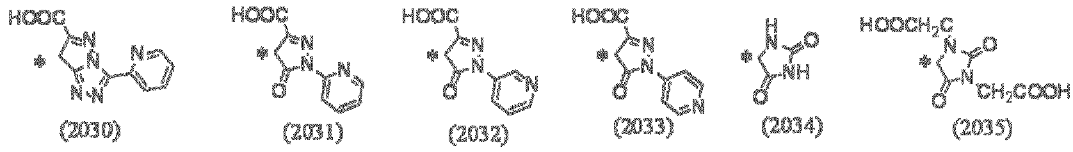

(2030) (2031) (2032) (2033) (2034) (2035)

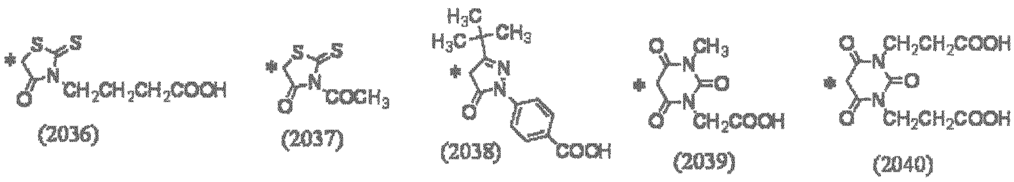

(2036) (2037) (2038) (2039) (2040)

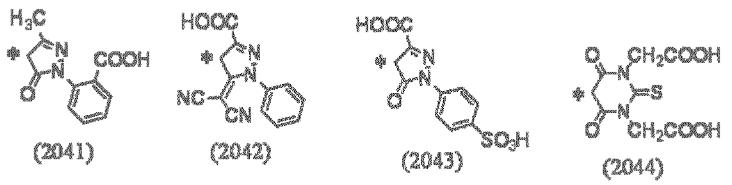

(2041) (2042) (2043) (2044)

wherein symbol * represents a carbon atom to which X and Y in formula (1) are bound.

**11.** The photoelectric conversion device according to claim 10, wherein the ring structure formed by binding of X and Y has a carboxyl group as a substituent.

**12.** The photoelectric conversion device according to claim 11, wherein the ring structure formed by binding of X and Y in formula (1) is represented by formula (2007) or (2012).

**13.** The photoelectric conversion device according to claim 1, wherein $A_1$ to $A_{10}$ in formula (1) represent a hydrogen atom.

**14.** The photoelectric conversion device according to claim 1, wherein $R_1$ in formula (1) represents a group represented by formula (3001) in which $R_{12}$ and $R_{13}$ represent a hydrogen atom or an alkyl group having 1 to 8 carbon atoms, or $R_1$ in formula (1) represents a group represented by formula (3003) in which $R_{14}$ and $R_{15}$ represent a phenyl group or a group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group having 1 to 4 carbon atoms.

**15.** The photoelectric conversion device according to claim 14, wherein $R_1$ in formula (1) represents a group represented by any of the following formulae (3101) to (3114).

[Formula 4]

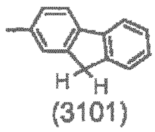
(3101)
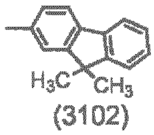
(3102)
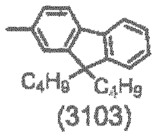
(3103)
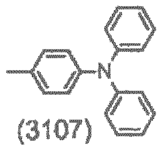
(3107)

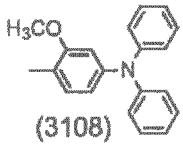
(3108)
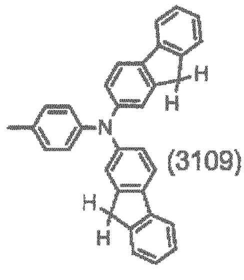
(3109)
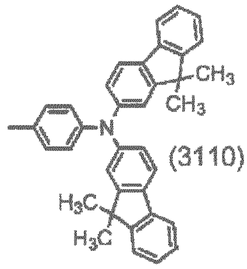
(3110)

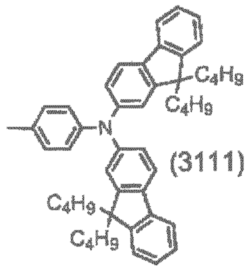
(3111)
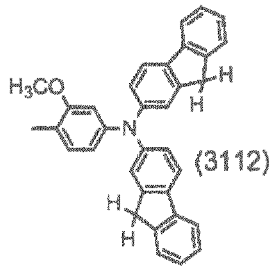
(3112)
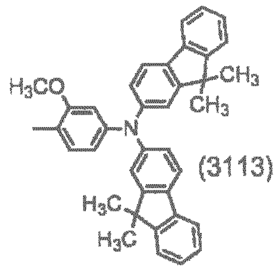
(3113)

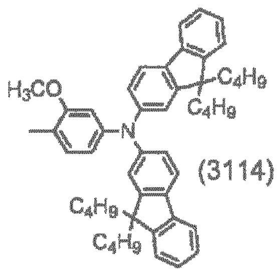
(3114)

**16.** The photoelectric conversion device according to claim 15, wherein $R_1$ in formula (1) represents a group represented by formula (3102), (3103), (3107), (3108), (3110), (3111), (3113) or (3114).

**17.** The photoelectric conversion device according to claim 16, wherein $R_1$ in formula (1) represents a group represented by formula (3103) or (3107).

**18.** The photoelectric conversion device according to claim 1, wherein $R_2$ in formula (1) represents a group represented by formula (3001) in which $R_{12}$ and $R_{13}$ represent a hydrogen atom or an alkyl group having 1 to 8 carbon atoms, or $R_2$ in formula (1) represents a group represented by formula (3003) in which $R_{14}$ and $R_{15}$ represent a phenyl group or a group represented by formula (3001) in which $R_{12}$ and $R_{13}$ represent a hydrogen atom or an alkyl group having 1 to 8 carbon atoms, and $R_{16}$ to $R_{19}$ each independently represent a hydrogen atom or an alkoxyl group

having 1 to 4 carbon atoms.

**19.** The photoelectric conversion device according to claim 18, wherein $R_2$ in formula (1) represents a group represented by any of formulae (3101) to (3114) in claim 15.

**20.** The photoelectric conversion device according to claim 19, wherein $R_2$ in formula (1) represents a group represented by formula (3107), (3108), (3110), (3111), (3113) or (3114).

**21.** The photoelectric conversion device according to claim 20, wherein $R_2$ in formula (1) represents a group represented by formula (3107) or (3111),

**22.** The photoelectric conversion device according to claim 1, wherein the methine dye represented by formula (1) is represented by any of following formulae (179) to (500).

[Formula 5-1]

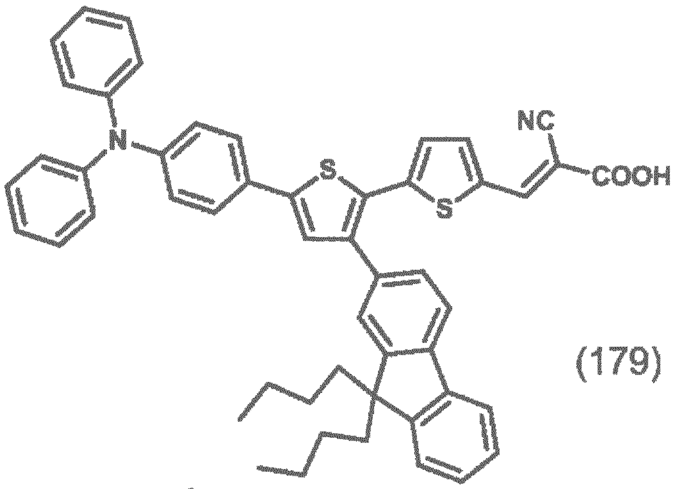

(179)

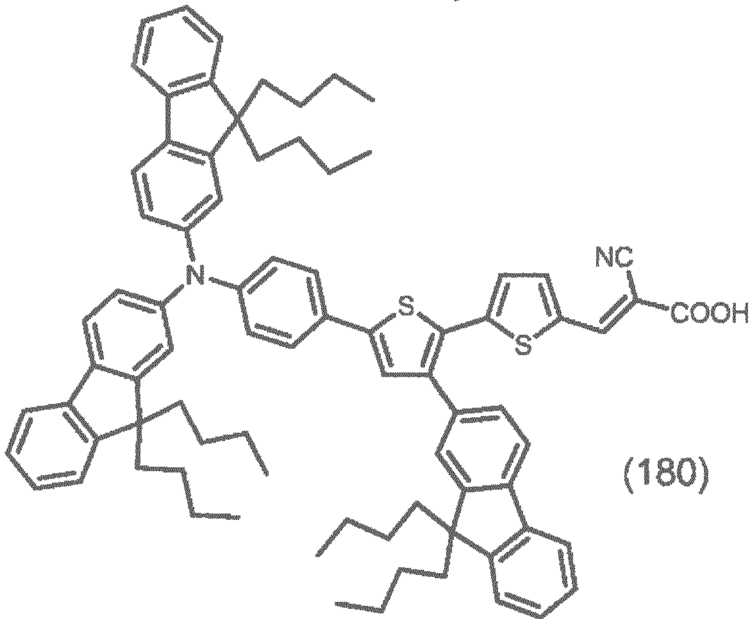

(180)

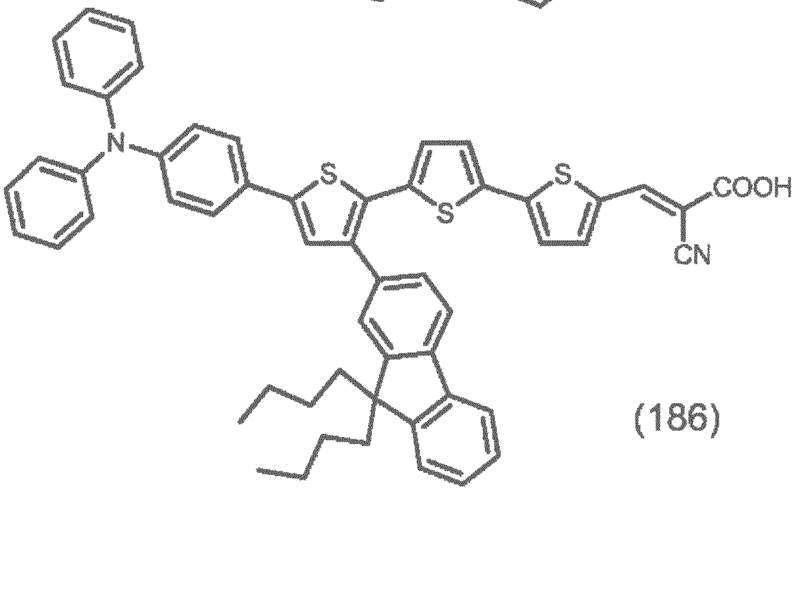

(186)

[Formula 5-2]

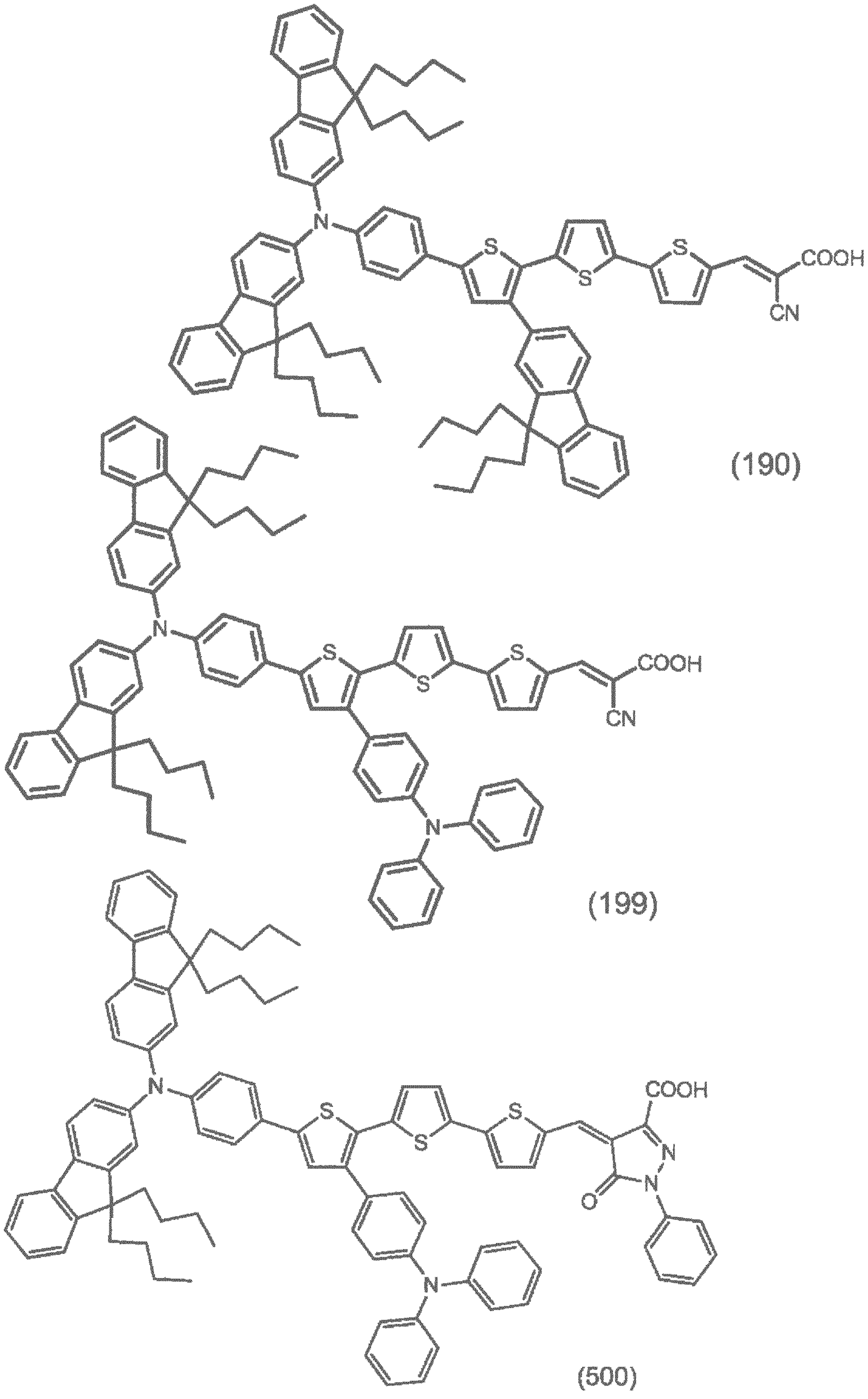

(190)

(199)

(500)

**23.** A solar battery equipped with the photoelectric conversion device according to any one of claims 1 to 22.

**24.** A methine compound represented by formula (1) in claim 1.

**INTERNATIONAL SEARCH REPORT**

International application No.
PCT/JP2013/059501

A. CLASSIFICATION OF SUBJECT MATTER
*H01M14/00*(2006.01)i, *C09B23/00*(2006.01)i, *H01L31/04*(2006.01)i

According to International Patent Classification (IPC) or to both national classification and IPC

B. FIELDS SEARCHED

Minimum documentation searched (classification system followed by classification symbols)
H01M14/00, C09B23/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | WO 2010/147427 A2 (DONGJIN SEMICHEM CO., LTD.), 23 December 2010 (23.12.2010), paragraphs [117] to [118] & KR 10-2010-0136931 A & TW 1114844 A | 1-24 |
| A | ZHANG et al.Triphenylamine-based dyes for dye-sensitized solar cells,Dyes and Pigments, 2009,81(3),p,224-230 (particularly, page 225, fig. 1, compound 2c) | 1-24 |
| A | JP 2006-525395 A (Osram Opto Semiconductors GmbH), 09 November 2006 (09.11.2006), paragraph [0105] & US 2006/0229431 A1 & WO 2004/099291 A1 | 1-24 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 May, 2013 (01.05.13) | 14 May, 2013 (14.05.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2664194 B
- WO 2002011213 A
- WO 200408261 A
- WO 2007100033 A


### Non-patent literature cited in the description


- **B. O'REGAN ; M. GRAETZEL.** *Nature,* 1991, vol. 353, 737
- **M. K. NAZEERUDDIN ; A. KAY ; I. RODICIO ; R. HUMPHRY-BAKER ; E. MULLER ; P. LISKA ; N. VLACHOPOULOS ; M. GRAETZEL.** *J.Am.Chem.Soc.,* 1993, vol. 115, 6382